(19) Europäisches Patentamt
European Patent Office
Office européen des brevets

(11) EP 3 715 949 A1

(12) **EUROPEAN PATENT APPLICATION**
published in accordance with Art. 153(4) EPC

(43) Date of publication:
**30.09.2020 Bulletin 2020/40**

(21) Application number: **18879725.2**

(22) Date of filing: **16.11.2018**

(51) Int Cl.:
***G03F 7/11*** (2006.01) ***C08G 10/02*** (2006.01)
***C08G 10/04*** (2006.01) ***G03F 7/027*** (2006.01)
***G03F 7/031*** (2006.01) ***G03F 7/039*** (2006.01)
***G03F 7/20*** (2006.01) ***G03F 7/26*** (2006.01)

(86) International application number:
**PCT/JP2018/042534**

(87) International publication number:
**WO 2019/098338 (23.05.2019 Gazette 2019/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.11.2017 JP 2017222641**

(71) Applicant: **Mitsubishi Gas Chemical Company, Inc.**
**Tokyo 100-8324 (JP)**

(72) Inventors:
- **MAKINOSHIMA, Takashi**
**Hiratsuka-shi**
**Kanagawa 254-0016 (JP)**
- **ECHIGO, Masatoshi**
**Tokyo 100-8324 (JP)**
- **MIKI, Yasushi**
**Hiratsuka-shi**
**Kanagawa 254-0016 (JP)**

(74) Representative: **Müller-Boré & Partner Patentanwälte PartG mbB**
**Friedenheimer Brücke 21**
**80639 München (DE)**

(54) **COMPOSITION FOR FORMING FILM FOR LITHOGRAPHY, FILM FOR LITHOGRAPHY, RESIST PATTERN FORMING METHOD, AND CIRCUIT PATTERN FORMING METHOD**

(57) A composition for film formation for lithography of the present invention comprises at least one selected from the group consisting of an aromatic hydrocarbon formaldehyde resin and a modified aromatic hydrocarbon formaldehyde resin, wherein the aromatic hydrocarbon formaldehyde resin is a product of condensation reaction between an aromatic hydrocarbon having a substituted or unsubstituted benzene ring and formaldehyde, and the modified aromatic hydrocarbon formaldehyde resin is formed by modifying the aromatic hydrocarbon formaldehyde resin.

EP 3 715 949 A1

**Description**

Technical Field

The present invention relates to a composition for film formation for lithography, a film for lithography, a method for forming a resist pattern, and a method for forming a circuit pattern.

Background Art

In the production of semiconductor devices, fine processing is practiced by lithography using photoresist materials. In recent years, further miniaturization based on pattern rules has been demanded along with increase in the integration and speed of large scale integrated circuits (LSI). And now, lithography using light exposure, which is currently used as a general purpose technique, is approaching the limit of essential resolution derived from the wavelength of a light source.

The light source for lithography used upon forming resist patterns has been shifted to ArF excimer laser (193 nm) having a shorter wavelength from KrF excimer laser (248 nm). However, when the miniaturization of resist patterns proceeds, the problem of resolution or the problem of collapse of resist patterns after development arises. Therefore, resists are desired to have a thinner film. Nevertheless, if resists merely have a thinner film, it is difficult to obtain the film thicknesses of resist patterns sufficient for substrate processing. Therefore, there is a need for a process of preparing a resist underlayer film between a resist and a semiconductor substrate to be processed, and imparting functions as a mask for substrate processing to this resist underlayer film in addition to a resist pattern.

Various resist underlayer films for such a process are currently known. For example, as a material for realizing resist underlayer films for lithography having the selectivity of a dry etching rate close to that of resists, unlike conventional resist underlayer films having a fast etching rate, Patent Literature 1 discloses an underlayer film forming material for a multilayer resist process containing a resin component having at least a substituent that generates a sulfonic acid residue by eliminating a terminal group under application of predetermined energy, and a solvent. Moreover, as a material for realizing resist underlayer films for lithography having the selectivity of a dry etching rate smaller than that of resists, Patent Literature 2 discloses a resist underlayer film material comprising a polymer having a specific repeat unit. Furthermore, as a material for realizing resist underlayer films for lithography having the selectivity of a dry etching rate smaller than that of semiconductor substrates, Patent Literature 3 discloses a resist underlayer film material comprising a polymer prepared by copolymerizing a repeat unit of an acenaphthylene and a repeat unit having a substituted or unsubstituted hydroxy group.

Meanwhile, as materials having high etching resistance for this kind of resist underlayer film, amorphous carbon underlayer films formed by chemical vapor deposition (CVD) using methane gas, ethane gas, acetylene gas, or the like as a raw material are well known.

In addition, as described in Patent Literature 4 and Patent Literature 5, the present inventors have suggested an underlayer film forming composition for lithography containing a naphthalene formaldehyde polymer comprising a particular structural unit and an organic solvent as a material that is not only excellent in optical properties and etching resistance, but also is soluble in a solvent and applicable to a wet process.

As for methods for forming an intermediate layer used in the formation of a resist underlayer film in a three-layer process, for example, a method for forming a silicon nitride film described in Patent Literature 6 and a CVD formation method for a silicon nitride film described in Patent Literature 7 are known. Also, as intermediate layer materials for a three-layer process, materials comprising a silsesquioxane-based silicon compound as described in Patent Literature 8 and Patent Literature 9 are known.

Citation List

Patent Literature

Patent Literature 1: Japanese Patent Application Laid-Open No. 2004-177668
Patent Literature 2: Japanese Patent Application Laid-Open No. 2004-271838
Patent Literature 3: Japanese Patent Application Laid-Open No. 2005-250434
Patent Literature 4: International Publication No. WO 2009/072465
Patent Literature 5: International Publication No. WO 2011/034062
Patent Literature 6: Japanese Patent Application Laid-Open No. 2002-334869
Patent Literature 7: International Publication No. WO 2004/066377

Patent Literature 8: Japanese Patent Application Laid-Open No. 2007-226170
Patent Literature 9: Japanese Patent Application Laid-Open No. 2007-226204

## Summary of Invention

### Technical Problem

As mentioned above, a large number of compositions for underlayer film formation for lithography have heretofore been suggested. However, none of these materials not only have high solvent solubility that permits application of a wet process such as spin coating or screen printing but also achieve both of heat resistance and etching resistance at high dimensions. Thus, the development of novel materials is required.
Accordingly, an object of the present invention is to provide a composition for film formation for lithography that can be applied to a wet process and has excellent heat resistance and etching resistance, a film for lithography, a method for forming a resist pattern, and a method for forming a circuit pattern.

### Solution to Problem

The inventors have, as a result of devoted examinations to solve the above problems, found out that use of a compound having a specific structure can solve the above problems, and reached the present invention.
More specifically, the present invention is as follows.

[1] A composition for film formation for lithography, comprising at least one selected from the group consisting of an aromatic hydrocarbon formaldehyde resin and a modified aromatic hydrocarbon formaldehyde resin, wherein the aromatic hydrocarbon formaldehyde resin is a product of condensation reaction between an aromatic hydrocarbon having a substituted or unsubstituted benzene ring and formaldehyde, and the modified aromatic hydrocarbon formaldehyde resin is formed by modifying the aromatic hydrocarbon formaldehyde resin.
[2] The composition for film formation for lithography according to [1], wherein the aromatic hydrocarbon formaldehyde resin is a xylene formaldehyde resin, which is a product of condensation reaction between xylene and formaldehyde, and the modified aromatic hydrocarbon formaldehyde resin is a modified xylene formaldehyde resin formed by modifying the xylene formaldehyde resin.
[3] The composition for film formation for lithography according to [1] or [2], wherein the modified aromatic hydrocarbon formaldehyde resin is at least one selected from the group consisting of the following (X1), (X2), (X3) and (X4):

(X1) a phenol-modified aromatic hydrocarbon formaldehyde resin formed by modifying the aromatic hydrocarbon formaldehyde resin with a phenol represented by the following formula (1);
(X2) a polyol-modified aromatic hydrocarbon formaldehyde resin formed by modifying the aromatic hydrocarbon formaldehyde resin with a polyol;
(X3) an epoxy-modified aromatic hydrocarbon formaldehyde resin; and
(X4) an acrylic modified aromatic hydrocarbon formaldehyde resin,

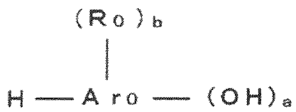

(1)

wherein $Ar_0$ represents an aromatic ring; $R_0$ represents a hydrogen atom, an alkyl group, an aryl group or an alkoxy group; a represents an integer of 1 to 3; b represents an integer of 0 or more; and when there are a plurality of $R_0$, the plurality of $R_0$ may be the same or different.
[4] The composition for film formation for lithography according to [3], wherein the phenol represented by the above formula (1) is phenol, 2,6-xylenol or 3,5-xylenol.
[5] The composition for film formation for lithography according to [3] or [4], wherein the polyol is a polyol represented by the following formula (1a):

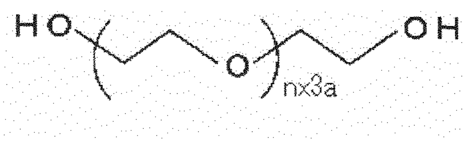

(1a)

wherein nx3a represents an integer of 0 to 5.

[6] The composition for film formation for lithography according to any of [3] to [5], wherein the epoxy-modified aromatic hydrocarbon formaldehyde resin is a resin obtained by reacting the phenol-modified aromatic hydrocarbon formaldehyde resin with epihalohydrin.

[7] The composition for film formation for lithography according to any of [3] to [6], wherein the acrylic modified aromatic hydrocarbon formaldehyde resin is a resin obtained by esterifying the polyol-modified aromatic hydrocarbon formaldehyde resin with acrylic acid or a derivative thereof.

[8] The composition for film formation for lithography according to any of [1] to [7], wherein the aromatic hydrocarbon formaldehyde resin is a deacetalized aromatic hydrocarbon formaldehyde resin that has been subjected to a deacetalization treatment, and the modified aromatic hydrocarbon formaldehyde resin is a resin formed by modifying the deacetalized aromatic hydrocarbon formaldehyde resin.

[9] The composition for film formation for lithography according to any of [1] to [8], wherein the modified aromatic hydrocarbon formaldehyde resin comprises a compound represented by the following formula (2):

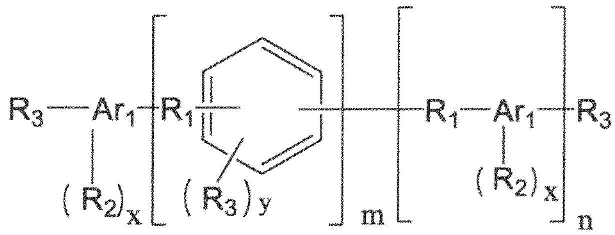

(2)

wherein $Ar_1$ represents an aromatic ring or an aliphatic ring; $R_1$ is a methylene group, a methyleneoxy group, an oxymethylene group or a divalent group formed by combining two or more groups thereof; $R_2$ represents a hydrogen atom, a hydroxy group, an alkyl group having 1 to 30 carbon atoms, an aryl group having 6 to 30 carbon atoms, an alkoxy group having 1 to 30 carbon atoms, an alkoxycarbonyl group having 1 to 30 carbon atoms, an alkenyl group having 2 to 30 carbon atoms, a group represented by the following formula (A) or a crosslinkable reactive group, wherein the alkyl group, the aryl group, the alkoxy group and the alkenyl group may be substituted with one substituent selected from the group consisting of a hydroxy group, an alkyl group having 1 to 12 carbon atoms and an alkoxy group, and wherein the alkyl group, the aryl group, the alkoxy group and the alkenyl group may comprise one bonding group selected from the group consisting of an ether bond, a ketone bond and an ester bond, where, when there are a plurality of $R_2$, the plurality of $R_2$ may be the same or different; $R_3$ is a hydrogen atom, a hydroxy group, an alkyl group having 1 to 3 carbon atoms, an aryl group, a hydroxymethylene group or a group represented by the following formula (B), the following formula (C1), the following formula (C2) or the following formula (C3), where, when there are a plurality of $R_3$, the plurality of $R_3$ may be the same or different; m represents an integer of 1 or more; n represents an integer of 1 or more; the arrangement of each unit is arbitrary; x represents an integer of 0 or more; and y represents an integer of 0 to 4, provided that either the formula (2) necessarily has any of the groups represented by the following formula (A), the following formula (B), the following formula (C1), the following formula (C2) and the following formula (C3), or $Ar_1$ represents an aromatic ring and at least one of $R_2$ bonded to the aromatic ring $Ar_1$ is a hydroxy group;

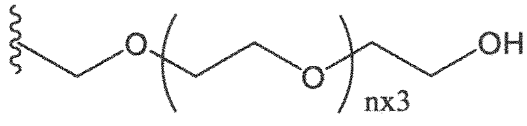

(A)

wherein nx3 represents an integer of 1 to 5;

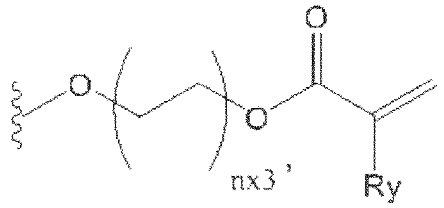

(B)

wherein nx3' represents an integer of 1 to 5 and Ry represents a hydrogen atom or a methyl group;

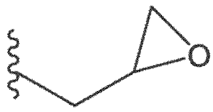

(C 1)

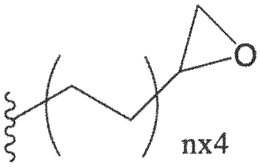

(C 2)

wherein nx4 represents an integer of 1 to 5; and

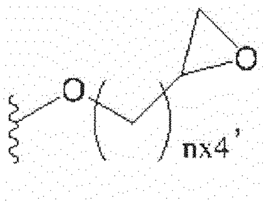

(C 3)

wherein nx4' represents an integer of 1 to 5.

[10] The composition for film formation for lithography according to any of [1] to [9], further comprising a radical polymerization initiator.

[11] The composition for film formation for lithography according to [10], wherein the radical polymerization initiator is at least one selected from the group consisting of a ketone-based photopolymerization initiator, an organic peroxide-based polymerization initiator and an azo-based polymerization initiator.

[12] The composition for film formation for lithography according to [10] or [11], wherein a content of the radical polymerization initiator is 0.05 to 50 parts by mass based on 100 parts by mass of the solid content of the composition for film formation for lithography.

[13] The composition for film formation for lithography according to any of [1] to [12], further comprising at least one selected from the group consisting of a photocurable monomer, a photocurable oligomer and a photocurable polymer.

[14] The composition for film formation for lithography according to any of [1] to [13], further comprising a solvent.

[15] The composition for film formation for lithography according to any of [1] to [14], further comprising an acid generating agent.

[16] The composition for film formation for lithography according to any of [1] to [15], further comprising an acid crosslinking agent.

[17] The composition for film formation for lithography according to any of [1] to [16], further comprising a crosslinking promoting agent.

[18] The composition for film formation for lithography according to any of [1] to [17], further comprising a base generating agent.

[19] The composition for film formation for lithography according to any of [1] to [18], wherein the composition is for an underlayer film.

[20] The composition for film formation for lithography according to any of [1] to [18], wherein the composition is for a resist.

[21] The composition for film formation for lithography according to any of [1] to [18], wherein the composition is for a resist permanent film.

[22] A film for lithography, formed by using the composition for film formation for lithography according to any of [1] to [21].

[23] The film for lithography according to [22], wherein the film is an underlayer film.

[24] A method for forming a resist pattern, comprising the steps of:

forming an underlayer film on a substrate using the composition for film formation for lithography according to any of [1] to [21] ;

forming at least one photoresist layer on the underlayer film; and

irradiating a predetermined region of the photoresist layer with radiation for development, thereby forming a resist pattern.

[25] A method for forming a circuit pattern, comprising the steps of:

forming an underlayer film on a substrate using the composition for film formation for lithography according to any of [1] to [21] ;
forming an intermediate layer film on the underlayer film using a resist intermediate layer film forming material containing a silicon atom;
forming at least one photoresist layer on the intermediate layer film;
irradiating a predetermined region of the photoresist layer with radiation for development, thereby forming a resist pattern;
etching the intermediate layer film with the resist pattern as a mask, thereby forming an intermediate layer film pattern;
etching the underlayer film with the intermediate layer film pattern as an etching mask, thereby forming an underlayer film pattern; and
etching the substrate with the underlayer film pattern as an etching mask, thereby forming a pattern on the substrate.

Advantageous Effects of Invention

According to the present invention, a composition for film formation for lithography that can be applied to a wet process and has excellent heat resistance and etching resistance, a film for lithography, a method for forming a resist pattern, and a method for forming a circuit pattern can be provided.

Description of Embodiments

Hereinafter, embodiments of the present invention will be described (hereinafter, referred to as the "present embodiment"). The present embodiment described below is given merely for illustrating the present invention. The present invention is not limited only by that embodiment.

In the present specification, the "pattern formability" refers to a property by which, upon forming a resist pattern, the formed pattern is not collapsed and has good rectangularity.

A composition for film formation for lithography of the present embodiment comprises at least one selected from the group consisting of an aromatic hydrocarbon formaldehyde resin (aromatic hydrocarbon formaldehyde compound) and a modified aromatic hydrocarbon formaldehyde resin (modified aromatic hydrocarbon formaldehyde compound), wherein the aromatic hydrocarbon formaldehyde resin is a product of condensation reaction between an aromatic hydrocarbon having a substituted or unsubstituted benzene ring and formaldehyde, and the modified aromatic hydrocarbon formaldehyde resin is formed by modifying the aromatic hydrocarbon formaldehyde resin. The composition for film formation for lithography of the present embodiment is suitably used for, for example, forming underlayer films and for resist permanent films, which will be mentioned later. Hereinafter, the aromatic hydrocarbon formaldehyde resin and the modified aromatic hydrocarbon formaldehyde resin may be simply referred to as a "component (A)".

The component (A) contained in the composition for film formation for lithography of the present embodiment has an aromatic ring, and when the component (A) is baked at a high temperature, various functional groups in the component (A) undergo crosslinking reaction, thereby forming a crosslinked structure. Due to this, the composition for film formation for lithography of the present embodiment can exhibit high heat resistance upon making the composition a film for lithography. As a result, deterioration of the film upon baking at a high temperature is suppressed, and the obtained film for lithography (particularly, underlayer film) is excellent in etching resistance to oxygen plasma etching and the like. In addition, although the component (A) contained in the composition for film formation for lithography of the present embodiment has an aromatic ring, it has high solubility in an organic solvent, and particularly has high solubility in a safe solvent. Due to this, the composition for film formation for lithography of the present embodiment can be applied to a wet process. Furthermore, since the component (A) contained in the composition for film formation for lithography of the present embodiment is a low molecular weight compound (for example, a compound having a molecular weight of 1000 or less (preferably, 800 or less)), the composition for film formation for lithography of the present embodiment is, for example, excellent in pattern formability.

In addition, upon making the composition for film formation for lithography of the present embodiment a film for lithography, it is excellent in embedding properties to a substrate having difference in level and film flatness, as well as stability of the product quality. Furthermore, upon making the composition for film formation for lithography of the present embodiment a film for lithography, an excellent resist pattern can be obtained because it is also excellent in

adhesiveness to a resist layer material and a resist intermediate layer film material.

Hereinafter, the component (A) will be described.

[Aromatic Hydrocarbon Formaldehyde Resin]

The aromatic hydrocarbon formaldehyde resin can be obtained by condensation reaction between an aromatic hydrocarbon having a substituted or unsubstituted benzene ring (hereinafter, also referred to as an "aromatic hydrocarbon (A)") and formaldehyde in the presence of an acidic catalyst.

Here, examples of the aromatic hydrocarbon (A) having a substituted benzene ring include a compound having a benzene ring substituted with one or more substituents selected from the group consisting of an alkyl group having 1 to 3 carbon atoms, an aryl group, a hydroxy group and a hydroxymethylene group, and from the viewpoint of achieving the effect of the present invention more effectively and reliably, the aromatic hydrocarbon (A) having a substituted benzene ring is preferably an aromatic hydrocarbon having a benzene ring substituted with an alkyl group having 1 to 3 carbon atoms, and is more preferably xylene.

Here, the product of condensation reaction between xylene and formaldehyde is referred to as a xylene formaldehyde resin, and a modified product thereof is referred to as a modified xylene formaldehyde resin. From the viewpoint of achieving the effect of the present invention more effectively and reliably, the aromatic hydrocarbon formaldehyde resin of the present embodiment is preferably a xylene formaldehyde resin, and the modified aromatic hydrocarbon formaldehyde resin is preferably a modified xylene formaldehyde resin.

Examples of the formaldehyde to be used in the condensation reaction include, but not particularly limited to, an aqueous formaldehyde solution that is industrially available. Other examples thereof include a compound that generates formaldehyde. These formaldehydes can be used alone as one kind or may be used in combination of two or more kinds. Among them, from the viewpoint of still more suppressing gelation, the aqueous formaldehyde solution is preferable.

The molar ratio of the aromatic hydrocarbon (A) and formaldehyde to be used for the condensation reaction, the aromatic hydrocarbon (A):formaldehyde, is preferably 1:1 to 1:20, more preferably 1:1.5 to 1:17.5, further preferably 1:2 to 1:15, even further preferably 1:2 to 1:12.5, and particularly preferably 1:2 to 1:10. When the molar ratio is in the above range, the yield of the obtained aromatic hydrocarbon formaldehyde resin (particularly, xylene formaldehyde resin) is still more improved, and the remaining amount of unreacted formaldehyde tends to be still more reduced.

Examples of the acidic catalyst to be used for the condensation reaction include publicly known inorganic acids, organic acids, Lewis acids and solid acids. Examples of the inorganic acid include hydrochloric acid, sulfuric acid, phosphoric acid, hydrobromic acid and hydrofluoric acid. Examples of the organic acid include oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid. Examples of the Lewis acid include zinc chloride, aluminum chloride, iron chloride and boron trifluoride. Examples of the solid acid include silicotungstic acid, phosphotungstic acid, silicomolybdic acid and phosphomolybdic acid. These acidic catalysts can be used alone as one kind or may be used in combination of two or more kinds. Among them, from the viewpoint of production, one or more selected from the group consisting of sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid and phosphotungstic acid are preferable.

The amount of the acidic catalyst to be used is preferably 0.0001 to 100 parts by mass, more preferably 0.001 to 85 parts by mass, and further preferably 0.001 to 70 parts by mass based on 100 parts by mass of the total amount of the aromatic hydrocarbon (A) and formaldehyde. When the amount to be used is in the above range, the reaction rate is still more improved, and since the reaction rate is improved, increase in the resin viscosity tends to be still more suppressed. In the condensation reaction, the acidic catalyst may be placed in the reaction system at once, or may be placed sequentially.

The condensation reaction is carried out, for example, in the presence of the acidic catalyst normally at normal pressure, and it may be carried out while subjecting raw materials to be used to heating reflux at a temperature at which they are compatible or higher (normally, 80 to 300°C) or while distilling off the produced water. In addition, the condensation reaction may be carried out at normal pressure, or may be carried out while pressurizing the reaction system. In addition, the condensation reaction may be carried out while passing an inert gas, such as nitrogen, helium and argon, through the reaction system, if required.

In addition, in the condensation reaction, a solvent that is inert to the reaction may be used, if required. Examples of the solvent include aromatic hydrocarbon-based solvents such as toluene and xylene; saturated aliphatic hydrocarbon-based solvents such as heptane and hexane; alicyclic hydrocarbon-based solvents such as cyclohexane; ether-based solvents such as dioxane and dibutyl ether; ketone-based solvents such as methyl isobutyl ketone; carboxylic acid ester-based solvents such as ethyl propionate; and carboxylic acid-based solvents such as acetic acid. These solvents are

used alone as one kind or used in combination of two or more kinds.

In the condensation reaction, it is preferable that an alcohol coexist in the reaction system although there is no particular limitation thereon. When an alcohol coexists, the termini of the resin is capped with the alcohol, and an aromatic hydrocarbon formaldehyde resin (for example, xylene formaldehyde resin) having a low molecular weight and a low dispersivity (that is, a characteristic of having a narrow molecular weight distribution) is obtained. In addition, when such an aromatic hydrocarbon formaldehyde resin is modified with a modifying agent, there is a tendency that a modified resin having good solvent solubility and low melt viscosity is obtained. Examples of the alcohol include, but not particularly limited to, a monool having 1 to 12 carbon atoms and a diol having 1 to 12 carbon atoms. These alcohols are used alone as one kind or used in combination of two or more kinds. Among them, from the viewpoint of the productivity of a xylene formaldehyde resin, one or more selected from the group consisting of propanol, butanol, octanol and 2-ethylhexanol are preferable. When an alcohol coexists in the reaction system, the amount of the alcohol to be used is not particularly limited, and may be, for example, 1 to 10 equivalents of the hydroxyl group in the alcohol based on 1 equivalent of the methylol group in the xylene methanol.

In the condensation reaction, the aromatic hydrocarbon (A), formaldehyde and the acidic catalyst may be added to the reaction system at the same time, each of them may be added sequentially, or the aromatic hydrocarbon (A) may be added sequentially to the reaction system in which formaldehyde and the acidic catalyst are present. Among them, when a method in which components are added sequentially is taken, the concentration of oxygen in the obtained resin becomes high, and upon modifying the resin with a modifying agent, for example, the resin can react more with a phenol (a hydroxy-substituted aromatic compound), which is preferable.

In the condensation reaction, the reaction time is preferably 0.5 to 30 hours, more preferably 0.5 to 20 hours, and further preferably 0.5 to 10 hours. When the reaction time is within the above range, there is a tendency that a resin having objective attributes is obtained still more economically and still more industrially.

In the condensation reaction, the reaction temperature is preferably 80 to 300°C, more preferably 85 to 270°C, and further preferably 90 to 240°C. When the reaction temperature is within the above range, there is a tendency that a resin having objective attributes is obtained still more economically and still more industrially.

After the reaction terminates, if required, a solvent may be further added for dilution, and the diluent is left to stand still and thus separated into two phases, thereby separating the resin phase, which is an oil phase, and the aqueous phase. Subsequently, if required, the acidic catalyst may be removed completely by further subjecting the resin phase to water washing, and the added solvent and unreacted raw materials may be removed by a general method such as distillation. Accordingly, a xylene formaldehyde resin is obtained.

At least a part of benzene rings in the obtained xylene formaldehyde resin are crosslinked with, for example, a bonding group (crosslinking group) represented by the following formula (3) and/or the following formula (4) .

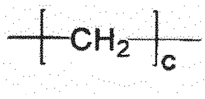

(3)

In the formula (3), c represents an integer of 1 to 10.

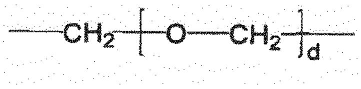

(4)

In the formula (4), d represents an integer of 0 to 10.

In addition, at least a part of benzene rings in the xylene formaldehyde resin may be crosslinked with a bond in which a bonding group represented by the formula (3) and a bonding group represented by the following formula (5) are randomly arranged (for example, a bonding group represented by the following formula (6), a bonding group represented by the following formula (7), and a bonding group represented by the following formula (8)).

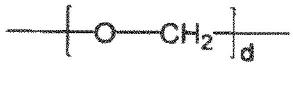

(5)

In the formula (5), d represents an integer of 0 to 10.

$-CH_2-O-CH_2-CH_2-$ (6)

$CH_2-CH_2-O-CH_2-$ (7)

$-CH_2-O-CH_2-O-CH_2-CH_2-$ (8)

[Deacetal Bond Xylene Formaldehyde Resin and Production Method Thereof]

It is preferable that the aromatic hydrocarbon formaldehyde resin be a deacetalized aromatic hydrocarbon formaldehyde resin that has been subjected to a deacetalization treatment, and the modified aromatic hydrocarbon formaldehyde resin be a resin formed by modifying the deacetalized aromatic hydrocarbon formaldehyde resin. The deacetalized aromatic hydrocarbon formaldehyde resin is obtained by treating the aromatic hydrocarbon formaldehyde resin in the presence of water and an acidic catalyst. In the present embodiment, this treatment is referred to as "deacetalization". When the aromatic hydrocarbon formaldehyde resin is subjected to a deacetalization treatment, the proportion of a bond between oxymethylene groups with no benzene ring is reduced, and d in the formula (4) tends to be small. For the deacetalized aromatic hydrocarbon formaldehyde resin thus obtained (for example, deacetalized xylene formaldehyde resin), compared to the aromatic hydrocarbon formaldehyde resin (for example, xylene formaldehyde resin), the residual amount upon thermal decomposition of the resin to be obtained after modification tends to be larger (the mass reduction ratio tends to be lower).

Examples of the aromatic hydrocarbon formaldehyde resin to be used for the deacetalization treatment include a xylene formaldehyde resin.

Examples of the acidic catalyst to be used for the deacetalization include the acidic catalysts exemplified as the acidic catalyst to be used for the condensation reaction. These acidic catalysts are used alone as one kind or used in combination of two or more kinds.

The deacetalization treatment is carried out in the presence of the acidic catalyst normally at normal pressure, and the deacetalization treatment may be carried out at a temperature at which raw materials to be used are compatible or higher (normally, 80 to 300°C) by dropping water to be used into the reaction system or spraying water vapor. Water in the reaction system may be distilled off or may be refluxed, but from the viewpoint of being capable of debonding an acetal bond efficiently, it is preferable to distill off the water in the reaction system along with low boiling point components such as formaldehyde generated in the reaction. The deacetalization treatment may be carried out at normal pressure, or may be carried out while pressurizing the reaction system. In addition, the deacetalization reaction may be carried out while passing an inert gas, such as nitrogen, helium and argon, through the reaction system, if required.

In addition, in the deacetalization treatment, a solvent that is inert to the reaction may be used, if required. Examples of the solvent include the solvents exemplified as the solvent that can be used in the condensation reaction. These solvents are used alone as one kind or used in combination of two or more kinds.

The amount of the acidic catalyst to be used is preferably 0.0001 to 100 parts by mass, more preferably 0.001 to 85 parts by mass, and further preferably 0.001 to 70 parts by mass based on 100 parts by mass of the aromatic hydrocarbon formaldehyde resin (for example, xylene formaldehyde resin). When the amount to be used is in the above range, the reaction rate is still more improved, and since the reaction rate is improved, increase in the resin viscosity tends to be still more suppressed. In the deacetalization treatment, the acidic catalyst may be placed in the reaction system at once, or may be placed sequentially.

Examples of the water to be used for the deacetalization treatment are not particularly limited as long as it can be industrially used, and include tap water, distilled water, ion exchanged water, pure water and ultrapure water.

The amount of the water to be used is preferably 0.1 to 10000 parts by mass, more preferably 1 to 5000 parts by mass, and further preferably 10 to 3000 parts by mass based on 100 parts by mass of the aromatic hydrocarbon formaldehyde resin (for example, xylene formaldehyde resin).

In the acetalization treatment, the reaction time is preferably 0.5 to 20 hours, more preferably 1 to 15 hours, and further preferably 2 to 10 hours. When the reaction time is within the above range, there is a tendency that a resin having objective attributes is obtained still more economically and industrially.

In the deacetalization treatment, the reaction temperature is preferably 80 to 300°C, more preferably 85 to 270°C, and further preferably 90 to 240°C. When the reaction temperature is within the above range, there is a tendency that a resin having objective attributes is obtained still more economically and industrially.

For the deacetalized aromatic hydrocarbon formaldehyde resin (for example, deacetalized xylene formaldehyde resin), compared to the aromatic hydrocarbon formaldehyde resin (for example, xylene formaldehyde resin), there is a tendency that the concentration of oxygen is still more reduced and the softening point is still more improved. For example, when the aromatic hydrocarbon formaldehyde resin is subjected to the deacetalization treatment under conditions where the amount of the acidic catalyst to be used is 0.05 part by mass, the amount of the water to be used is 2000 parts by mass, the reaction time is 5 hours, and the reaction temperature is 150°C, there is a tendency that the concentration of oxygen is reduced by approximately 0.1 to 8.0% by mass and the softening point is raised by approximately 3 to 100°C.

Representative examples of the aromatic hydrocarbon formaldehyde resin of the present embodiment obtained by the above production method include a compound represented by the following formula (16). The aromatic hydrocarbon formaldehyde resin of the present embodiment is, for example, a mixture including a compound (resin) represented by the formula (16) as a main component.

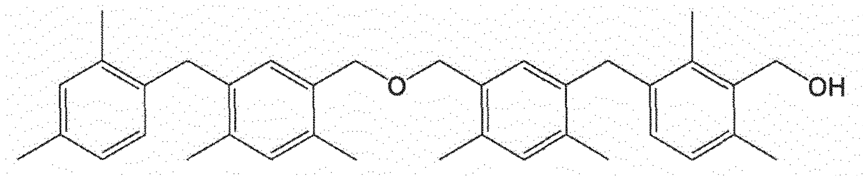
(16)

[Modified Aromatic Hydrocarbon Formaldehyde Resin and Production Method Thereof]

The modified aromatic hydrocarbon formaldehyde resin is, for example, a resin formed by modifying the aromatic hydrocarbon formaldehyde resin with a modifying agent, and includes a resin obtained by reacting the aromatic hydrocarbon formaldehyde resin with a modifying agent and also a resin obtained by reacting the modified aromatic hydrocarbon formaldehyde resin that has been modified with a modifying agent with another modifying agent.

From the viewpoint of achieving effects of the present embodiment, it is preferable that the modified aromatic hydrocarbon formaldehyde resin be at least one selected from the group consisting of the following (X1), (X2), (X3) and (X4):

(X1) a phenol-modified aromatic hydrocarbon formaldehyde resin formed by modifying the aromatic hydrocarbon formaldehyde resin with a phenol represented by the following formula (1);
(X2) a polyol-modified aromatic hydrocarbon formaldehyde resin formed by modifying the aromatic hydrocarbon formaldehyde resin with a polyol;
(X3) an epoxy-modified aromatic hydrocarbon formaldehyde resin; and
(X4) an acrylic modified aromatic hydrocarbon formaldehyde resin.

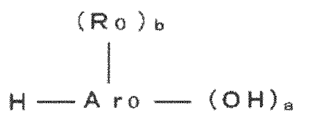
(1)

In the formula (1), $Ar_0$ represents an aromatic ring; $R_0$ represents a hydrogen atom, an alkyl group, an aryl group or an alkoxy group; a represents an integer of 1 to 3; b represents an integer of 0 or more; and when there are a plurality of $R_0$, the plurality of $R_0$ may be the same or different.

(X1) Phenol-Modified Aromatic Hydrocarbon Formaldehyde Resin

A phenol-modified aromatic hydrocarbon formaldehyde resin (for example, xylene formaldehyde resin) is obtained by heating the aromatic hydrocarbon formaldehyde resin (xylene formaldehyde resin) and a phenol represented by the formula (1) (hydroxy-substituted aromatic compound) in the presence of an acidic catalyst and subjecting them to condensation reaction (modification condensation reaction). In the present specification, the above condensation reaction is also referred to as "phenol modification reaction".

In the formula (1), $Ar_0$ represents an aromatic ring; $R_0$ represents a hydrogen atom, an alkyl group, an aryl group or an alkoxy group; a represents an integer of 1 to 3; b represents an integer of 0 or more; and when there are a plurality of $R_0$, the plurality of $R_0$ may be the same or different. In the formula (1), when b is 1 or more, the bonding position of 1 or more $R_0$ to the aromatic ring is not particularly limited. When $Ar_1$ is a benzene ring, the upper limit value of b is 5 - a; when $Ar_1$ is a naphthalene ring, the upper limit value of b is 7 - a; and when $Ar_1$ is a biphenylene ring, the upper limit value of b is 9 - a.

In the formula (1), examples of the aromatic ring represented as $Ar_0$ include, but not particularly limited to, a benzene ring, a naphthalene ring, an anthracene ring and a biphenylene ring. In addition, examples of the alkyl group represented by $R_0$ include a linear or branched alkyl group having 1 to 8 carbon atoms. Among them, the alkyl group represented by $R_0$ is preferably a linear or branched alkyl group having 1 to 4 carbon atoms, and it is more preferably a methyl group, an ethyl group, a propyl group, an isopropyl group, a butyl group, a sec-butyl group or a tert-butyl group. In addition, examples of the aryl group represented by $R_0$ include a phenyl group, a p-tolyl group, a naphthyl group and an anthryl group. As the combination of $Ar_0$, $R_0$ and b, from the viewpoint of the availability of raw materials, a combination

is preferable in which $Ar_1$ is a benzene ring and b is 0 to 3, and when b is 1 or more, $R_2$ is an alkyl group and/or an aryl group.

Specific examples of the phenol (hydroxy-substituted aromatic compound) represented by the formula (1) include phenol, 2,6-xylenol, 3,5-xylenol, naphthol, dihydroxynaphthalene, biphenol, hydroxyanthracene and dihydroxyanthracene. Among them, from the viewpoint of still more excellent handleability, phenol, 2,6-xylenol or 3,5-xylenol is preferable.

The amount of the phenol (hydroxy-substituted aromatic compound) represented by the formula (1) to be used is preferably 0.1 to 5 moles, more preferably 0.2 to 4 moles, and further preferably 0.3 to 3 moles based on the number of moles (1 mole) of the contained oxygen of the aromatic hydrocarbon formaldehyde resin (for example, deacetalized formaldehyde resin). When the amount to be used is in the above range, the yield of the obtained phenol-modified aromatic hydrocarbon formaldehyde resin is still more improved, and the remaining amount of the unreacted phenol (hydroxy-substituted aromatic compound) tends to be still more reduced.

The molecular weight of the obtained phenol-modified aromatic hydrocarbon formaldehyde resin is affected by the number of moles of the contained oxygen in the aromatic hydrocarbon formaldehyde resin (for example, deacetalized aromatic hydrocarbon formaldehyde resin) and the amount of the phenol (hydroxy-substituted aromatic compound) represented by the formula (1) to be used, and when both of them are increased, the molecular weight tends to decrease. Here, the number of moles of the contained oxygen can be determined by measuring the concentration of oxygen (% by mass) in the aromatic hydrocarbon formaldehyde resin (for example, deacetalized aromatic hydrocarbon formaldehyde resin) by organic elementary analysis and carrying out calculation in accordance with the following calculation formula:

number of moles of contained oxygen (mol) = amount of resin to be used (g) x concentration of oxygen (% by mass)/16.

Examples of the acidic catalyst to be used for the modification reaction include the acidic catalysts exemplified as the acidic catalyst to be used for the condensation reaction. These acidic catalysts are used alone as one kind or used in combination of two or more kinds.

The amount of the acidic catalyst to be used is preferably 0.0001 to 100 parts by mass, more preferably 0.001 to 85 parts by mass, and further preferably 0.001 to 70 parts by mass based on 100 parts by mass of the aromatic hydrocarbon formaldehyde resin (for example, deacetalized aromatic hydrocarbon formaldehyde resin). When the amount to be used is in the above range, the reaction rate is still more improved, and furthermore, since the reaction rate is improved, increase in the resin viscosity tends to be still more suppressed. The acidic catalyst may be placed in the reaction system at once, or may be placed sequentially.

The modification reaction is carried out, for example, in the presence of the acidic catalyst normally at normal pressure, and it is carried out while subjecting raw materials to be used to heating reflux at a temperature at which they are compatible or higher (normally, 80 to 300°C) and distilling off the produced water. In addition, the modification reaction may be carried out at normal pressure, or may be carried out while pressurizing the reaction system. In addition, the modification reaction may be carried out while passing an inert gas, such as nitrogen, helium and argon, through the reaction system, if required.

In addition, in the modification reaction, a solvent that is inert to the reaction may be used, if required. Examples of the solvent include the solvents exemplified as the solvent that can be used in the condensation reaction. These solvents are used alone as one kind or used in combination of two or more kinds.

In the modification reaction, the reaction time is preferably 0.5 to 20 hours, more preferably 1 to 15 hours, and further preferably 2 to 10 hours. When the reaction time is within the above range, there is a tendency that a resin having objective attributes is obtained still more economically and still more industrially.

In the modification reaction, the reaction temperature may be in the numerical value range of the reaction temperature exemplified in the condensation reaction.

After the reaction terminates, if required, a solvent may be further added for dilution, and the diluent is left to stand still and thus separated into two phases, thereby separating the resin phase, which is an oil phase, and the aqueous phase. Subsequently, if required, the acidic catalyst may be removed completely by further subjecting the resin phase to water washing, and the added solvent and unreacted raw materials may be removed by a general method such as distillation. Accordingly, a phenol-modified xylene formaldehyde resin is obtained.

For the phenol-modified aromatic hydrocarbon formaldehyde resin (particularly, modified xylene formaldehyde resin), compared to the aromatic hydrocarbon formaldehyde resin (particularly, xylene formaldehyde resin), there is a tendency that the residual amount upon thermal decomposition is still more increased (the mass reduction ratio is

reduced) and the hydroxy value is still more raised. Specifically, when the phenol modification is carried out under conditions where the amount of the acidic catalyst to be used is 0.05 part by mass, the reaction time is 5 hours, and the reaction temperature is 200°C, there is a tendency that the residual amount upon thermal decomposition is increased by approximately 1 to 50% and the hydroxy value is raised by approximately 1 to 300 mgKOH/g.

The main product of the modified aromatic hydrocarbon formaldehyde resin to be obtained by the above production method is, for example, those in which formaldehyde becomes a methylene group upon the reaction and an aromatic hydrocarbon (for example, xylene) and the aromatic ring of a phenol (for example, a benzene ring) are bonded to each other via this methylene group. The phenol-modified aromatic hydrocarbon formaldehyde resin (for example, phenol-modified xylene formaldehyde resin) to be obtained after the reaction is obtained as a mixture of numerous compounds because the position at which formaldehyde is bonded to the aromatic hydrocarbon (for example, xylene) and the phenol, the polymerization number and the like vary. Specifically, a phenol-modified xylene formaldehyde resin obtained by reacting phenol with a xylene formaldehyde resin, the product "NIKANOL G" manufactured by Fudow Company Limited, in the presence of para-toluenesulfonic acid is a mixture including a compound represented by the following formula (9), a compound represented by the following formula (10) and a compound represented by the following formula (11) as main components thereof.

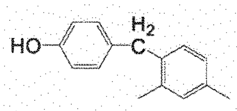

(9)

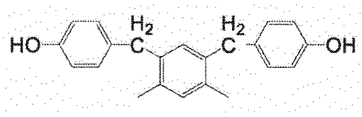

(10)

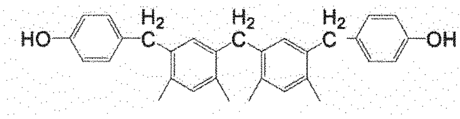

(11)

Specific examples of the above production method include a method in which xylene, an aqueous formalin solution, 2,6-xylenol and concentrated sulfuric acid are heated in a nitrogen stream, water is refluxed for 7 hours, the acid is then neutralized, and extraction is carried out with an organic solvent, thereby obtaining a modified xylene formaldehyde resin. In this case, the obtained modified xylene formaldehyde resin is a mixture including a compound represented by the following formula (12), a compound represented by the following formula (13), a compound represented by the following formula (14) and a compound represented by the following formula (15) as main components thereof.

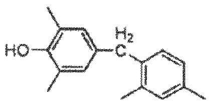

(12)

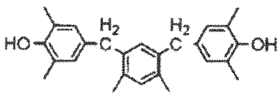

(13)

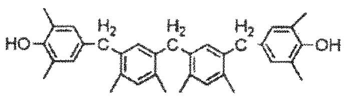

(14)

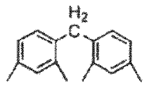

(15)

The hydroxy value (OH value) of the phenol-modified aromatic hydrocarbon formaldehyde resin (for example, xylene formaldehyde resin) is preferably 150 to 400 mgKOH/g and is more preferably 200 to 350 mgKOH/g from the viewpoint of handleability. The OH value is determined based on JIS-K1557-1.

The phenol-modified aromatic hydrocarbon formaldehyde resin (for example, phenol-modified xylene formaldehyde resin) may be produced by the above production method, or commercial products may also be used. Examples of the commercial product include, but not particularly limited to, the products "NIKANOL GL16" and "NIKANOL G" manufactured by Fudow Company Limited

(X2) Polyol-Modified Aromatic Hydrocarbon Formaldehyde Resin

A polyol-modified aromatic hydrocarbon formaldehyde resin (for example, polyol-modified xylene formaldehyde resin) is obtained by, for example, reacting the aromatic hydrocarbon formaldehyde resin (particularly, deacetalized aromatic hydrocarbon formaldehyde resin) with a polyol in the presence of an acidic catalyst. In addition, the polyol-modified aromatic hydrocarbon formaldehyde resin has an alcoholic hydroxy group that is rich in reactivity. The polyol-modified aromatic hydrocarbon formaldehyde resin includes a resin obtained by reacting a modified aromatic hydrocarbon formaldehyde resin that has been modified with a modifying agent other than polyols with a polyol.

Examples of the polyol include, but not particularly limited to, aliphatic polyols, alicyclic polyols and aromatic polyols, and it is preferable that the polyol be an aliphatic polyol. Examples of the aliphatic polyol include, but not particularly limited to, trimethylolpropane, neopentyl glycol, ester glycol, spiroglycol, pentaerythritol, ethylene glycol, diethylene glycol, dipropylene glycol, 1,2-butanediol, 1,3-butanediol, 1,4-butanediol, 1,5-pentanediol, 1,6-hexanediol, 2,5-hexanediol, 1,2-hexanediol, trimethylolethane, 1,2-octanediol, 1,10-decanediol, 1,2,4-butanediol, 3-hexane-2,5-diol, 2,5-dimethyl-3-hexane-2,5-diol, 2,2,4-trimethyl-1,3-pentanediol, polyethylene glycol and polyoxypropylene glycol. Among them, from the viewpoint of achieving the effect of the present invention more effectively and reliably, it is preferable that the polyol be a polyol represented by the following formula (1a):

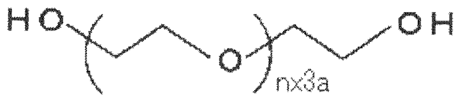

(1a)

In the formula (1a), nx3a represents an integer of 0 to 5.

Examples of the method for producing the polyol-modified aromatic hydrocarbon formaldehyde resin (for example, polyol-modified xylene formaldehyde resin) include a production method described in Japanese Patent Application Laid-Open No. 4-224815.

The hydroxy value of the polyol-modified aromatic hydrocarbon formaldehyde resin (for example, polyol-modified xylene formaldehyde resin) is not particularly limited, but is preferably 20 to 850 mgKOH/g, more preferably 50 to 600 mgKOH/g, and further preferably 100 to 400 mgKOH/g from the viewpoint of UV curability. The hydroxy value is determined based on JIS-K1557-1.

The weight average molecular weight (Mw) in terms of polystyrene of the polyol-modified aromatic hydrocarbon formaldehyde resin (for example, polyol-modified xylene formaldehyde resin) is not particularly limited, but is preferably 250 to 10,000, more preferably 250 to 5,000, and further preferably 250 to 2,000 from the viewpoint of UV curability. The weight average molecular weight (Mw) can be measured by gel permeation chromatography (GPC).

The polyol-modified aromatic hydrocarbon formaldehyde resin (for example, polyol-modified xylene formaldehyde resin) may be produced by the above production method, or commercial products may also be used. Examples of the commercial product include, but not particularly limited to, the products "K100E", "K140" and "K140E" manufactured by Fudow Company Limited.

(X3) Epoxy-Modified Aromatic Hydrocarbon Formaldehyde Resin

An epoxy-modified aromatic hydrocarbon formaldehyde resin is obtained by, for example, subjecting a phenol-modified aromatic hydrocarbon formaldehyde resin and an epihalohydrin to reaction (modification reaction).

Examples of the phenol-modified aromatic hydrocarbon formaldehyde resin include the phenol-modified aromatic hydrocarbon formaldehyde resins exemplified in the section of "(X1) Phenol-Modified Aromatic Hydrocarbon Formaldehyde Resin".

Examples of the epihalohydrin include epichlorohydrin, $\alpha$-methylepichlorohydrin, $\gamma$-methylepichlorohydrin and epibromohydrin. Among them, it is preferable that the epihalohydrin be epichlorohydrin from the viewpoint of easy availability.

The amount of the epihalohydrin to be used may be approximately 2 to 20 moles based on 1 mole of the phenolic hydroxy group of the phenol-modified aromatic hydrocarbon formaldehyde resin.

In the above modification reaction, in order to promote the reaction, a quaternary ammonium salt (for example, tetramethylammonium chloride, tetramethylammonium bromide and trimethylbenzylammonium chloride) may be added to the reaction system. The amount of the quaternary ammonium salt to be used may be approximately 0.1 to 15 g based on 1 mole of the phenolic hydroxy group of the phenol-modified aromatic hydrocarbon formaldehyde resin.

In addition, in the above modification reaction, a solvent that is inert to the reaction may be used, if required. Examples of the solvent include alcohols (for example, methanol, ethanol and isopropyl alcohol) and aprotic polar solvents (for example, dimethyl sulfone, dimethyl sulfoxide, tetrahydrofuran and dioxane). These solvents are used alone as one kind or used in combination of two or more kinds. The amount of the solvent to be used may be, in the case of using an alcohol as the solvent, approximately 2 to 50 parts by mass based on 100 parts by mass of the amount of the epihalohydrin to be used, and in the case of using an aprotic polar solvent as the solvent, approximately 10 to 80 parts by mass based on 100 parts by mass of the amount of the epihalohydrin to be used.

The reaction time in the modification reaction may be approximately 0.5 to 10 hours, and the reaction temperature may be approximately 30 to 90°C. After the reaction terminates, the epihalohydrin and the solvent may be removed under heating and reduced pressure after washing the reaction product with water or without water washing.

(X4) Acrylic Modified Aromatic Hydrocarbon Formaldehyde Resin

An acrylate-modified aromatic hydrocarbon formaldehyde resin (for example, acrylate-modified xylene formaldehyde resin) is obtained by, for example, subjecting a polyol-modified aromatic hydrocarbon formaldehyde resin (for example, xylene formaldehyde resin) and acrylic acid or a derivative thereof (for example, halogenated acrylic acid such as acryloyl chloride) to esterification reaction.

Examples of the polyol-modified aromatic hydrocarbon formaldehyde resin include the polyol-modified aromatic hydrocarbon formaldehyde resins exemplified in the section of "(X2) Polyol-Modified Aromatic Hydrocarbon Formaldehyde Resin".

The acrylic modified aromatic hydrocarbon formaldehyde resin (for example, acrylic modified xylene formaldehyde resin) is, for example, a mixture of a variety of structures including functional groups having high reactivity. Therefore, the acrylic modified aromatic hydrocarbon formaldehyde resin has still more excellent adhesiveness, cohesiveness, dispersibility, toughness, flexibility, heat resistance, water resistance and chemical resistance, still more suitable viscosity and compatibility, and still much better elongation, and furthermore, also has still more excellent optical properties (for example, high transparency, scarce discoloration and amorphousness).

The acrylic modified aromatic hydrocarbon formaldehyde resin (for example, acrylic modified xylene formaldehyde resin) has excellent reactivity, and therefore, there is a tendency that a cured product can be obtained by UV irradiation still more readily. Therefore, even when the acrylic modified aromatic hydrocarbon formaldehyde resin (for example, acrylic modified xylene formaldehyde resin) is cured alone, a coating having still more excellent flexibility, adhesiveness and transparency is obtained.

The ester value of the acrylic modified aromatic hydrocarbon formaldehyde resin (for example, xylene formaldehyde resin) of the present embodiment is not particularly limited, but is preferably 20 to 850 mgKOH/g, more preferably 50 to 500 mgKOH/g, and further preferably 100 to 200 mgKOH/g from the viewpoint of UV curability. The ester value is determined based on JIS K 0070: 1992.

[Method for Producing Acrylic Modified Aromatic Hydrocarbon Formaldehyde Resin (Acrylic Modified Xylene Formaldehyde Resin)]

A method for producing the acrylic modified aromatic hydrocarbon formaldehyde resin (for example, acrylic modified xylene formaldehyde resin) of the present embodiment comprises a step of esterifying a polyol-modified xylene formaldehyde resin and acrylic acid or a derivative thereof. Examples of the esterification are not particularly limited as long as it is a publicly known esterification, but include a dehydrative esterification method and a transesterification method.

(Production Method Including Dehydrative Esterification Method)

In the method for producing the acrylic modified aromatic hydrocarbon formaldehyde resin (for example, acrylic

modified xylene formaldehyde resin) of the present embodiment, it is preferable that the method comprise a step of subjecting a polyol-modified xylene formaldehyde resin and acrylic acid or a derivative thereof to dehydrative esterification in the presence of an acidic catalyst. In this step, the dehydrative esterification may be carried out in the presence of an acidic catalyst and a polymerization inhibitor.

Examples of the acidic catalyst include, but not particularly limited to, publicly known acidic catalysts. For example, mention may be made of sulfuric acid, hydrochloric acid, phosphoric acid, fluoroboric acid, benzenesulfonic acid, p-toluenesulfonic acid, methanesulfonic acid and cation exchange resins. These acidic catalysts are used alone as one kind or used in combination of two or more kinds. Among them, sulfuric acid and p-toluenesulfonic acid are preferable from the viewpoint of easy availability, inexpensiveness and still more excellent reactivity. The amount of the acidic catalyst to be used is preferably 0.01 to 10 mol% based on 1 mole of the molar quantity of acrylic acid to be placed.

Examples of the polymerization inhibitor are not particularly limited, but they are preferably those comprising a copper compound and a phenolic compound.

The copper compound may be an anhydride or a hydrate, and examples thereof include cupric halides such as cupric chloride and cupric bromide; cuprous halides such as cuprous chloride and cuprous bromide; copper sulfate; and copper dialkyldithiocarbamates such as copper dimethyldithiocarbamate and copper dibutyldithiocarbamate. These polymerization inhibitors can be used alone as one kind or may be used in combination of two or more kinds. Among them, cupric chloride and/or copper sulfate are preferable from the viewpoint of exhibiting still much stronger polymerization inhibiting actions and being still more inexpensive.

Examples of the phenolic compound include hydroquinone, hydroquinone monomethyl ether, tert-butylcatechol, 2,6-di-tert-butylphenol, 2,4-di-tert-butylphenol, 2-tert-butyl-4,6-dimethylphenol, 2,6-di-tert-butyl-4-methyl-phenol and 2,4,6-tri-tert-butylphenol. These phenolic compounds can be used alone as one kind or may be used in combination of two or more kinds. Among them, hydroquinone and hydroquinone monomethyl ether are preferable from the viewpoint of being still more inexpensive and being removed still more readily by neutralization and washing after the dehydrative esterification.

The amount of the polymerization inhibitor to be used is, regardless of the amount of any of the copper compound and the phenolic compound to be used, preferably 5 to 20,000 ppm by weight, and more preferably 25 to 3,000 ppm by weight based on the entire reaction solution. When the amount to be used is less than 5 ppm by weigh, there is a risk that polymerization inhibiting effects are insufficient. In addition, when the amount to be used is greater than 20,000 ppm by weight, further addition of the polymerization inhibitor does not improve polymerization inhibiting effects, which is uneconomical, and there is a risk that staining occurs in the acrylic modified xylene formaldehyde resin to be obtained.

The esterification reaction of the polyol-modified aromatic hydrocarbon formaldehyde resin (for example, polyol-modified xylene formaldehyde resin) and acrylic acid may be carried out based on a publicly known method. Specifically, examples thereof include a method in which the polyol-modified aromatic hydrocarbon formaldehyde resin (polyol-modified xylene formaldehyde resin) and acrylic acid are heated and stirred for esterification in the presence of the acidic catalyst and the polymerization inhibitor.

The proportion of the amount of acrylic acid or an acrylic acid derivative to be placed to the amount of the polyol-modified aromatic hydrocarbon formaldehyde resin (for example, xylene formaldehyde resin) to be placed is not particularly limited, but the molar quantity of acrylic acid to be placed is preferably 0.5 to 3 moles based on 1 mole of the entire amount of hydroxy groups in the polyol-modified aromatic hydrocarbon formaldehyde resin (for example, xylene formaldehyde resin).

The end point of the esterification reaction may be arbitrarily set by controlling the amount of water as a byproduct and the like.

The esterification reaction may be carried out in the presence of a solvent, or may be carried out under conditions where a solvent is not present. In the esterification reaction, water is produced along with the progress of the reaction. Therefore, the solvent is preferably a solvent that can be removed azeotropically with water from the viewpoint of still more improving the reaction rate.

Examples of the solvent include, but not particularly limited to, aromatic hydrocarbons such as toluene, benzene and xylene; aliphatic hydrocarbons such as n-hexane, cyclohexane and n-heptane; organic chlorine compounds such as trichloroethane, tetrachloroethylene and methyl chloroform; and ketones such as methyl isobutyl ketone. These solvents are used alone as one kind or used in combination of two or more kinds.

The proportion (weight ratio) of these solvents to be used to the entire amount of the reaction raw materials is not particularly limited, but is preferably 0.1 to 10 and is more preferably 2 to 5.

In the above modification reaction, the reaction temperature is not particularly limited, but is preferably 65 to 140°C and is more preferably 75 to 120°C from the viewpoint of reducing the reaction time and preventing the polymerization. When the reaction temperature is less than 65°C, there is a risk that the reaction rate is too slow, thereby reducing the yield, and when the reaction temperature is greater than 140°C, there is a risk that acrylic acid or the acrylic modified xylene formaldehyde resin is thermally polymerized.

In the above modification reaction, the reaction is preferably carried out under conditions of normal pressure

or while reducing the pressure a little.

In the above modification reaction, it is preferable that the esterification reaction be carried out in the presence of oxygen for the purpose of preventing thermal polymerization of acrylic acid or the acrylic modified aromatic hydrocarbon formaldehyde resin (for example, acrylic modified xylene formaldehyde resin). Specifically, examples thereof include a method in which the esterification reaction is carried out while blowing an inert gas comprising oxygen into the reaction solution. Examples of the inert gas include nitrogen and helium, and it is preferably nitrogen from the viewpoint of being inexpensive.

In the above modification reaction, in addition to the above polymerization inhibitor, additional polymerization inhibitor may be used in combination, if required. Specifically, examples thereof include quinone-based polymerization inhibitors such as p-benzoquinone and naphthoquinone; thiophenol-based polymerization inhibitors such as 3-hydroxythiophenol; naphthol-based polymerization inhibitors such as α-nitroso-β-naphthol; and amine-based polymerization inhibitors such as alkylated diphenylamine, N,N'-diphenyl-p-phenyleneamine and phenothiazine. These additional polymerization inhibitors can be used alone as one kind or may be used in combination of two or more kinds.

Examples of the reaction apparatus to be used for the above reaction include, but not particularly limited to, a reactor equipped with a stirrer, a thermometer, an air supply pipe and a water separator.

In the method for producing the acrylic modified aromatic hydrocarbon formaldehyde resin, the reaction product obtained by the esterification reaction may be purified according to a publicly known method. Specifically, the reaction solution may be neutralized, and then it may be washed with water. Subsequently, after separating the aqueous layer, the reaction solvent may be distilled off under reduced pressure, and filtration may be carried out if required. The neutralization step is carried out for the purpose of removing unreacted acrylic acid and the acidic catalyst in the reaction solution. Examples of the neutralization step include a method in which an alkaline aqueous solution is added to the reaction solution and the resultant mixture is stirred.

The polyol-modified aromatic hydrocarbon formaldehyde resin to be used as a raw material (polyol-modified aromatic hydrocarbon formaldehyde resin) may be, for example, a resin obtained by reacting a modified xylene formaldehyde resin with a polyol, wherein the resin has an alcoholic hydroxy group that is rich in reactivity.

The modified aromatic hydrocarbon formaldehyde resin is not particularly limited, but preferably includes a compound represented by the following formula (2) from the viewpoint of heat resistance.

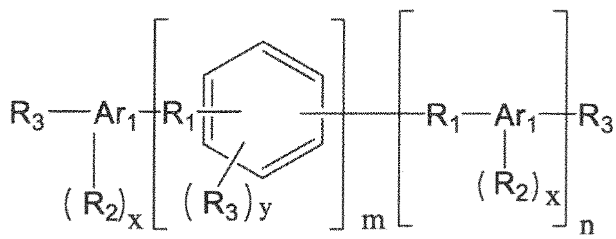

(2)

In the formula (2), $Ar_1$ represents an aromatic ring or an aliphatic ring (preferably, aromatic ring); $R_1$ is a methylene group, a methyleneoxy group, an oxymethylene group or a divalent group formed by combining two or more groups thereof; $R_2$ represents a hydrogen atom, a hydroxy group, an alkyl group having 1 to 30 carbon atoms, an aryl group having 6 to 30 carbon atoms, an alkoxy group having 1 to 30 carbon atoms, an alkoxycarbonyl group having 1 to 30 carbon atoms, an alkenyl group having 2 to 30 carbon atoms, a group represented by the following formula (A) or a crosslinkable reactive group, wherein the alkyl group, the aryl group, the alkoxy group and the alkenyl group may be substituted with one substituent selected from the group consisting of a hydroxy group, an alkyl group having 1 to 12 carbon atoms and an alkoxy group, and wherein the alkyl group, the aryl group, the alkoxy group and the alkenyl group may comprise one bonding group selected from the group consisting of an ether bond, a ketone bond and an ester bond, where, when there are a plurality of $R_2$, the plurality of $R_2$ may be the same or different; $R_3$ is a hydrogen atom, a hydroxy group, an alkyl group having 1 to 3 carbon atoms, an aryl group, a hydroxymethylene group or a group represented by the following formula (B), the following formula (C1), the following formula (C2) or the following formula (C3), where, when there are a plurality of $R_3$, the plurality of $R_3$ may be the same or different; m represents an integer of 1 or more; n represents an integer of 1 or more; the arrangement of each unit is arbitrary; x represents an integer of 0 or more; and y represents an integer of 0 to 4, provided that either the formula (2) necessarily has any of the groups represented by the following formula (A), the following formula (B), the following formula (C1), the following formula (C2) and the following formula (C3), or $Ar_1$ has an aromatic ring and at least one of $R_2$ bonded to the aromatic ring $Ar_1$ is a hydroxy group.

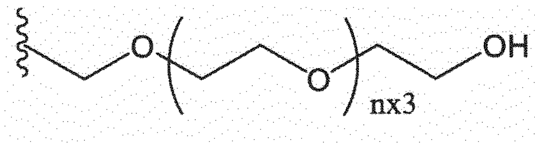

(A)

In the formula (A), nx3 represents an integer of 1 to 5.

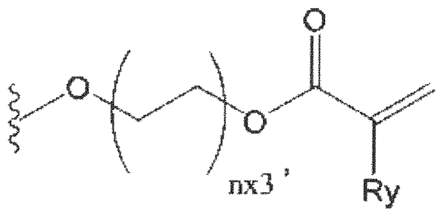

(B)

In the formula (B), nx3' represents an integer of 1 to 5 and Ry represents a hydrogen atom or a methyl group.

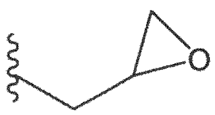

(C1)

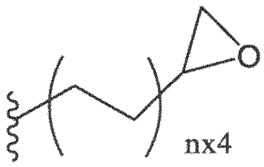

(C2)

In the formula (C2), nx4 represents an integer of 1 to 5.

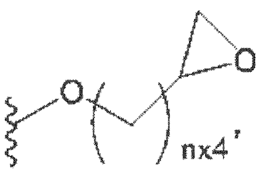

(C3)

In the formula (C3), nx4' represents an integer of 1 to 5.

In the formula (2), m and n represent the ratio of each unit, and the arrangement of each unit is arbitrary. That is, the modified aromatic hydrocarbon formaldehyde resin represented by the formula (2) may be a random copolymer or may be a block copolymer. In addition, the modified aromatic hydrocarbon formaldehyde resin represented by the formula (2) may be crosslinked (linked) with 2 or more $R^1$. The upper limit value of m is, for example, 50 or less and preferably 20 or less, and the upper limit value of n is, for example, 20 or less.

Representative examples of the phenol-modified aromatic hydrocarbon formaldehyde resin represented by the following formula (2) are shown below. The phenol-modified aromatic hydrocarbon formaldehyde resin preferably includes a compound represented by the following formula (17), more preferably includes a compound represented by the following formula (18), and further preferably includes a compound represented by the following formula (19) from the viewpoint of reactivity.

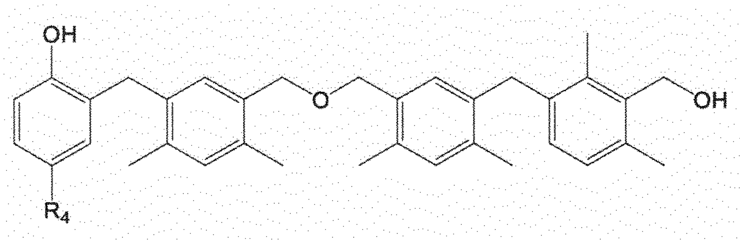
(17)

In the formula (17), $R_4$ represents a linear, branched or cyclic alkyl group having 1 to 30 carbon atoms.

The phenol-modified xylene formaldehyde resin represented by the formula (17) is a compound formed by modifying the xylene formaldehyde resin represented by the formula (16) with an alkylphenol represented by the formula: R4-Ph-OH, wherein $R_4$ represents a linear, branched or cyclic alkyl group having 1 to 30 carbon atoms; Ph represents a phenyl group; and $R_4$ is bonded to the para position.

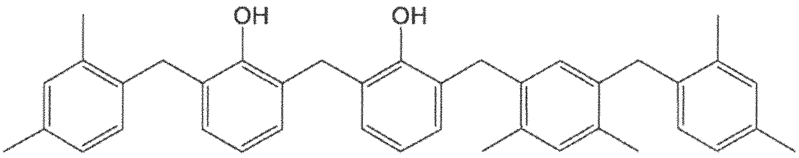
(18)

The phenol-modified xylene formaldehyde resin represented by the formula (18) is a compound formed by modifying the xylene formaldehyde resin represented by the formula (16) with phenol.

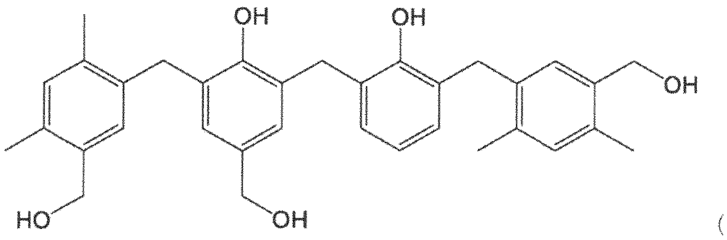
(19)

The phenol-modified xylene formaldehyde resin represented by the formula (19) is a compound formed by modifying the xylene formaldehyde resin represented by the formula (16) with a phenol.

Representative examples of the polyol-modified aromatic hydrocarbon formaldehyde resin represented by the following formula (2) are shown below. The polyol-modified aromatic hydrocarbon formaldehyde resin preferably includes a compound represented by the following formula (20), and more preferably includes a compound represented by the following formula (21) from the viewpoint of reactivity.

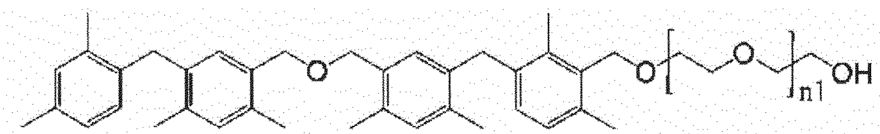
(20)

In the formula (20), n1 represents an integer of 0 to 3.

The polyol-modified xylene formaldehyde resin represented by the formula (20) is a compound formed by modifying the xylene formaldehyde resin represented by the formula (16) with (poly)ethylene oxide.

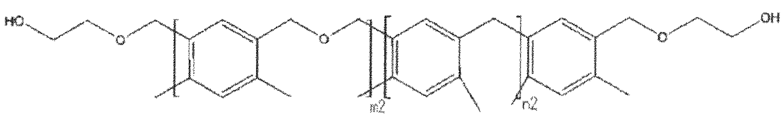
(21)

In the formula (21), m2 represents an integer of 1 to 4, and n2 represents an integer of 1 to 4.

The polyol-modified xylene formaldehyde resin represented by the formula (21) is a compound formed by modifying the xylene formaldehyde resin represented by the formula (16) with ethylene glycol.

Representative examples of the epoxy-modified aromatic hydrocarbon formaldehyde resin represented by the following formula (2) are shown below. The epoxy-modified aromatic hydrocarbon formaldehyde resin preferably includes a compound represented by the following formula (22) from the viewpoint of reactivity.

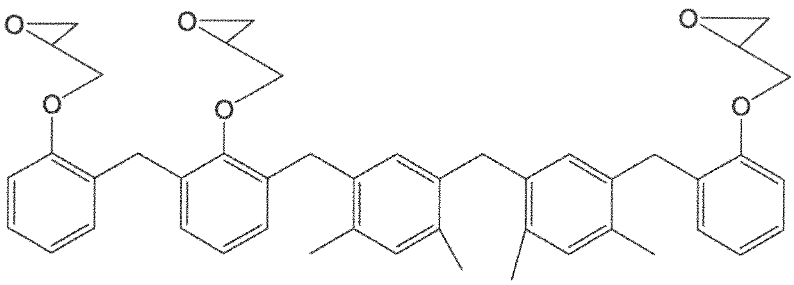

(22)

The epoxy-modified xylene formaldehyde resin represented by the formula (22) is a compound formed by subjecting the phenol-modified formaldehyde resin represented by the formula (18) to epoxy modification.

Representative examples of the acrylic modified aromatic hydrocarbon formaldehyde resin represented by the formula (2) are shown below. The acrylic modified aromatic hydrocarbon formaldehyde resin preferably includes a compound represented by the following formula (23) from the viewpoint of reactivity.

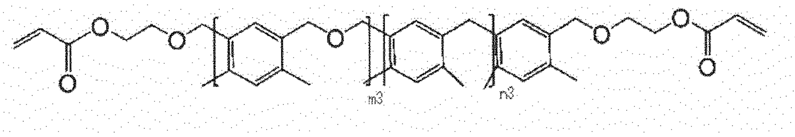

(23)

In the formula (23), m3 represents an integer of 1 to 4, and n3 represents an integer of 1 to 4.

The acrylic epoxy-modified xylene formaldehyde resin represented by the formula (23) is a compound formed by subjecting the polyol-modified xylene formaldehyde resin represented by the above formula (21) to acrylic modification.

[Method for Purifying Component (A)]

A method for purifying the component (A) of the present embodiment comprises the steps of: obtaining a solution (S) by dissolving the component (A) in a solvent; and extracting impurities in the component (A) by bringing the obtained solution (S) into contact with an acidic aqueous solution (a first extraction step). In the step of obtaining the solution (S), the solvent comprises an organic solvent that does not mix with water.

According to the purification method of the present embodiment, the contents of various metals contained in the component (A) can be reduced.

More specifically, in the purification method of the present embodiment, the above component (A) is dissolved in an organic solvent that does not mix with water (hereinafter, also referred to as a "particular organic solvent") to obtain the solution (S), and furthermore, extraction treatment can be carried out by bringing that solution (S) into contact with an acidic aqueous solution. Thereby, metals contained in the solution (S) containing the component (A) of the present embodiment are transferred to the aqueous phase, then the organic phase and the aqueous phase are separated, and thus the component (A) having a reduced metal content can be obtained.

The component (A) of the present embodiment to be used in the purification method of the present embodiment may be a single component, or may be a mixture containing two or more components. In addition, in the purification method of the present embodiment, purification may be carried out in a form where the component (A) contains various crosslinking agents, various acid generating agents, various stabilizers and the like, and additional components (for example, surfactants), all of which will be mentioned later.

The particular organic solvent to be used in the purification method of the present embodiment is not particularly limited, but is preferably an organic solvent that is safely applicable to semiconductor manufacturing processes, and specifically it may be an organic solvent having a solubility in water at room temperature of less than 30 g based on 100 g of water (preferably less than 20 g and more preferably less than 10 g). The proportion of the amount of the organic solvent to be used to the amount of the component (A) of the present embodiment to be used is preferably 1 to 100.

Specific examples of the particular organic solvent include organic solvents described in International Publication No. WO 2015/080240. These particular organic solvents are used alone as one kind or used in combination of two or more kinds. Among them, it is preferable that the particular organic solvent be one or more selected from the group consisting of toluene, 2-heptanone, cyclohexanone, cyclopentanone, methyl isobutyl ketone, propylene glycol monomethyl ether acetate and ethyl acetate, it is more preferable that the particular organic solvent be one or more selected from the group consisting of methyl isobutyl ketone, ethyl acetate, cyclohexanone and propylene glycol monomethyl ether acetate, and methyl isobutyl ketone and/or ethyl acetate are further preferable. Methyl isobutyl ketone and ethyl acetate can make the saturation solubility of the component (A) of the present embodiment relatively high, and since the boiling point thereof is relatively low, the load in the case of industrially distilling off the solvent and in the step of removing the solvent by drying can be still more reduced.

Examples of the acidic aqueous solution to be used in the purification method of the present embodiment include, but are not particularly limited to, those described in International Publication No. WO 2015/080240. These acidic aqueous solutions can be used alone as one kind or may be used in combination of two or more kinds. Among these acidic aqueous solutions, aqueous solutions of one or more mineral acids selected from the group consisting of hydrochloric acid, sulfuric acid, nitric acid and phosphoric acid, or aqueous solutions of one or more organic acids selected from the group consisting of acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid are preferable; aqueous solutions of sulfuric acid, nitric acid and acetic acid, as well as carboxylic acids (for example, oxalic acid, tartaric acid and citric acid) are more preferable; aqueous solutions of one or more selected from the group consisting of sulfuric acid, oxalic acid, tartaric acid and citric acid are further preferable; and an aqueous solution of oxalic acid is even further preferable. Polyvalent carboxylic acids such as oxalic acid, tartaric acid and citric acid coordinate with metal ions and provide a chelating effect, and thus tend to be capable of removing metals still more effectively. As for water used herein, it is preferable to use water, the metal content of which is small, such as ion exchanged water, according to the purpose of the purification method of the present embodiment.

The pH of the acidic aqueous solution to be used in the purification method of the present embodiment is not particularly limited, but it is preferable to regulate the acidity of the aqueous solution in consideration of an influence on the component (A) of the present embodiment. For example, the pH of the acidic aqueous solution is approximately 0 to 5, and is preferably approximately 0 to 3.

The amount of the acidic aqueous solution to be used in the purification method of the present embodiment is not particularly limited, but it is preferable to regulate the amount to be used within the above range from the viewpoint of reducing the number of extraction operations for removing metals, and furthermore, from the viewpoint of ensuring operability in consideration of the overall amount of fluid. From the same viewpoints, the amount of the acidic aqueous solution to be used is preferably 10 to 200 parts by mass, and is more preferably 20 to 100 parts by mass based on 100 parts by mass of the solution (S).

In the purification method of the present embodiment, by bringing the above acidic aqueous solution into contact with the component (A) of the present embodiment and the solution (S) containing the particular organic solvent, metals can be extracted from the component (A) in the solution (S).

In the purification method of the present embodiment, it is preferable that the solution (S) further contain an organic solvent that mixes with water. When an organic solvent that mixes with water is contained, there is a tendency that the amount of the component (A) of the present embodiment to be placed can be increased, also the fluid separability is improved, and purification can be carried out at a high reaction vessel efficiency. The method for adding the organic solvent that mixes with water is not particularly limited, and may be, for example, any of a method involving adding it to the organic solvent-containing solution in advance, a method involving adding it to water or the acidic aqueous solution in advance, and a method involving adding it after bringing the organic solvent-containing solution into contact with water or the acidic aqueous solution. Among them, it is preferable to use the method involving adding it to the organic solvent-containing solution in advance from the viewpoint of the workability of operations and the ease of managing the amount to be placed.

In the purification method of the present embodiment, the organic solvent that mixes with water is not particularly limited, but is preferably an organic solvent that is safely applicable to semiconductor manufacturing processes. The amount of the organic solvent that mixes with water to be used is not particularly limited as long as the solution phase and the aqueous phase separate, but is preferably 0.1 to 100 times by mass, more preferably 0.1 to 50 times by mass, and further preferably 0.1 to 20 times by mass based on the amount of the component (A) of the present embodiment to be used.

In the purification method of the present embodiment, specific examples of the organic solvent that mixes with water include those described in International Publication No. WO 2015/080240. Among them, N-methylpyrrolidone, propylene glycol monomethyl ether, and the like are preferable, and N-methylpyrrolidone and propylene glycol monomethyl ether are more preferable. These solvents can be used alone as one kind or may be used in combination of two or more kinds.

The temperature upon carrying out the extraction treatment is, for example, 20 to 90°C, and is preferably 30 to 80°C. The extraction operation is carried out, for example, by thoroughly mixing the solution (S) and the acidic aqueous solution by stirring or the like and then leaving the obtained mixed solution to stand still. Thereby, metal components contained in the solution containing the component (A) of the present embodiment and the organic solvents are transferred to the aqueous phase. Also, by this operation, the acidity of the solution is lowered, and deterioration of the component (A) of the present embodiment can be suppressed.

By being left to stand still, the above solution is separated into the solution phase containing the component (A) of the present embodiment and the organic solvents and the aqueous phase, and thus, the solution phase containing the component (A) of the present embodiment and the solvents is recovered by decantation or the like. The time to stand still is not particularly limited, but it is preferable to regulate the time to stand still from the viewpoint of attaining much better separation of the solution phase containing the organic solvents and the aqueous phase. The time for leaving the mixed solution to stand still is, for example, 1 minute or longer, preferably 10 minutes or longer, and more preferably 30 minutes or longer. While the extraction treatment may be carried out only once, it is effective to repeat mixing, leaving-to-stand-still, and separating operations multiple times.

It is preferable that the purification method of the present embodiment include a step of extracting impurities in the component (A) by further bringing the solution phase containing the component (A) into contact with water after the first extraction step (the second extraction step). Specifically, for example, it is preferable that, after the above extraction treatment is carried out using the acidic aqueous solution, the solution phase that has been extracted and recovered from the aqueous solution and that contains the component (A) of the present embodiment and the solvents be further subjected to the extraction treatment with water. The above extraction treatment with water is not particularly limited, and can be carried out, for example, by thoroughly mixing the above solution phase and water by stirring or the like and then leaving the obtained mixed solution to stand still. The mixed solution after being left to stand still is separated into the solution phase containing the component (A) of the present embodiment and the solvents and the aqueous phase, and thus, the solution phase containing the component (A) of the present embodiment and the solvents can be recovered by decantation or the like.

In addition, it is preferable that the water to be used in the second extraction step be water, the metal content of which is small, such as ion exchanged water, according to the purpose of the present embodiment. While the number of extraction treatment may be only once, it is effective to repeat mixing, leaving-to-stand-still, and separating operations multiple times. In addition, conditions in the extraction treatment, such as the proportion of both to be used, temperature and time, are not particularly limited, and may be the same as the above contact treatment conditions with the acidic aqueous solution.

Water that is possibly present in the solution containing the component (A) of the present embodiment and the solvents can be readily removed by performing operations such as vacuum distillation. Also, if required, the concentration of the component (A) of the present embodiment can be regulated to be any concentration by adding a solvent to the above solution.

Examples of the method for isolating the component (A) from the solution containing the component (A) of the present embodiment and the solvents include, but not particularly limited to, publicly known methods, such as reduced-pressure removal, separation by reprecipitation, and a combination thereof. If required, publicly known treatments such as concentration operation, filtration operation, centrifugation operation, and drying operation can be further carried out.

The component (A) of the present embodiment contains, for example, one or more compounds represented by the formula (1).

If required, in addition to the "component (A)", the composition for film formation for lithography of the present embodiment may comprise, as an optional component, at least one component among a radical polymerization initiator, a curable monomer, a photocurable oligomer, a photocurable polymer and an additional component. Hereinafter, these optional components will be described.

<Radical Polymerization Initiator>

The composition for film formation for lithography of the present embodiment may further contain a radical polymerization initiator from the viewpoint of achieving the effect of the present invention more effectively and reliably. The radical polymerization initiator may be a photopolymerization initiator that initiates radical polymerization by light, or may be a thermal polymerization initiator that initiates radical polymerization by heat.

Examples of such a radical polymerization initiator include, but not particularly limited to, publicly known radical polymerization initiators, and these radical polymerization initiators can be used alone as one kind or may be used in combination of two or more kinds. Among them, from the viewpoint of achieving the effect of the present invention more effectively and reliably, it is preferable that the radical polymerization initiator be at least one selected from the group consisting of a ketone-based photopolymerization initiator, an organic peroxide-based polymerization initiator and an azo-based polymerization initiator.

Examples of the ketone-based photopolymerization initiator include an acylphosphine oxide-based photopolymerization initiator, an aromatic ketone-based photopolymerization initiator, a quinone-based photopolymerization initiator, and an alkylphenone-based polymerization initiator. Examples of the acylphosphine oxide-based photopolymerization initiator include (2,6-dimethoxybenzoyl)-2,4,6-pentylphosphine oxide, bis(2,4,6-trimethylbenzoyl)-phenylphosphine oxide, 2,4,6-trimethylbenzoyldiphenylphosphine oxide ("IRGACURE-TPO" (manufactured by BASF SE)), ethyl-2,4,6-trimethylbenzoylphenylphosphinate, bis(2,4,6-trimethylbenzoyl)-phenylphosphine oxide ("IRGACURE-819" (manufactured by BASF SE)), (2,5-dihydroxyphenyl)diphenylphosphine oxide, (p-hydroxyphenyl)diphenylphosphine oxide, bis(p-hydroxyphenyl)phenylphosphine oxide, and tris(p-hydroxyphenyl)phosphine oxide. Examples of the aromatic ketone-based photopolymerization initiator include benzophenone, N,N'-tetramethyl-4,4'-diaminobenzophenone (Michler's ketone), N,N'-tetraethyl-4,4'-diaminobenzophenone, 4-methoxy-4'-dimethylaminobenzophenone, 2,2-dimethoxy-1,2-diphenylethan-1-one ("IRGACURE-651" (manufactured by BASF SE)), 2-benzyl-2-dimethylamino-1-(4-morpholinophenyl)-butan-1-one ("IRGACURE-369" (manufactured by BASF SE)), and 2-methyl-1-[4-(methylthio)phenyl]-2-morpholinopropan-1-one ("IRGACURE-907" (manufactured by BASF SE)). Examples of the quinone-based photopolymerization initiator include 2-ethylanthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylanthraquinone, 1-chloroanthraquinone, 2-methylanthraquinone, 1,4-naphthoquinone, 9,10-phenanthraquinone, 2-methyl-1,4-naphthoquinone, and 2,3-dimethylanthraquinone. Examples of the alkylphenone-based photopolymerization initiator include benzoin-based compounds such as benzoin, benzoin methyl ether, benzoin ethyl ether, benzoin isopropyl ether and benzoin phenyl ether; 2,2-dimethoxy-1,2-diphenylethan-1-one ("IRGACURE-651" (manufactured by BASF SE)), 1-hydroxy-cyclohexylphenylketone ("IRGACURE-184" (manufactured by BASF SE)), 2-hydroxy-2-methyl-1-phenyl-propan-1-one ("IRGACURE-1173" (manufactured by BASF SE)), 1-[4-(2-hydroxyethoxy)-phenyl]-2-hydroxy-2-methyl-1-propan-1-one ("IRGACURE-2959" (manufactured by BASF SE)), and 2-hydroxy-1-{4-[4-(2-hydroxy-2-methyl-propionyl)-benzyl]phenyl}-2-methyl-propan-1-one ("IRGACURE-127" (manufactured by BASF SE)).

Specific examples of the organic peroxide-based polymerization initiator include methyl ethyl ketone peroxide, cyclohexanone peroxide, methylcyclohexanone peroxide, methyl acetoacetate peroxide, acetyl acetate peroxide, 1,1-bis(t-hexylperoxy)-3,3,5-trimethylcyclohexane, 1,1-bis(t-hexylperoxy)-cyclohexane, 1,1-bis(t-butylperoxy)-3,3,5-trimethylcyclohexane, 1,1-bis(t-butylperoxy)-2-methylcyclohexane, 1,1-bis(t-butylperoxy)-cyclohexane, 1,1-bis(t-butylperoxy)cyclododecane, 1,1-bis(t-butylperoxy)butane, 2,2-bis(4,4-di-t-butylperoxycyclohexyl)propane, p-menthane hydroperoxide, diisopropylbenzene hydroperoxide, 1,1,3,3-tetramethylbutyl hydroperoxide, cumene hydroperoxide, t-hexyl hydroperoxide, t-butyl hydroperoxide, $\alpha,\alpha'$-bis(t-butylperoxy)diisopropylbenzene, dicumyl peroxide, 2,5-dimethyl-2,5-bis(t-butylperoxy)hexane, t-butylcumyl peroxide, di-t-butyl peroxide, 2,5-dimethyl-2,5-bis(t-butylperoxy)hexyne-3, isobutyryl peroxide, 3,5,5-trimethylhexanoyl peroxide, octanoyl peroxide, lauroyl peroxide, stearoyl peroxide, succinic acid peroxide, m-toluoyl benzoyl peroxide, benzoyl peroxide, di-n-propyl peroxydicarbonate, diisopropyl peroxydicarbonate, bis(4-t-butylcyclohexyl) peroxydicarbonate, di-2-ethoxyethyl peroxydicarbonate, di-2-ethoxyhexyl peroxydicarbonate, di-3-methoxybutyl peroxydicarbonate, di-s-butyl peroxydicarbonate, di(3-methyl-3-methoxybutyl) peroxydicarbonate, $\alpha,\alpha'$-bis(neodecanoylperoxy)diisopropylbenzene, cumyl peroxyneodecanoate, 1,1,3,3-tetramethylbutyl peroxyneodecanoate, 1-cyclohexyl-1-methylethyl peroxyneodecanoate, t-hexyl peroxyneodecanoate, t-butyl peroxyneodecanoate, t-hexyl peroxypivalate, t-butyl peroxypivalate, 1,1,3,3-tetramethylbutyl peroxy-2-ethylhexanoate, 2,5-dimethyl-2,5-bis(2-ethylhexanoylperoxy)hexanoate, 1-cyclohexyl-1-methylethyl peroxy-2-ethylhexanoate, t-hexyl peroxy-2-ethylhexanoate, t-butyl peroxy-2-ethylhexanoate, t-hexyl peroxyisopropylmonocarbonate, t-butyl peroxyisobutyrate, t-butyl peroxymalate, t-butyl peroxy-3,5,5-trimethylhexanoate, t-butyl peroxylaurate, t-butyl peroxyisopropylmonocarbonate, t-butyl peroxy-2-ethylhexylmonocarbonate, t-butyl peroxyacetate, t-butyl peroxy-m-toluylbenzoate, t-butyl peroxybenzoate, bis(t-butylperoxy) isophthalate, 2,5-dimethyl-2,5-bis(m-toluylperoxy)hexane, t-hexyl peroxybenzoate, 2,5-dimethyl-2,5-bis(benzoylperoxy)hexane, t-butyl peroxyallylmonocarbonate, t-butyltrimethylsilyl peroxide, 3,3',4,4'-tetra(t-butylperoxycarbonyl)benzophenone and 2,3-dimethyl-2,3-diphenylbutane.

Specific examples of the azo-based polymerization initiator include 2-phenylazo-4-methoxy-2,4-dimethylvaleronitrile, 1-[(1-cyano-1-methylethyl)azo]formamide, 1,1'-azobis(cyclohexane-1-carbonitrile), 2,2'-azobis(2-methylbutyronitrile), 2,2'-azobisisobutyronitrile, 2,2'-azobis(2,4-dimethylvaleronitrile), 2,2'-azobis(2-methylpropionamidine) dihydrochloride, 2,2'-azobis(2-methyl-N-phenylpropionamidine) dihydrochloride, 2,2'-azobis[N-(4-chlorophenyl)-2-methylpropionamidine]dihydride chloride, 2,2'-azobis[N-(4-hydrophenyl)-2-methylpropionamidine] dihydrochloride, 2,2'-azobis[2-methyl-N-(phenylmethyl)propionamidine] dihydrochloride, 2,2'-azobis[2-methyl-N-(2-propenyl)propionamidine] dihydrochloride, 2,2'-azobis[N-(2-hydroxyethyl)-2-methylpropionamidine] dihydrochloride, 2,2'-azobis[2-(5-methyl-2-imidazolin-2-yl)propane] dihydrochloride, 2,2'-azobis[2-(2-imidazolin-2-yl)propane] dihydrochloride, 2,2'-azobis[2-(4,5,6,7-tetrahydro-1H-1,3-diazepin-2-yl)propane] dihydrochloride, 2,2'-azobis[2-(3,4,5,6-tetrahydropyrimidin-2-yl)propane] dihydrochloride, 2,2'-azobis[2-(5-hydroxy-3,4,5,6-tetrahydropyrimidin-2-yl)propane] dihydrochloride, 2,2'-azobis[2-[1-(2-hydroxyethyl)-2-imidazolin-2-yl]propane] dihydrochloride, 2,2'-azobis[2-(2-imidazolin-2-yl)propane], 2,2'-azobis[2-methyl-N-[1,1-bis(hydroxymethyl)-2-hydroxyethyl]propionamide], 2,2'-azobis[2-methyl-N-[1,1-bis(hydroxymethyl)ethyl]propionamide], 2,2'-azobis[2-methyl-N-(2-hydroxyethyl)propionamide], 2,2'-azobis(2-methylpropionamide),

2,2'-azobis(2,4,4-trimethylpentane), 2,2'-azobis(2-methylpropane), dimethyl-2,2-azobis(2-methylpropionate), 4,4'-azobis(4-cyanopentanoic acid) and 2,2'-azobis[2-(hydroxymethyl)propionitrile].

The content of the radical polymerization initiator is preferably 0.05 to 50 parts by mass, more preferably 1.00 to 45 parts by mass, and further preferably 5.00 to 40 parts by mass based on 100 parts by mass of the solid content of the composition for film formation for lithography. When the content is 0.05 part by mass or more, the curability of the resin tends to be still much better, and when the content is 50 parts by mass or less, the long term storage stability of the composition at room temperature tends to be still much better.

<Curable Monomer, Photocurable Oligomer and Photocurable Polymer>

It is preferable that the composition for film formation for lithography of the present embodiment contain at least one selected from the group consisting of a photocurable monomer, a photocurable oligomer and a photocurable polymer from the viewpoint of achieving the effect of the present invention more effectively and reliably. Hereinafter, the photocurable monomer, the photocurable oligomer and the photocurable polymer are collectively referred to as a "photocurable compound".

The photocurable compound preferably has one or more radical polymerizable functional groups, and is preferably a (meth)acrylate compound. It is preferable that the content of the photocurable compound be 0.05 to 20 parts by mass based on 100 parts by mass of the solid content of the composition for film formation for lithography.

It is preferable that the composition for film formation for lithography of the present embodiment further contain a solvent from the viewpoint of achieving the effect of the present invention more effectively and reliably. Examples of the solvent include, but are not particularly limited to, ethylene glycol monoalkyl ether acetates such as ethylene glycol monomethyl ether acetate, ethylene glycol monoethyl ether acetate, ethylene glycol mono-n-propyl ether acetate and ethylene glycol mono-n-butyl ether acetate; ethylene glycol monoalkyl ethers such as ethylene glycol monomethyl ether and ethylene glycol monoethyl ether; propylene glycol monoalkyl ether acetates such as propylene glycol monomethyl ether acetate, propylene glycol monoethyl ether acetate (PGMEA), propylene glycol mono-n-propyl ether acetate and propylene glycol mono-n-butyl ether acetate; propylene glycol monoalkyl ethers such as propylene glycol monomethyl ether (PGME) and propylene glycol monoethyl ether; lactate esters such as methyl lactate, ethyl lactate, n-propyl lactate, n-butyl lactate and n-amyl lactate; aliphatic carboxylic acid esters such as methyl acetate, ethyl acetate, n-propyl acetate, n-butyl acetate, n-amyl acetate, n-hexyl acetate, methyl propionate and ethyl propionate; additional esters such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutylacetate, 3-methyl-3-methoxybutylacetate, butyl 3-methoxy-3-methylpropionate, butyl 3-methoxy-3-methylbutyrate, methyl acetoacetate, methyl pyruvate and ethyl pyruvate; aromatic hydrocarbons such as toluene and xylene; ketones such as methyl ethyl ketone, 2-heptanone, 3-heptanone, 4-heptanone, cyclopentanone and cyclohexanone (CHN); amides such as N,N-dimethylformamide, N-methylacetamide, N,N-dimethylacetamide and N-methylpyrrolidone; and lactones such as $\gamma$-lactone. These solvents can be used alone as one kind or may be used in combination of two or more kinds.

Among them, the solvent is preferably a safe solvent, and is more preferably at least one selected from the group consisting of PGMEA (propylene glycol monomethyl ether acetate), PGME (propylene glycol monomethyl ether), CHN (cyclohexanone), CPN (cyclopentanone), ortho-xylene (OX), 2-heptanone, anisole, butyl acetate, ethyl propionate and ethyl lactate.

In the present embodiment, the proportion between the amount of the solid component (solid content) and the amount of the solvent is not particularly limited, but is preferably 1 to 80% by mass of the solid component and 20 to 99% by mass of the solvent, more preferably 1 to 50% by mass of the solid component and 50 to 99% by mass of the solvent, further preferably 2 to 40% by mass of the solid component and 60 to 98% by mass of the solvent, and particularly preferably 2 to 10% by mass of the solid component and 90 to 98% by mass of the solvent, based on 100% by mass of the total mass of the solid component and the solvent.

[Acid Generating Agent (C)]

It is preferable that the composition for film formation for lithography of the present embodiment further contain an acid generating agent (C) from the viewpoint of achieving the effect of the present invention more effectively and reliably. Examples of the acid generating agent (C) are not particularly limited as long as it can directly or indirectly generate an acid by irradiation of radiation selected from the group consisting of visible light, ultraviolet, excimer laser, electron beam, extreme ultraviolet (EUV), X-ray and ion beam, but include bissulfonyldiazomethanes such as bis(p-toluenesulfonyl)diazomethane, bis(2,4-dimethylphenylsulfonyl)diazomethane, bis(tert-butylsulfonyl)diazomethane, bis(n-butylsulfonyl)diazomethane, bis(isobutylsulfonyl)diazomethane, bis(isopropylsulfonyl)diazomethane, bis(n-propylsulfonyl)diazomethane, bis(cyclohexylsulfonyl)diazomethane, bis(isopropylsulfonyl)diazomethane, 1,3-bis(cyclohexylsulfonylazomethylsulfonyl)propane, 1,4-bis(phenylsulfonylazomethylsulfonyl)butane, 1,6-bis(phenylsulfonylazomethylsulfonyl)hexane, and 1,10-bis(cyclohexylsulfonylazomethylsulfonyl)decane; and halogen-containing triazine derivatives such as 2-(4-methoxyphenyl)-4,6-(bistrichloromethyl)-1,3,5-triazine, 2-(4-methoxynaphthyl)-4,6-(bistrichloromethyl)-1,3,5-triazine, tris(2,3-dibromopropyl)-1,3,5-triazine, and tris(2,3-dibromopropyl)isocyanurate. These acid generating agents (C) can be used alone as one kind or may be used in combination of two or more kinds. Among these acid generating agents (C), an acid generating agent having an aromatic ring is preferable, and an acid generating agent having a compound represented by the following formula (8-1) or (8-2) is more preferable, from the viewpoint of heat resistance.

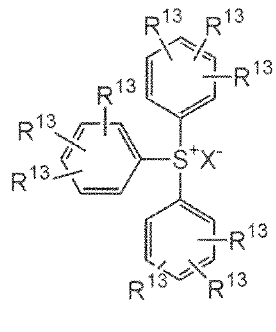

(8-1)

In the formula (8-1), $R^{13}$ may be the same or different, and each independently represents a hydrogen atom, a linear, branched or cyclic alkyl group, a linear, branched or cyclic alkoxy group, a hydroxyl group or a halogen atom; and $X^-$ represents a sulfonic acid ion or a halide ion having an alkyl group, an aryl group, a halogen-substituted alkyl group or a halogen-substituted aryl group.

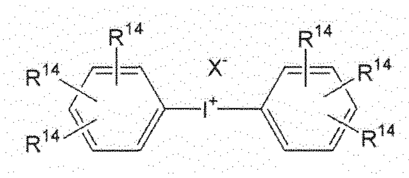

(8-2)

In the formula (8-2), $R^{14}$ may be the same or different, and each independently represents a hydrogen atom, a linear, branched or cyclic alkyl group, a linear, branched or cyclic alkoxy group, a hydroxyl group or a halogen atom; and $X^-$ is as defined above.

In the formula (8-1) or (8-2), the acid generating agent is further preferably a compound wherein $X^-$ is a sulfonic acid ion having an aryl group or a halogen-substituted aryl group; furthermore preferably a compound wherein $X^-$ is a sulfonic acid ion having an aryl group; and particularly preferably one selected from the group consisting of diphenyltrimethylphenylsulfonium p-toluenesulfonate, triphenylsulfonium p-toluenesulfonate, triphenylsulfonium trifluoromethanesulfonate, and triphenylsulfonium nonafluoromethanesulfonate. By using the above acid generating agent, there is a tendency that the LER (line edge roughness) can be still more reduced.

The content of the acid generating agent (C) is preferably 0.001 to 49% by mass, more preferably 1 to 40% by mass, further preferably 3 to 30% by mass, and particularly preferably 10 to 25% by mass, based on the entire solid content (100% by mass) of the composition for film formation for lithography. When the content is within the above range, there is a tendency that a pattern profile with still much higher sensitivity and low edge roughness is obtained. In the present embodiment, the acid generation method is not particularly limited as long as an acid is generated in the system. By using excimer laser instead of ultraviolet such as g-ray and i-ray, finer processing is possible, and also by using electron beam, extreme ultraviolet, X-ray or ion beam as a high energy ray, further finer processing is possible.

[Acid Crosslinking Agent (G)]

It is preferable that the composition for film formation for lithography of the present embodiment further contain an acid crosslinking agent (G) from the viewpoint of achieving the effect of the present invention more effectively and reliably. In the present specification, the acid crosslinking agent (G) refers to a compound that is capable of intramolecular or intermolecular crosslinking the component (A) in the presence of an acid generated from the acid generating agent (C). Examples of such an acid crosslinking agent (G) include a compound having a group that is capable of crosslinking the component (A) (hereinafter, also referred to as a "crosslinkable group").

Examples of such a crosslinkable group include (i) a hydroxyalkyl group such as a hydroxy (C1-C6 alkyl group), a C1-C6 alkoxy (C1-C6 alkyl group) and an acetoxy (C1-C6 alkyl group), or a group derived therefrom; (ii) a carbonyl

group such as a formyl group and a carboxy (C1-C6 alkyl group), or a group derived therefrom; (iii) a nitrogenous group-containing group such as a dimethylaminomethyl group, a diethylaminomethyl group, a dimethylolaminomethyl group, a diethylolaminomethyl group and a morpholinomethyl group; (iv) a glycidyl group-containing group such as a glycidyl ether group, a glycidyl ester group and a glycidylamino group; (v) a group derived from an aromatic group such as a C1-C6 allyloxy (C1-C6 alkyl group) and a C1-C6 aralkyloxy (C1-C6 alkyl group) such as a benzyloxymethyl group and a benzoyloxymethyl group; and (vi) a polymerizable multiple bond-containing group such as a vinyl group and an isopropenyl group. In the above, C1-C6 means that the number of carbon atoms is 1 to 6. Among them, as the crosslinkable group of the acid crosslinking agent (G), a hydroxyalkyl group and/or an alkoxyalkyl group are preferable, and an alkoxymethyl group is particularly preferable.

Examples of the acid crosslinking agent (G) having the above crosslinkable group include, but not particularly limited to, compounds described in paragraphs 0096 to 0123 of International Publication No. WO 2013/024778. These acid crosslinking agents (G) can be used alone as one kind or may be used in combination of two or more kinds.

The content of the acid crosslinking agent (G) is preferably 0.5 to 49% by mass, more preferably 0.5 to 40% by mass, further preferably 1 to 30% by mass, and particularly preferably 2 to 25% by mass, based on the entire solid content (100% by mass) of the composition for film formation for lithography. When the content is 0.5% by mass or more, there is a tendency that the inhibiting effect of the solubility of a film for lithography (for example, resist film) in an alkaline developing solution is still more improved, the film remaining rate is reduced, and occurrence of swelling and meandering of a pattern is still more inhibited. On the other hand, when the content is 49% by mass or less, there is a tendency that a decrease in heat resistance as a resist is still more inhibited.

It is preferable that the composition for film formation for lithography of the present embodiment further contain a crosslinking promoting agent from the viewpoint of still more accelerating crosslinking and curing reaction.

Examples of the crosslinking promoting agent include, but not particularly limited to, amines, imidazoles, organic phosphines and Lewis acids. These crosslinking promoting agents are used alone as one kind or used in combination of two or more kinds.

Specific examples of the crosslinking promoting agent include tertiary amines such as 1,8-diazabicyclo(5,4,0)undecene-7, triethylenediamine, benzyldimethylamine, triethanolamine, dimethylaminoethanol and tris(dimethylaminomethyl)phenol; imidazoles such as 2-methylimidazole, 2-phenylimidazole, 2-ethyl-4-methylimidazole, 2-phenyl-4-methylimidazole, 2-heptadecylimidazole and 2,4,5-triphenylimidazole; organic phosphines such as tributylphosphine, methyldiphenylphosphine, triphenylphosphine, diphenylphosphine and phenylphosphine; tetra substituted phosphonium-tetra substituted borates such as tetraphenylphosphonium-tetraphenyl borate, tetraphenylphosphonium-ethyltriphenyl borate and tetrabutylphosphonium-tetrabutyl borate; and tetraphenylboron salts such as 2-ethyl-4-methylimidazole-tetraphenyl borate and N-methylmorpholine-tetraphenyl borate.

The content of the crosslinking promoting agent is preferably 0.1 to 9% by mass and is more preferably 0.1 to 3% by mass based on the solid content (100% by mass) of the forming composition for lithography.

[Acid Diffusion Controlling Agent (E)]

It is preferable that the composition for film formation for lithography of the present embodiment further contain an acid diffusion controlling agent (E) having a function of controlling diffusion of an acid generated from the acid generating agent (C) by radiation irradiation in a film for lithography (for example, resist film) to inhibit any unpreferable chemical reaction in an unexposed region or the like. Accordingly, while the storage stability of the film composition for lithography is still more improved and the resolution is still more improved, the line width change of a resist pattern due to variation in the post exposure delay time before radiation irradiation and the post exposure delay time after radiation irradiation is still more inhibited, thereby making the composition extremely excellent in process stability. Such an acid diffusion controlling agent (E) is not particularly limited, and examples thereof include a radiation degradable basic compound such as a nitrogen atom-containing basic compound, a basic sulfonium compound and a basic iodonium compound.

Examples of the above acid diffusion controlling agent (E) include, but not particularly limited to, acid diffusion controlling agents described in paragraphs 0128 to 0141 of International Publication No. WO 2013/024778. These acid diffusion controlling agents (E) are used alone as one kind or used in combination of two or more kinds.

The content of the acid diffusion controlling agent (E) is preferably 0.001 to 49% by mass, more preferably 0.01 to 10% by mass, further preferably 0.01 to 5% by mass, and particularly preferably 0.01 to 3% by mass, based on the entire solid content (100% by mass) of the composition for lithography. When the content is 0.001% by mass or more, there is a tendency that a decrease in resolution, as well as deterioration of the pattern shape and the dimension, is still more inhibited. Moreover, even though the post exposure delay time from electron beam irradiation to heating after radiation irradiation becomes longer, there is a tendency that the shape of the pattern upper layer portion is still much less likely to deteriorate. When the content is 10% by mass or less, there is a tendency that a decrease in sensitivity, and developability of the unexposed portion or the like are still more inhibited. In addition, by using the above acid

diffusion controlling agent, while the storage stability of the resist composition is still more improved and the resolution is still more improved, the line width change of a resist pattern due to variation in the post exposure delay time before radiation irradiation and the post exposure delay time after radiation irradiation is still more inhibited, thereby making the composition extremely excellent in process stability.

[Additional Component (F)]

The composition for film formation for lithography of the present embodiment may contain an additional component (F) (also referred to as an "optional component (F)") other than the above. Examples of the additional component (F) include various additive agents such as a base generating agent, a dissolution promoting agent, a dissolution controlling agent, a sensitizing agent, a surfactant, and an organic carboxylic acid or oxo acid of phosphor or derivative thereof. These additional components (F) can be used alone as one kind or may be used in combination of two or more kinds.

[Base Generating Agent]

The composition for film formation for lithography of the present embodiment may contain a latent base generating agent for accelerating crosslinking and curing reaction, if required. Examples of the base generating agent include those generating a base by thermal decomposition (thermal base generating agents) and those generating a base by photoirradiation (photobase generating agents), but either of them can be used.
The thermal base generating agent includes, for example, at least one selected from an acidic compound (A1) that generates a base when it is heated to 40°C or higher and an ammonium salt (A2) having an anion and an ammonium cation with a pKa1 of 0 to 4.
The above acidic compound (A1) and the above ammonium salt (A2) are heated to generate a base, and thus can accelerate crosslinking and curing reaction due to the base generated from these compounds. In addition, unless these compounds are heated, cyclization of the composition for film formation for lithography hardly progresses, and therefore, a composition for film formation for lithography excellent in stability can be prepared.
The photobase generating agent is a neutral compound that produces a base by exposing the electromagnetic wave. Examples of those that generate an amine by exposing them to electromagnetic wave include benzyl carbamates, benzoyl carbamates, O-carbamoylhydroxyamines and O-carbamoyloximes, as well as RR'-N-CO-OR" (where R and R' are hydrogen or a lower alkyl group; and R" is a nitrobenzyl group or an $\alpha$-methyl-nitrobenzyl group). Particularly, from the viewpoint of ensuring storage stability upon adding the photobase generating agent to the solution and inhibiting volatilization upon baking due to low vapor pressure, preferable is a borate compound that generates a tertiary amine, a quaternary ammonium salt comprising a dithiocarbamate as an anion (see, C. E. Hoyle, et. al., Macromolecules, 32, 2793 (1999)) or the like.
Specific examples of the latent base generating agent include those described below; however, the present invention is not limited in any way by them.
Examples of the hexaammineruthenium(III) triphenylalkylborate include hexaammineruthenium(III) tris(triphenylmethylborate), hexaammineruthenium(III) tris(triphenylethylborate), hexaammineruthenium(III) tris(triphenylpropylborate), hexaammineruthenium(III) tris(triphenylbutylborate), hexaammineruthenium(III) tris(triphenylhexylborate), hexaammineruthenium(III) tris(triphenyloctylborate), hexaammineruthenium(III) tris(triphenyloctadecylborate), hexaammineruthenium(III) tris(triphenylisopropylborate), hexaammineruthenium(III) tris(triphenylisobutylborate), hexaammineruthenium(III) tris(triphenyl-sec-butylborate), hexaammineruthenium(III) tris(triphenyl-tert-butylborate) and hexaammineruthenium(III) tris(triphenylneopentylborate).
Examples of the hexaammineruthenium(III) triphenylborate include hexaammineruthenium(III) tris(triphenylcyclopentylborate), hexaammineruthenium(III) tris(triphenylcyclohexylborate), hexaammineruthenium(III) tris[triphenyl(4-decylcyclohexyl)borate], hexaammineruthenium(III) tris[triphenyl(fluoromethyl)borate], hexaammineruthenium(III) tris[triphenyl(chloromethyl)borate], hexaammineruthenium(III) tris[triphenyl(bromomethyl)borate], hexaammineruthenium(III) tris[triphenyl(trifluoromethyl)borate], hexaammineruthenium(III) tris[triphenyl(trichloromethyl)borate], hexaammineruthenium(III) tris[triphenyl(hydroxymethyl)borate], hexaammineruthenium(III) tris[triphenyl(carboxymethyl)borate], hexaammineruthenium(III) tris[triphenyl(cyanomethyl)borate], hexaammineruthenium(III) tris[triphenyl(nitromethyl)borate] and hexaammineruthenium(III) tris[triphenyl(azidomethyl)borate].
Examples of the hexaammineruthenium(III) triarylbutylborate include hexaammineruthenium(III) tris[tris(1-naphthyl)butylborate], hexaammineruthenium(III) tris[tris(2-naphthyl)butylborate], hexaammineruthenium(III) tris[tris(o-tolyl)butylborate], hexaammineruthenium(III) tris[tris(m-tolyl)butylborate], hexaammineruthenium(III) tris[tris(p-tolyl)butylborate], hexaammineruthenium(III) tris[tris(2,3-xylyl)butylborate] and hexaammineruthenium(III) tris[tris(2,5-xylyl)butylborate].
Examples of the ruthenium(III) tris(triphenylbutylborate) include tris(ethylenediamine) ruthenium(III) tris(triphenylbutylborate), cis-diamminebis (ethylenediamine)ruthenium(III) tris(triphenylbutylborate), trans-diamminebis (ethylenediamine)ruthenium(III) tris(triphenylbutylborate), tris(trimethylenediamine)ruthenium(III) tris(triphenylbutylborate), tris(propylenediamine)ruthenium(III) tris(triphenylbutylborate), tetraammine{(-)(propylenediamine)}ruthenium(III) tris(triphenylbutylborate), tris(trans-1,2-cyclohexanediamine)ruthenium(III) tris(triphenylbutylborate), bis(diethylenetriamine)ruthenium(III) tris(triphenylbutylborate), bis(pyridine)bis(ethylenediamine)ruthenium(III) tris(triphenylbutylborate) and bis(imidazole)bis(ethylenediamine)ruthenium(III) tris(triphenylbutylborate).

The base generating agent can be readily produced by, for example, mixing a halide salt, sulfate salt, nitrate salt, acetate salt or the like of each complex ion with an alkali metal borate salt in an appropriate solvent such as water, an alcohol or a water-containing organic solvent. These halide salt, sulfate salt, nitrate salt, acetate salt and the like of each complex ion, which are raw materials, are easily available as commercial products. Besides, the synthesis method therefor is described in, for example, New Experimental Chemistry Lecture Vol. 8 (Synthesis of Inorganic Compounds III), edited by The Chemical Society of Japan, Maruzen Co., Ltd., 1977, and the like.

The content of the latent base generating agent is preferably 0.001 to 25% by mass and is more preferably 0.01 to 10% by mass based on the entire solid content (100% by mass) of the composition for film formation for lithography. When the content of the latent base generating agent is 0.001% by mass or more, there is a tendency that curing of the composition for film formation for lithography can be prevented from being insufficient. When the content is 25% by mass or less, there is a tendency that the long term storage stability of the composition for film formation for lithography at room temperature can be prevented from being impaired.

[Dissolution Promoting Agent]

A dissolution promoting agent is, for example, a component having a function of increasing the solubility of the component (A) in a developing solution more to moderately increase the dissolution rate of the component (A) upon developing. Examples of the above dissolution promoting agent can include low molecular weight phenolic compounds, and preferably are bisphenols and tris(hydroxyphenyl)methane. These dissolution promoting agents are used alone as one kind or used in combination of two or more kinds.

The content of the dissolution promoting agent may be arbitrarily set depending on the kind of the component (A), and is preferably 0 to 49% by mass, more preferably 0 to 5% by mass, and further preferably 0 to 1% by mass, based on the entire solid content (100% by mass) of the composition for film formation for lithography.

[Dissolution Controlling Agent]

A dissolution controlling agent is, for example, a component having a function of controlling the solubility of the component (A) in a developing solution still more to moderately decrease the dissolution rate of the component (A) upon developing. As the above dissolution controlling agent, for example, those that do not chemically change in steps such as calcination of resist coating, radiation irradiation and development are preferable.

Examples of the dissolution controlling agent are not particularly limited, but can include aromatic hydrocarbons such as phenanthrene, anthracene and acenaphthene; ketones such as acetophenone, benzophenone and phenyl naphthyl ketone; and sulfones such as methyl phenyl sulfone, diphenyl sulfone and dinaphthyl sulfone. These dissolution controlling agents are used alone as one kind or used in combination of two or more kinds.

The content of the dissolution controlling agent may be arbitrarily set depending on the kind of the component (A), and is preferably 0 to 49% by mass, more preferably 0 to 5% by mass, and further preferably 0 to 1% by mass, based on the entire solid content (100% by mass) of the composition for film formation for lithography.

[Sensitizing Agent]

The sensitizing agent is, for example, a component having a function of absorbing irradiated radiation energy, transmitting the energy to the acid generating agent (C), and thereby increasing the acid production amount, and improving the apparent sensitivity of a resist more. Examples of such a sensitizing agent include, but not particularly limited to, benzophenones, biacetyls, pyrenes, phenothiazines and fluorenes. These sensitizing agents are used alone as one kind or used in combination of two or more kinds.

The content of the sensitizing agent may be arbitrarily set depending on the kind of the component (A), and is preferably 0 to 49% by mass, more preferably 0 to 5% by mass, and further preferably 0 to 1% by mass, based on the entire solid content (100% by mass) of the composition for film formation for lithography.

[Surfactant]

A surfactant is, for example, a component having a function of improving coatability and striation of the composition for film formation for lithography (for example, resist composition), and developability of a resist or the like. Such a surfactant may be any of anionic, cationic, nonionic and amphoteric surfactants. These surfactants are used alone as one kind or used in combination of two or more kinds. A preferable surfactant is a nonionic surfactant. The nonionic surfactant has a good affinity with a solvent used in production of resist compositions, and the effects mentioned above tend to be more remarkable. Examples of the nonionic surfactant include, but not particularly limited to, polyoxyethylene higher alkyl ethers, polyoxyethylene higher alkyl phenyl ethers, and higher fatty acid diesters of polyethylene glycol. Examples of commercially available products of the nonionic surfactant include EFTOP (a product manufactured by Jemco Inc.), MEGAFAC (a product manufactured by DIC Corporation), Fluorad (a product manufactured by Sumitomo 3M Limited), AsahiGuard and Surflon (hereinbefore, products manufactured by Asahi Glass Co., Ltd.), Pepole (a product manufactured by Toho Chemical Industry Co., Ltd.), KP (manufactured by Shin-Etsu Chemical Co., Ltd.), and Polyflow (a product manufactured by Kyoeisha Chemical Co., Ltd.).

The content of the surfactant may be arbitrarily set depending on the kind of the component (A), and is preferably 0 to 49% by mass, more preferably 0 to 5% by mass, and further preferably 0 to 1% by mass, based on the entire solid content (100% by mass) of the composition for film formation for lithography.

[Organic Carboxylic Acid or Oxo Acid of Phosphor or Derivative Thereof]

For the purpose of still more inhibiting sensitivity deterioration or still more improving a resist pattern shape, post exposure delay stability and the like, the composition for film formation for lithography (for example, composition for resist film formation) of the present embodiment can contain an organic carboxylic acid or oxo acid of phosphor or derivative thereof (hereinafter, they are also simply referred to as an "organic carboxylic acid or the like", collectively). The organic carboxylic acid or the like may be used in combination with the acid diffusion controlling agent, or may be used alone. Examples of the organic carboxylic acid include, but not particularly limited to, malonic acid, citric acid, malic acid, succinic acid, benzoic acid and salicylic acid. Examples of the oxo acid of phosphor or a derivative thereof include, but not particularly limited to, phosphoric acid or a derivative thereof such as ester including phosphoric acid, di-n-butyl ester phosphate, and diphenyl ester phosphate; phosphonic acid or a derivative thereof such as ester including phosphonic acid, dimethyl ester phosphonate, di-n-butyl ester phosphonate, phenylphosphonic acid, diphenyl ester phosphonate, and dibenzyl ester phosphonate; and phosphinic acid and a derivative thereof such as ester including phosphinic acid and phenylphosphinic acid. Among them, phosphonic acid is preferable.

These organic carboxylic acids or the like are used alone as one kind or used in combination of two or more kinds. The content of the organic carboxylic acid or the like may be arbitrarily set depending on the kind of the component (A), and is preferably 0 to 49% by mass, more preferably 0 to 5% by mass, and further preferably 0 to 1% by mass, based on the entire solid content (100% by mass) of the composition for film formation for lithography.

The composition for film formation for lithography of the present embodiment may contain one or more selected from the group consisting of, for example, a dye, a pigment and an adhesion aid as an additive agent other than the above dissolution promoting agent, dissolution controlling agent, sensitizing agent, surfactant, and organic carboxylic acid or the like, if required. For example, when the composition for film formation for lithography of the present embodiment contains a dye or a pigment, a latent image of the exposed portion is visualized and influence of halation upon exposure can be alleviated, which is preferable. Also, when the composition for film formation for lithography of the present embodiment contains an adhesion aid, adhesiveness to a substrate can be improved more, which is preferable. Furthermore, examples of the additional additive agent include a halation preventing agent, a storage stabilizing agent, a defoaming agent, and a shape improving agent. Specific examples thereof include 4-hydroxy-4'-methylchalkone.

In the composition for film formation for lithography of the present embodiment, the content of the optional component (F) is, for example, 0 to 99% by mass, preferably 0 to 49% by mass, more preferably 0 to 10% by mass, further preferably 0 to 5% by mass, furthermore preferably 0 to 1% by mass, and particularly preferably 0% by mass, based on the entire solid content (100% by mass) of the composition for film formation for lithography of the present embodiment.

[Content Ratio of Each Component in Composition for Film Formation for Lithography]

In the composition for film formation for lithography of the present embodiment, the content of the component (A) of the present embodiment is, but not particularly limited to, preferably 50 to 99.4% by mass, more preferably 55 to 90% by mass, further preferably 60 to 80% by mass, and particularly preferably 60 to 70% by mass, based on the entire solid content (100% by mass) of the composition for film formation for lithography of the present embodiment. When the content of the component (A) is within the above range, there is a tendency that the resolution is still more improved and the line edge roughness (LER) is still more decreased.

In the composition for film formation for lithography (for example, composition for resist film formation) of the present embodiment, the content ratio of the component (A), the acid generating agent (C), the acid crosslinking agent

(G), the acid diffusion controlling agent (E), and the optional component (F) (the component (A)/the acid generating agent (C)/the acid crosslinking agent (G)/the acid diffusion controlling agent (E)/the optional component (F)) is preferably 50 to 99.4% by mass/0.001 to 49% by mass/0.5 to 49% by mass/0.001 to 49% by mass/0 to 49% by mass, more preferably 55 to 90% by mass/1 to 40% by mass/0.5 to 40% by mass/0.01 to 10% by mass/0 to 5% by mass, further preferably 60 to 80% by mass/3 to 30% by mass/1 to 30% by mass/0.01 to 5% by mass/0 to 1% by mass, and particularly preferably 60 to 70% by mass/10 to 25% by mass/2 to 20% by mass/0.01 to 3% by mass/0% by mass, based on the total (100% by mass) of the component (A), the acid generating agent (C), the acid crosslinking agent (G), the acid diffusion controlling agent (E), and the optional component (F) in the composition for film formation for lithography. When the content ratio of each component is within the above range, performances such as sensitivity, resolution and developability tend to be still more excellent.

Examples of the method for producing the composition for film formation for lithography of the present embodiment include a method in which each of the above components is dissolved in a solvent into a homogenous solution, and the resultant solution is then filtered through a filter or the like with a pore diameter of approximately 0.2 μm, if required, to prepare the composition.

The composition for film formation for lithography of the present embodiment may contain an additional resin, if required. Examples of the additional resin include, but not particularly limited to, one or more selected from the group consisting of a novolac resin, a polyvinyl phenol, a polyacrylic acid, a polyvinyl alcohol, a styrene-maleic anhydride resin, and a polymer comprising acrylic acid, vinyl alcohol or vinylphenol as a monomeric unit, and derivatives thereof. The content of the additional resin is not particularly limited and may be arbitrarily set depending on, for example, the kind of the component (A). It is preferably 30 parts by mass or less, more preferably 10 parts by mass or less, further preferably 5 parts by mass or less, and particularly preferably 0 part by mass, based on 100 parts by mass of the component (A).

[Physical Properties and the Like of Composition for Film Formation for Lithography]

The composition for film formation for lithography of the present embodiment can form an amorphous film by, for example, spin coating, and can be applied to a general semiconductor process. In addition, the composition for film formation for lithography of the present embodiment can individually prepare any of positive type and negative type resist patterns depending on the kind of a developing solution to be used.

In the case of a positive type resist pattern, the dissolution rate of the amorphous film formed by spin coating with the composition for film formation for lithography of the present embodiment in a developing solution at 23°C is preferably 5 angstrom/sec or less, more preferably 0.05 to 5 angstrom/sec, and further preferably 0.0005 to 5 angstrom/sec. When the dissolution rate is 5 angstrom/sec or less, the amorphous film is insoluble or poorly soluble in a developing solution, and as a result, a resist pattern is easily formed. In addition, when the amorphous film has a dissolution rate of 0.0005 angstrom/sec or more, the resolution tends to be still more improved. It is presumed that this is because, due to the change in the solubility before and after exposure of the component (A), contrast at the interface between the exposed portion being dissolved in a developing solution and the unexposed portion not being dissolved in a developing solution is increased, but the present invention is not limited in any way by this presumption. In addition, when the dissolution rate is 0.0005 angstrom/sec or more, there is a tendency that effects of reducing LER and defects are obtained.

In the case of a negative type resist pattern, the dissolution rate of the amorphous film formed by spin coating with the composition for film formation for lithography of the present embodiment in a developing solution at 23°C is preferably 10 angstrom/sec or more. When the dissolution rate is 10 angstrom/sec or more, the amorphous film is still more easily soluble in a developing solution, and therefore, it is still more suited for formation of a resist pattern. Also, when the dissolution rate is 10 angstrom/sec or more, the resolution may be improved. It is presumed that this is because the micro surface portion of the component (A) dissolves and LER is reduced, but the present invention is not limited in any way by this presumption. In addition, when the dissolution rate is 10 angstrom/sec or more, there is a tendency that effects of reducing defects are obtained.

The dissolution rate can be determined by immersing the amorphous film in a developing solution for a predetermined period of time at 23°C and then measuring the film thickness before and after immersion by a publicly known method such as visual, ellipsometric, or QCM method.

In the case of a positive type resist pattern, the dissolution rate of the portion exposed by radiation such as KrF excimer laser, extreme ultraviolet, electron beam or X-ray, of the amorphous film formed by spin coating with the composition for film formation for lithography of the present embodiment, in a developing solution at 23°C is preferably 10 angstrom/sec or more. When the dissolution rate is 10 angstrom/sec or more, the amorphous film is easily soluble in a developing solution, and as a result, it is still more suited for formation of a resist pattern. Also, when the dissolution rate is 10 angstrom/sec or more, the resolution may be improved. It is presumed that this is because the micro surface portion of the component (A) dissolves and LER is reduced, but the present invention is not limited in any way by this presumption. In addition, when the dissolution rate is 10 angstrom/sec or more, there is a tendency that effects of reducing defects

are obtained.

In the case of a negative type resist pattern, the dissolution rate of the portion exposed by radiation such as KrF excimer laser, extreme ultraviolet, electron beam or X-ray, of the amorphous film formed by spin coating with the composition for film formation for lithography of the present embodiment, in a developing solution at 23°C is preferably 5 angstrom/sec or less, more preferably 0.05 to 5 angstrom/sec, and further preferably 0.0005 to 5 angstrom/sec. When the dissolution rate is 5 angstrom/sec or less, the amorphous film is insoluble or poorly soluble in a developing solution, and as a result, a resist pattern is easily formed. In addition, when the amorphous film has a dissolution rate of 0.0005 angstrom/sec or more, the resolution tends to be still more improved. It is presumed that this is because, due to the change in the solubility before and after exposure of the component (A), contrast at the interface between the unexposed portion being dissolved in a developing solution and the exposed portion not being dissolved in a developing solution is increased, but the present invention is not limited in any way by this presumption. In addition, when the dissolution rate is 0.0005 angstrom/sec or more, there is a tendency that effects of reducing LER and defects are obtained.

[Radiation-Sensitive Composition]

A radiation-sensitive composition of the present embodiment is a radiation-sensitive composition containing (the component (A)), an optically active diazonaphthoquinone compound (B) and a solvent, and the content of the solvent is 20 to 99% by mass based on 100% by mass in total of the radiation-sensitive composition.

The component (A) is used in combination with the optically active diazonaphthoquinone compound (B) mentioned later and is useful as a base material for positive type resists that becomes a compound easily soluble in a developing solution by irradiation with g-ray, h-ray, i-ray, KrF excimer laser, ArF excimer laser, extreme ultraviolet, electron beam, or X-ray. Although the properties of the component (A) are not largely altered by irradiation of g-ray, h-ray, i-ray, KrF excimer laser, ArF excimer laser, extreme ultraviolet, electron beam, or X-ray, the optically active diazonaphthoquinone compound (B) poorly soluble in a developing solution is converted to an easily soluble compound, and a resist pattern can therefore be formed in a development step.

Since the component (A) is a relatively low molecular weight compound, the roughness of the resist pattern to be obtained can be made very small. In addition, the component (A) is preferably a compound represented by the formula (2), wherein at least one of $R_1$ to $R_3$ comprises a group containing an iodine atom. Accordingly, in the radiation-sensitive composition of the present embodiment, the ability to absorb radiation such as electron beam, extreme ultraviolet (EUV), or X-ray is still more increased, and as a result, this tends to enable the enhancement of the sensitivity.

The glass transition temperature of the component (A) is preferably 100°C or more, more preferably 120°C or more, further preferably 140°C or more, and particularly preferably 150°C or more. The upper limit value of the glass transition temperature of the component (A) is not particularly limited and is, for example, 400°C. When the glass transition temperature of the component (A) falls within the above range, there is a tendency that the heat resistance, which allows maintenance of the pattern shape, is still more improved in a semiconductor lithography process, and performances such as high resolution are still more improved.

The heat of crystallization determined by the differential scanning calorimetry of the component (A) is preferably less than 20 J/g. In addition, the difference between the crystallization temperature and the glass transition temperature ((crystallization temperature) - (glass transition temperature)) is preferably 70°C or more, more preferably 80°C or more, further preferably 100°C or more, and particularly preferably 130°C or more. When the heat of crystallization is less than 20 J/g or the temperature difference falls within the above range, there is a tendency that an amorphous film is easily formed upon spin coating the radiation-sensitive composition, the film formability necessary for formation of a resist pattern is retained over a long period of time, and the resolution is still more improved.

In the present embodiment, the heat of crystallization, crystallization temperature, and glass transition temperature are determined by differential scanning calorimetry using a product "DSC/TA-50WS" manufactured by Shimadzu Corp. Specifically, for example, about 10 mg of a sample is placed in an unsealed container made of aluminum, and the temperature is raised to the melting point or more at a temperature increase rate of 20°C/min in a nitrogen gas stream (50 mL/min). After quenching, again the temperature is raised to the melting point or more at a temperature increase rate of 20°C/min in a nitrogen gas stream (30 mL/min). After further quenching, again the temperature is raised to 400°C at a temperature increase rate of 20°C/min in a nitrogen gas stream (30 mL/min). The temperature at the middle point (where the specific heat is changed into the half) of steps in the baseline shifted in a step-like pattern is defined as the glass transition temperature (Tg). The temperature of the subsequently appearing exothermic peak is defined as the crystallization temperature. The heat is determined from the area of a region surrounded by the exothermic peak and the baseline and defined as the heat of crystallization.

The component (A) is preferably low sublimable at 100°C or lower, preferably 120°C or lower, more preferably 130°C or lower, further preferably 140°C or lower, and particularly preferably 150°C or lower at normal pressure. The low sublimability means that, in thermogravimetry, weight reduction upon keeping the component (A) at a predetermined temperature for 10 minutes is 10% or less, preferably 5% or less, more preferably 3% or less, further preferably 1% or

less, and particularly preferably 0.1% or less. The low sublimability can prevent an exposure apparatus from being contaminated by outgassing upon exposure. In addition, due to low sublimability, a good pattern shape with low roughness can be obtained.

The component (A) to be contained in the radiation-sensitive composition of the present embodiment dissolves at preferably 1% by mass or more, more preferably 5% by mass or more, and further preferably 10% by mass or more at 23°C in a solvent that is selected from, for example, propylene glycol monomethyl ether acetate (PGMEA), propylene glycol monomethyl ether (PGME), cyclohexanone (CHN), cyclopentanone (CPN), 2-heptanone, anisole, butyl acetate, ethyl propionate and ethyl lactate, and exhibits the highest ability to dissolve the component (A). Particularly preferably, the component (A) dissolves at 20% by mass or more at 23°C in a solvent that is selected from the group consisting of PGMEA, PGME and CHN and exhibits the highest ability to dissolve the resist base material. Particularly preferably, the component (A) dissolves at 20% by mass or more at 23°C in PGMEA. When the above conditions are met, the radiation-sensitive composition is still more easily used in a semiconductor production process at a full production scale.

[Optically Active Diazonaphthoquinone Compound (B)]

The optically active diazonaphthoquinone compound (B) to be contained in the radiation-sensitive composition of the present embodiment is a diazonaphthoquinone substance including a polymer or non-polymer optically active diazonaphthoquinone compound. The optically active diazonaphthoquinone compound (B) is not particularly limited as long as it is generally used as a photosensitive component (sensitizing agent) in positive type resist compositions. One kind or two or more kinds can be optionally selected and used.

As such a sensitizing agent, there is no particular limitation, but it is preferably a compound obtained by reacting naphthoquinonediazide sulfonic acid chloride, benzoquinonediazide sulfonic acid chloride, or the like with a low molecular weight compound or a high molecular weight compound having a functional group condensable with these acid chlorides. Herein, examples of the functional group condensable with the acid chlorides include, but not particularly limited to, a hydroxy group and an amino group. Particularly, a hydroxy group is preferable. Examples of the compound containing a hydroxy group condensable with the acid chlorides include, but not particularly limited to, hydroquinone, resorcin, hydroxybenzophenones such as 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone and 2,2',3,4,6'-pentahydroxybenzophenone, hydroxyphenylalkanes such as bis(2,4-dihydroxyphenyl)methane, bis(2,3,4-trihydroxyphenyl)methane and bis(2,4-dihydroxyphenyl)propane, and hydroxytriphenylmethanes such as 4,4',3",4"-tetrahydroxy-3,5,3',5'-tetramethyltriphenylmethane and 4,4',2",3",4"-pentahydroxy-3,5,3',5'-tetramethyltriphenylmethane.

In addition, preferable examples of the acid chloride such as naphthoquinonediazide sulfonic acid chloride or benzoquinonediazide sulfonic acid chloride include 1,2-naphthoquinonediazide-5-sulfonyl chloride and 1,2-naphthoquinonediazide-4-sulfonyl chloride.

The radiation-sensitive composition of the present embodiment may be prepared by, for example, dissolving each component in a solvent upon use into a homogeneous solution, and then if required, filtering through a filter or the like with a pore diameter of approximately 0.2 μm, for example.

[Solvent]

Examples of the solvent that can be used in the radiation-sensitive composition of the present embodiment are not particularly limited to, but include propylene glycol monomethyl ether acetate, propylene glycol monomethyl ether, cyclohexanone, cyclopentanone, 2-heptanone, anisole, butyl acetate, ethyl propionate and ethyl lactate. These solvents are used alone as one kind or used in combination of two or more kinds. Among them, one or more selected from the group consisting of propylene glycol monomethyl ether acetate, propylene glycol monomethyl ether and cyclohexanone is preferable.

The content of the solvent is 20 to 99% by mass, preferably 50 to 99% by mass, more preferably 60 to 98% by mass, and particularly preferably 90 to 98% by mass, based on 100% by mass in total of the radiation-sensitive composition. Also, the content of components except for the solvent (solid components) is 1 to 80% by mass, preferably 1 to 50% by mass, more preferably 2 to 40% by mass, and particularly preferably 2 to 10% by mass, based on 100% by mass in total of the radiation-sensitive composition.

[Properties of Radiation-Sensitive Composition]

The radiation-sensitive composition of the present embodiment can form an amorphous film by, for example, spin coating, and can be applied to a general semiconductor process. In addition, the radiation-sensitive composition of the present embodiment can individually prepare any of positive type and negative type resist patterns depending on

the kind of a developing solution to be used.

In the case of a positive type resist pattern, the dissolution rate of the amorphous film formed by spin coating with the radiation-sensitive composition of the present embodiment in a developing solution at 23°C is preferably 5 angstrom/sec or less, more preferably 0.05 to 5 angstrom/sec, and further preferably 0.0005 to 5 angstrom/sec. When the dissolution rate is 5 angstrom/sec or less, the amorphous film is insoluble or poorly soluble in a developing solution, and as a result, a resist pattern is easily formed. In addition, when the amorphous film has a dissolution rate of 0.0005 angstrom/sec or more, the resolution tends to be still more improved. It is presumed that this is because, due to the change in the solubility before and after exposure of the component (A), contrast at the interface between the exposed portion being dissolved in a developing solution and the unexposed portion not being dissolved in a developing solution is increased, but the present invention is not limited in any way by this presumption. Also, there is a tendency that effects of reducing LER and defects are obtained.

In the case of a negative type resist pattern, the dissolution rate of the amorphous film formed by spin coating with the radiation-sensitive composition of the present embodiment in a developing solution at 23°C is preferably 10 angstrom/sec or more. When the dissolution rate is 10 angstrom/sec or more, the amorphous film is still more easily soluble in a developing solution, and therefore, it is still more suited for formation of a resist pattern. Also, when the dissolution rate is 10 angstrom/sec or more, the resolution may be improved. It is presumed that this is because the micro surface portion of the component (A) dissolves and LER is reduced, but the present invention is not limited in any way by this presumption. In addition, when the dissolution rate is 10 angstrom/sec or more, there is a tendency that effects of reducing defects are obtained.

The above dissolution rate can be determined by immersing the amorphous film in a developing solution for a predetermined period of time at 23°C and then measuring the film thickness before and after immersion by a publicly known method such as visual, ellipsometric, or QCM method.

In the case of a positive type resist pattern, the dissolution rate of the exposed portion after irradiation with radiation such as KrF excimer laser, extreme ultraviolet, electron beam or X-ray, or after heating at 20 to 500°C, of the amorphous film formed by spin coating with the radiation-sensitive composition of the present embodiment, in a developing solution at 23°C is preferably 10 angstrom/sec or more, more preferably 10 to 10000 angstrom/sec, and further preferably 100 to 1000 angstrom/sec. When the dissolution rate is 10 angstrom/sec or more, the amorphous film is easily soluble in a developing solution, and as a result, it is still more suited for formation of a resist pattern. When the dissolution rate is 10000 angstrom/sec or less, the resolution may be improved. It is presumed that this is because the micro surface portion of the component (A) dissolves and LER is reduced, but the present invention is not limited in any way by this presumption. In addition, when the dissolution rate is 10 angstrom/sec or more, there is a tendency that effects of reducing defects are obtained.

In the case of a negative type resist pattern, the dissolution rate of the exposed portion after irradiation with radiation such as KrF excimer laser, extreme ultraviolet, electron beam or X-ray, or after heating at 20 to 500°C, of the amorphous film formed by spin coating with the radiation-sensitive composition of the present embodiment, in a developing solution at 23°C is preferably 5 angstrom/sec or less, more preferably 0.05 to 5 angstrom/sec, and further preferably 0.0005 to 5 angstrom/sec. When the dissolution rate is 5 angstrom/sec or less, the amorphous film is insoluble or poorly soluble in a developing solution, and as a result, a resist pattern is easily formed. In addition, when the amorphous film has a dissolution rate of 0.0005 angstrom/sec or more, the resolution may be still more improved. It is presumed that this is because, due to the change in the solubility before and after exposure of the component (A), contrast at the interface between the unexposed portion being dissolved in a developing solution and the exposed portion not being dissolved in a developing solution is increased, but the present invention is not limited in any way by this presumption. In addition, when the dissolution rate is 0.0005 angstrom/sec or more, there is a tendency that effects of reducing LER and defects are obtained.

[Content Ratio of Each Component in Radiation-Sensitive Composition]

In the radiation-sensitive composition of the present embodiment, the content of the component (A) is preferably 1 to 99% by mass, more preferably 5 to 95% by mass, further preferably 10 to 90% by mass, and particularly preferably 25 to 75% by mass, based on the entire mass of the solid components (the summation of the component (A), the optically active diazonaphthoquinone compound (B) and optionally used solid components such as the additional component (D), hereinafter the same). When the content of the component (A) falls within the above range, there is a tendency that the radiation-sensitive composition of the present embodiment can produce a pattern with still much higher sensitivity and lower roughness.

In the radiation-sensitive composition of the present embodiment, the content of the optically active diazonaphthoquinone compound (B) is preferably 1 to 99% by mass, more preferably 5 to 95% by mass, further preferably 10 to 90% by mass, and particularly preferably 25 to 75% by mass, based on the entire mass of the solid components. When the content of the optically active diazonaphthoquinone compound (B) falls within the above range, there is a tendency

that the radiation-sensitive composition of the present embodiment can produce a pattern with high sensitivity and low roughness.

[Additional Optional Component (D)]

In the radiation-sensitive composition of the present embodiment, if required, one kind or two or more kinds of various additive agents such as the acid generating agent, acid crosslinking agent, acid diffusion controlling agent, dissolution promoting agent, dissolution controlling agent, sensitizing agent, surfactant, and organic carboxylic acid or oxo acid of phosphor or derivative thereof mentioned above can be added as a component other than the component (A) and the optically active diazonaphthoquinone compound (B). In the present specification, the additional component (D) may be referred to as an "optional component (D)".

The content ratio of the component (A), the optically active diazonaphthoquinone compound (B) and the additional optional component (D) that may be optionally contained in the radiation-sensitive composition ((A)/(B)/(D)) is preferably 1 to 99% by mass/99 to 1% by mass/0 to 98% by mass, more preferably 5 to 95% by mass/95 to 5% by mass/0 to 49% by mass, further preferably 10 to 90% by mass/90 to 10% by mass/0 to 10% by mass, furthermore preferably 20 to 80% by mass/80 to 20% by mass/0 to 5% by mass, and particularly preferably 25 to 75% by mass/75 to 25% by mass/0% by mass, based on 100% by mass of the solid components of the radiation-sensitive composition.

The content ratio of each component is selected from each range so that the summation thereof is 100% by mass. When the content ratio of each component falls within the above range, the radiation-sensitive composition of the present embodiment tends to be still more excellent in performances of roughness, sensitivity and resolution.

The radiation-sensitive composition of the present embodiment can comprise an additional resin, if required. Examples of such a resin include, but not particularly limited to, a novolac resin, a polyvinyl phenol, a polyacrylic acid, a polyvinyl alcohol, a styrene-maleic anhydride resin, and a polymer comprising acrylic acid, vinyl alcohol or vinylphenol as a monomeric unit, and derivatives thereof. The content of these resins, which is arbitrarily adjusted according to the kind of the component (A) to be used, is preferably 30 parts by mass or less, more preferably 10 parts by mass or less, further preferably 5 parts by mass or less, and particularly preferably 0 part by mass, based on 100 parts by mass of the component (A).

[Method for Producing Amorphous Film]

The method for producing an amorphous film according to the present embodiment comprises the step of forming an amorphous film on a substrate using the above radiation-sensitive composition.

[Resist Pattern Formation Method Using Radiation-Sensitive Composition]

A resist pattern formation method using the radiation-sensitive composition of the present embodiment includes the steps of: forming a resist film on a substrate using the above radiation-sensitive composition; exposing at least a portion of the formed resist film; and developing the exposed resist film, thereby forming a resist pattern. Specifically, the same operation as in the following resist pattern formation method using the resist composition can be performed.

[Resist Pattern Formation Method Using Composition for Film Formation for Lithography]

A resist pattern formation method using the composition for film formation for lithography of the present embodiment (the first resist pattern formation method) includes the steps of: forming a resist film on a substrate using the composition for film formation for lithography of the present embodiment; exposing at least a portion of the resist film; and developing the exposed resist film, thereby forming a resist pattern. The resist pattern according to the present embodiment can also be formed as an upper layer resist pattern in a multilayer process.

Examples of the resist pattern formation method include, but not particularly limited to, the following methods. A resist film is formed by coating a conventionally publicly known substrate with the above resist composition of the present embodiment using a coating means such as spin coating, flow casting coating, and roll coating. Examples of the conventionally publicly known substrate include, but not particularly limited to, a substrate for electronic components, and the one having a predetermined wiring pattern formed thereon, or the like. More specific examples include a substrate made of a metal such as a silicon wafer, copper, chromium, iron and aluminum, and a glass substrate. Examples of a wiring pattern material include copper, aluminum, nickel, and gold. Also, if required, the substrate may be a substrate having an inorganic and/or organic film provided thereon. Examples of the inorganic film include an inorganic antireflection film (inorganic BARC). Examples of the organic film include an organic antireflection film (organic BARC). The substrate may be subjected to surface treatment with hexamethylene disilazane or the like.

Next, the substrate coated with the composition for film formation for lithography is heated if required. The

heating conditions vary according to the compounding composition of the resist composition, or the like, but are preferably 20 to 250°C, and more preferably 20 to 150°C. By heating, the adhesiveness of a resist to a substrate may be improved, which is preferable. Then, the resist film is exposed to a desired pattern by any radiation selected from the group consisting of visible light, ultraviolet, excimer laser, electron beam, extreme ultraviolet (EUV), X-ray, and ion beam. The exposure conditions or the like are arbitrarily selected according to the compounding composition of the resist composition, or the like. In the present embodiment, in order to stably form a fine pattern with a high degree of accuracy in exposure, the resist film is preferably heated after radiation irradiation.

Next, by developing the exposed resist film in a developing solution, a predetermined resist pattern is formed. As the above developing solution, a solvent having a solubility parameter (SP value) close to that of the component (A) to be used is preferably selected. A polar solvent such as a ketone-based solvent, an ester-based solvent, an alcohol-based solvent, an amide-based solvent, and an ether-based solvent; and a hydrocarbon-based solvent, or an alkaline aqueous solution can be used. Specifically, for example, reference can be made to International Publication No. WO 2013/024778.

Depending on the kind of the developing solution, a positive type resist pattern or a negative type resist pattern can be individually prepared. In general, in the case of a polar solvent such as a ketone-based solvent, an ester-based solvent, an alcohol-based solvent, an amide-based solvent, and an ether-based solvent, or a hydrocarbon-based solvent, a negative type resist pattern is formed, and in the case of an alkaline aqueous solution, a positive type resist pattern is formed.

A plurality of above solvents may be mixed, or the solvent may be used by mixing the solvent with a solvent other than those described above or water within the range having performance. In order to sufficiently exhibit the effect of the present invention, the water content ratio as the whole developing solution is, for example, less than 70% by mass, preferably less than 50% by mass, more preferably less than 30% by mass, and further preferably less than 10% by mass. Particularly preferably, the developing solution is substantially moisture free. That is, the content of the organic solvent in the developing solution is, for example, preferably 30% by mass or more and 100% by mass or less, preferably 50% by mass or more and 100% by mass or less, more preferably 70% by mass or more and 100% by mass or less, further preferably 90% by mass or more and 100% by mass or less, and particularly preferably 95% by mass or more and 100% by mass or less, based on the entire amount of the developing solution.

Particularly, the developing solution is preferably a developing solution containing at least one kind of solvent selected from the group consisting of a ketone-based solvent, an ester-based solvent, an alcohol-based solvent, an amide-based solvent, and an ether-based solvent. Accordingly, there is a tendency that resist performances, such as the resolution and roughness of a resist pattern, are still more improved, which is preferable.

The vapor pressure of the developing solution at 20°C is preferably 5 kPa or less, more preferably 3 kPa or less, and further preferably 2 kPa or less. When the vapor pressure of the developing solution is 5 kPa or less, there is a tendency that the evaporation of the developing solution on the substrate or in a developing cup is inhibited, the temperature uniformity within a wafer surface is improved, and as a result, the size uniformity within the wafer surface is made better.

Specific examples of the developing solution having a vapor pressure of 5 kPa or less include developing solutions described in International Publication No. WO 2013/024778.

Specific examples of the developing solution having a vapor pressure of 2 kPa or less, which is a particularly preferable range, include developing solutions described in International Publication No. WO 2013/024778.

To the developing solution, a surfactant can be added in an appropriate amount, if required. The surfactant is not particularly limited but, for example, an ionic or nonionic fluorine-based and/or silicon-based surfactant can be used. Examples of the fluorine-based and/or silicon-based surfactant include the surfactants described in Japanese Patent Application Laid-Open Nos. 62-36663, 61-226746, 61-226745, 62-170950, 63-34540, 7-230165, 8-62834, 9-54432, and 9-5988, and U.S. Pat. Nos. 5405720, 5360692, 5529881, 5296330, 5436098, 5576143, 5294511, and 5824451. The surfactant is preferably a nonionic surfactant. The nonionic surfactant is not particularly limited, but a fluorine-based surfactant or a silicon-based surfactant is further preferable.

The amount of the surfactant to be used is usually 0.001 to 5% by mass, preferably 0.005 to 2% by mass, and further preferably 0.01 to 0.5% by mass, based on the entire amount of the developing solution.

For the development method, for example, a method for dipping a substrate in a bath filled with a developing solution for a fixed time (dipping method), a method for raising a developing solution on a substrate surface by the effect of a surface tension and keeping it still for a fixed time, thereby conducting the development (puddle method), a method for spraying a developing solution on a substrate surface (spraying method), and a method for continuously ejecting a developing solution on a substrate rotating at a constant speed while scanning a developing solution ejecting nozzle at a constant rate (dynamic dispense method), or the like may be applied. The time for conducting the pattern development is not particularly limited, but is preferably 10 seconds to 90 seconds.

After the step of conducting development, a step of stopping the development by the replacement with another solvent may be practiced.

A step of rinsing the resist film with a rinsing solution containing an organic solvent is preferably provided after the development.

The rinsing solution to be used in the rinsing step after development is not particularly limited as long as the rinsing solution does not dissolve the resist pattern cured by crosslinking. A solution containing a general organic solvent or water may be used as the rinsing solution. As the rinsing solution, a rinsing solution containing at least one kind of organic solvent selected from the group consisting of a hydrocarbon-based solvent, a ketone-based solvent, an ester-based solvent, an alcohol-based solvent, an amide-based solvent, and an ether-based solvent is preferably used. More preferably, after development, a step of rinsing the film by using a rinsing solution containing at least one kind of organic solvent selected from the group consisting of a ketone-based solvent, an ester-based solvent, an alcohol-based solvent and an amide-based solvent is conducted. Still more preferably, after development, a step of rinsing the film by using a rinsing solution containing an alcohol-based solvent or an ester-based solvent is conducted. Still more preferably, after development, a step of rinsing the film by using a rinsing solution containing a monohydric alcohol is conducted. Particularly preferably, after development, a step of rinsing the film by using a rinsing solution containing a monohydric alcohol having 5 or more carbon atoms is conducted. The time for rinsing the pattern is not particularly limited, but is preferably 10 seconds to 90 seconds.

Herein, examples of the monohydric alcohol to be used in the rinsing step after development are not particularly limited, and specific examples include monohydric alcohols described in International Publication No. WO 2013/024778.

A plurality of these components may be mixed, or the component may be used by mixing the component with an organic solvent other than those described above.

The water content ratio in the rinsing solution is preferably 10% by mass or less, more preferably 5% by mass or less, and further preferably 3% by mass or less. When the water content ratio is 10% by mass or less, there is a tendency that better development characteristics can be obtained.

The vapor pressure at 20°C of the rinsing solution to be used after development is preferably 0.05 kPa or more and 5 kPa or less, more preferably 0.1 kPa or more and 5 kPa or less, and further preferably 0.12 kPa or more and 3 kPa or less. When the vapor pressure of the rinsing solution is 0.05 kPa or more and 5 kPa or less, there is a tendency that the temperature uniformity in the wafer surface is enhanced more, and furthermore, swelling due to permeation of the rinsing solution is inhibited more. As a result, the dimensional uniformity in the wafer surface tends to be made much better.

The rinsing solution may also be used after adding an appropriate amount of a surfactant to the rinsing solution.

In the rinsing step, the wafer after conducting development is subjected to rinsing treatment using the above organic solvent-containing rinsing solution. The method for rinsing treatment is not particularly limited. However, for example, a method for continuously ejecting a rinsing solution on a substrate spinning at a constant speed (spin coating method), a method for dipping a substrate in a bath filled with a rinsing solution for a fixed time (dipping method), a method for spraying a rinsing solution on a substrate surface (spraying method), or the like can be applied. Above all, it is preferable to conduct the rinsing treatment by the spin coating method and after the rinsing, spin the substrate at a rotational speed of 2,000 rpm to 4,000 rpm, to remove the rinsing solution from the substrate surface.

After forming the resist pattern, a pattern wiring substrate is obtained by etching. Etching can be conducted by a publicly known method such as dry etching using plasma gas, and wet etching with an alkaline solution, a cupric chloride solution, a ferric chloride solution, or the like.

After forming the resist pattern, plating can also be conducted. Examples of the above plating method include copper plating, solder plating, nickel plating, and gold plating.

The remaining resist pattern after etching can be peeled by an organic solvent. Examples of the above organic solvent include PGMEA (propylene glycol monomethyl ether acetate), PGME (propylene glycol monomethyl ether), and EL (ethyl lactate). Examples of the above peeling method include a dipping method and a spraying method. A wiring substrate having a resist pattern formed thereon may be a multilayer wiring substrate, and may have a small diameter through hole.

In the present embodiment, the wiring substrate can also be formed by a method for forming a resist pattern, then depositing a metal in vacuum, and subsequently dissolving the resist pattern in a solution, i.e., a liftoff method.

[Composition for Underlayer Film Formation for Lithography]

The composition for film formation for lithography of the present embodiment may be a composition for underlayer film formation. The content of the component (A) contained in the composition for underlayer film formation for lithography of the present embodiment is preferably 1 to 100% by mass, more preferably 10 to 100% by mass, further preferably 50 to 100% by mass, and particularly preferably 100% by mass, from the viewpoint of coatability and quality stability.

The composition for underlayer film formation for lithography of the present embodiment is applicable to a wet process and is excellent in heat resistance and etching resistance. Furthermore, the composition for underlayer film

formation for lithography of the present embodiment employs the above substances and can therefore form an underlayer film that is prevented from deteriorating during high temperature baking and is also excellent in etching resistance against oxygen plasma etching or the like. Moreover, the composition for underlayer film formation for lithography of the present embodiment is also excellent in adhesiveness to a resist layer and can therefore produce an excellent resist pattern. The composition for underlayer film formation for lithography of the present embodiment may contain an already known composition for underlayer film formation for lithography or the like, within the range not deteriorating the effect of the present invention.

[Solvent]

A solvent to be used in the composition for underlayer film formation for lithography of the present embodiment may be any solvent as long as it can dissolve the component (A).

The solvent is not particularly limited, but specific examples thereof include the solvents exemplified in the section of the composition for film formation for lithography of the present embodiment. These solvents are used alone as one kind or used in combination of two or more kinds. Among these solvents, one or more selected from the group consisting of cyclohexanone, propylene glycol monomethyl ether, propylene glycol monomethyl ether acetate, ethyl lactate, methyl hydroxyisobutyrate, and anisole are particularly preferable from the viewpoint of safety.

The content of the solvent is not particularly limited, and from the viewpoint of solubility and film formation, it is preferably 100 to 10,000 parts by mass, more preferably 200 to 5,000 parts by mass, and further preferably 200 to 1,000 parts by mass, based on 100 parts by mass of the above composition for underlayer film formation.

[Crosslinking Agent]

The composition for underlayer film formation for lithography of the present embodiment may contain a crosslinking agent, if required, from the viewpoint of, for example, suppressing intermixing. The crosslinking agent that can be used for the present embodiment is not particularly limited, but examples thereof include the crosslinking agents exemplified in the section of the composition for film formation for lithography of the present embodiment. These crosslinking agents are used alone as one kind or used in combination of two or more kinds.

In the composition for underlayer film formation for lithography of the present embodiment, the content of the crosslinking agent is not particularly limited, and is preferably 5 to 50 parts by mass and more preferably 10 to 40 parts by mass, based on 100 parts by mass of the composition for underlayer film formation. When the content of the crosslinking agent is within the above range, occurrence of a mixing event with a resist layer tends to be inhibited. Also, an antireflection effect is enhanced, and film formability after crosslinking tends to be enhanced.

[Acid Generating Agent]

The composition for underlayer film formation for lithography of the present embodiment may contain an acid generating agent, if required, from the viewpoint of, for example, further accelerating crosslinking reaction by heat. An acid generating agent that generates an acid by thermal decomposition, an acid generating agent that generates an acid by light irradiation, and the like are known, any of which can be used.

The acid generating agent is not particularly limited, but examples thereof include the acid generating agents exemplified in the section of the composition for film formation for lithography of the present embodiment. Those described in International Publication No. WO 2013/024779 can be used. These acid generating agents are used alone as one kind or used in combination of two or more kinds.

In the composition for underlayer film formation for lithography of the present embodiment, the content of the acid generating agent is not particularly limited, and is preferably 0.1 to 50 parts by mass and more preferably 0.5 to 40 parts by mass, based on 100 parts by mass of the composition for underlayer film formation. When the content of the acid generating agent is within the above range, crosslinking reaction tends to be enhanced by an increased amount of an acid generated. Also, occurrence of a mixing event with a resist layer tends to be inhibited.

[Basic Compound]

The composition for underlayer film formation for lithography of the present embodiment may further contain a basic compound from the viewpoint of, for example, improving storage stability.

The basic compound plays a role as a quencher against acids in order to prevent crosslinking reaction from proceeding due to a trace amount of an acid generated by the acid generating agent. Examples of such a basic compound include, but not particularly limited to, primary, secondary or tertiary aliphatic amines, amine blends, aromatic amines, heterocyclic amines, nitrogen-containing compounds having a carboxy group, nitrogen-containing compounds having

a sulfonyl group, nitrogen-containing compounds having a hydroxy group, nitrogen-containing compounds having a hydroxyphenyl group, alcoholic nitrogen-containing compounds, amide derivatives, and imide derivatives.

The basic compound to be used in the present embodiment is not particularly limited, but examples thereof include the basic compounds exemplified in the section of the composition for film formation for lithography of the present embodiment. These basic compounds are used alone as one kind or used in combination of two or more kinds.

In the composition for underlayer film formation for lithography of the present embodiment, the content of the basic compound is not particularly limited, and is preferably 0.001 to 2 parts by mass and more preferably 0.01 to 1 part by mass, based on 100 parts by mass of the composition for underlayer film formation. When the content is within the above range, storage stability tends to be enhanced without excessively deteriorating crosslinking reaction.

[Additional Additive Agent]

The composition for underlayer film formation for lithography of the present embodiment may also contain an additional resin and/or compound for the purpose of conferring thermosetting properties or controlling absorbance. Examples of such an additional resin and/or compound include, but not particularly limited to, naphthol resin, xylene resin naphthol-modified resin, phenol-modified resin of naphthalene resin, polyhydroxystyrene, dicyclopentadiene resin, resins containing (meth)acrylate, dimethacrylate, trimethacrylate, tetramethacrylate, a naphthalene ring such as vinylnaphthalene or polyacenaphthylene, a biphenyl ring such as phenanthrenequinone or fluorene, or a heterocyclic ring having a heteroatom such as thiophene or indene, and resins containing no aromatic ring; and resins or compounds containing an alicyclic structure, such as rosin-based resin, cyclodextrin, adamantine(poly)ol, tricyclodecane(poly)ol, and derivatives thereof. The composition for underlayer film formation for lithography of the present embodiment may further contain a publicly known additive agent. Examples of the above publicly known additive agent include, but not limited to, ultraviolet absorbers, surfactants, colorants, and nonionic surfactants.

[Underlayer Film for Lithography Formation Method]

A method for forming an underlayer film for lithography of the present embodiment includes the step of forming an underlayer film on a substrate using the composition for underlayer film formation for lithography of the present embodiment.

[Resist Pattern Formation Method Using Composition for Underlayer Film Formation for Lithography]

A resist pattern formation method using the composition for underlayer film formation for lithography of the present embodiment comprises the steps of: forming an underlayer film on a substrate using the composition for underlayer film formation for lithography of the present embodiment (step (A-1)); forming at least one photoresist layer on the underlayer film (step (A-2)); and irradiating a predetermined region of the photoresist layer with radiation for development, thereby forming a resist pattern (step (A-3)).

[Circuit Pattern Formation Method]

A circuit pattern formation method of the present embodiment comprises the steps of: forming an underlayer film on a substrate using the composition for film formation for lithography of the present embodiment (step (B-1)); forming an intermediate layer film on the underlayer film using a resist intermediate layer film material containing a silicon atom (step (B-2)); forming at least one photoresist layer on the intermediate layer film (step (B-3)); irradiating a predetermined region of the photoresist layer with radiation for development, thereby forming a resist pattern (step (B-4)); etching the intermediate layer film with the resist pattern as a mask, thereby forming an intermediate layer film pattern (step (B-5)); etching the underlayer film with the intermediate layer film pattern as an etching mask, thereby forming an underlayer film pattern (step (B-6)); and etching the substrate with the underlayer film pattern as an etching mask, thereby forming a pattern on the substrate (step (B-7)).

[Film for Lithography]

A film for lithography of the present embodiment is formed by using the composition for film formation for lithography of the present embodiment. The film for lithography may be an underlayer film or may be a resist permanent film, which will be mentioned later.

The underlayer film for lithography of the present embodiment is not particularly limited by its formation method as long as it is formed from the composition for underlayer film formation for lithography of the present embodiment. A publicly known approach can be applied thereto. The underlayer film can be formed by, for example, applying the

composition for underlayer film formation for lithography of the present embodiment onto a substrate by a publicly known coating method or printing method such as spin coating or screen printing, and then removing an organic solvent by volatilization or the like.

It is preferable to perform baking in the formation of the underlayer film, for inhibiting occurrence of a mixing event with an upper layer resist while accelerating crosslinking reaction. In this case, the baking temperature is not particularly limited and is preferably in the range of 80 to 450°C, and more preferably 200 to 400°C. The baking time is not particularly limited and is preferably 10 to 300 seconds. The thickness of the underlayer film can be arbitrarily selected according to required performance and is not particularly limited, but is preferably approximately 30 to 20,000 nm, and more preferably 50 to 15,000 nm.

After preparing the underlayer film, it is preferable to prepare a silicon-containing resist layer or a usual single-layer resist made of hydrocarbon thereon in the case of a two-layer process, and to prepare a silicon-containing intermediate layer thereon and further a silicon-free single-layer resist layer thereon in the case of a three-layer process. In this case, for a photoresist material for forming this resist layer, a publicly known material can be used.

After preparing the underlayer film on the substrate, a silicon-containing resist layer or a usual single-layer resist made of hydrocarbon can be prepared on the underlayer film in the case of a two-layer process. In the case of a three-layer process, a silicon-containing intermediate layer can be prepared on the underlayer film, and a silicon-free single-layer resist layer can be further prepared on the silicon-containing intermediate layer. In these cases, a publicly known photoresist material can be arbitrarily selected and used for forming the resist layer, without particular limitations.

For the silicon-containing resist material for a two-layer process, a silicon atom-containing polymer such as a polysilsesquioxane derivative or a vinylsilane derivative is used as a base polymer, and a positive type photoresist material further containing an organic solvent, an acid generating agent, and if required, a basic compound or the like is preferably used, from the viewpoint of oxygen gas etching resistance. Herein, a publicly known polymer that is used in this kind of resist material can be used as the silicon atom-containing polymer.

A polysilsesquioxane-based intermediate layer is preferably used as the silicon-containing intermediate layer for a three-layer process. By imparting effects as an antireflection film to the intermediate layer, there is a tendency that reflection can be effectively suppressed. For example, use of a material containing a large amount of an aromatic group and having high substrate etching resistance as the underlayer film in a process for exposure at 193 nm tends to increase a k value and enhance substrate reflection. However, the intermediate layer suppresses the reflection so that the substrate reflection can be 0.5% or less. The intermediate layer having such an antireflection effect is not limited, and for example, polysilsesquioxane that crosslinks by an acid or heat in which a light absorbing group having a phenyl group or a silicon-silicon bond is introduced is preferably used for exposure at 193 nm.

Alternatively, an intermediate layer formed by chemical vapor deposition (CVD) may be used. The intermediate layer highly effective as an antireflection film prepared by CVD is not limited, and, for example, a SiON film is known. In general, the formation of an intermediate layer by a wet process such as spin coating or screen printing is more convenient and more advantageous in cost, as compared with CVD. The upper layer resist for a three-layer process may be either positive type or negative type, and the same as a single-layer resist generally used can be used.

The underlayer film according to the present embodiment can also be used as an antireflection film for usual single-layer resists or an underlying material for suppression of pattern collapse. The underlayer film of the present embodiment is excellent in etching resistance for an underlying process and can be expected to also function as a hard mask for an underlying process.

In the case of forming a resist layer from the above photoresist material, a wet process such as spin coating or screen printing is preferably used, as in the case of forming the above underlayer film. After coating with the resist material by spin coating or the like, prebaking is generally performed. This prebaking is preferably performed at 80 to 180°C in the range of 10 to 300 seconds. Then, exposure, post-exposure baking (PEB), and development can be performed according to a conventional method to obtain a resist pattern. The thickness of the resist film is not particularly limited and is preferably 30 to 500 nm, and more preferably 50 to 400 nm.

The exposure light can be arbitrarily selected and used according to the photoresist material to be used. General examples thereof can include a high energy ray having a wavelength of 300 nm or less, specifically, excimer laser of 248 nm, 193 nm, or 157 nm, soft X-ray of 3 to 20 nm, electron beam, and X-ray.

In a resist pattern formed by the above method, pattern collapse is suppressed by the underlayer film according to the present embodiment. Therefore, use of the underlayer film according to the present embodiment can produce a finer pattern and can reduce an exposure amount necessary for obtaining the resist pattern.

Next, etching is performed with the obtained resist pattern as a mask. Gas etching is preferably used as the etching of the underlayer film in a two-layer process. The gas etching is preferably etching using oxygen gas. In addition to oxygen gas, an inert gas such as He or Ar, or CO, $CO_2$, $NH_3$, $SO_2$, $N_2$, $NO_2$, or $H_2$ gas may be added. Alternatively, the gas etching may be performed with CO, $CO_2$, $NH_3$, $N_2$, $NO_2$, or $H_2$ gas without the use of oxygen gas Particularly, the latter gas is preferably used for side wall protection in order to prevent the undercut of pattern side walls.

On the other hand, gas etching is also preferably used as the etching of the intermediate layer in a three-layer

process. The same gas etching as described in the above two-layer process is applicable. Particularly, it is preferable to process the intermediate layer in a three-layer process by using chlorofluorocarbon-based gas and using the resist pattern as a mask. Then, as mentioned above, the underlayer film can be processed by, for example, oxygen gas etching with the intermediate layer pattern as a mask.

Herein, in the case of forming an inorganic hard mask intermediate layer film as the intermediate layer, a silicon oxide film, a silicon nitride film, or a silicon oxynitride film (SiON film) is formed by CVD, ALD, or the like. A method for forming the nitride film is not limited, and for example, a method described in Japanese Patent Application Laid-Open No. 2002-334869 (Patent Literature 6) or WO 2004/066377 (Patent Literature 7) can be used. Although a photoresist film can be formed directly on such an intermediate layer film, an organic antireflection film (BARC) may be formed on the intermediate layer film by spin coating and a photoresist film may be formed thereon.

A polysilsesquioxane-based intermediate layer is preferably used as the intermediate layer. By imparting effects as an antireflection film to the resist intermediate layer film, there is a tendency that reflection can be effectively suppressed. A specific material for the polysilsesquioxane-based intermediate layer is not limited, and, for example, a material described in Japanese Patent Application Laid-Open No. 2007-226170 (Patent Literature 8) or Japanese Patent Application Laid-Open No. 2007-226204 (Patent Literature 9) can be used.

Also, for the subsequent etching of the substrate, a publicly known method can be used. For example, the substrate made of $SiO_2$ or SiN can be etched mainly using chlorofluorocarbon-based gas, and the substrate made of p-Si, Al or W can be etched mainly using chlorine- or bromine-based gas. In the case of etching the substrate with chlorofluorocarbon-based gas, the silicon-containing resist of the two-layer resist process or the silicon-containing intermediate layer of the three-layer process is peeled at the same time with substrate processing. On the other hand, in the case of etching the substrate with chlorine- or bromine-based gas, the silicon-containing resist layer or the silicon-containing intermediate layer is separately peeled and in general, peeled by dry etching using chlorofluorocarbon-based gas after substrate processing.

The underlayer film according to the present embodiment has a characteristic of having excellent etching resistance of the substrates. The substrate can be arbitrarily selected from publicly known ones and used, and is not particularly limited. Examples thereof include Si, $\alpha$-Si, p-Si, $SiO_2$, SiN, SiON, W, TiN, and Al. The substrate may be a laminate having a film to be processed (substrate to be processed) on a base material (support). Examples of such a film to be processed include various low-k films such as Si, $SiO_2$, SiON, SiN, p-Si, $\alpha$-Si, W, W-Si, Al, Cu, and Al-Si, and stopper films thereof. A material different from that for the base material (support) is generally used. The thickness of the substrate to be processed or the film to be processed is not particularly limited, and normally, it is preferably approximately 50 to 1,000,000 nm and more preferably 75 to 500,000 nm.

[Resist Permanent Film]

Also, a resist permanent film can be prepared by using the above composition for film formation for lithography. The resist permanent film prepared by coating with the above composition for film formation for lithography is suitable as a permanent film that also remains in a final product, if required, after formation of a resist pattern. Specific examples of the permanent film include, in relation to semiconductor devices, solder resists, package materials, underfill materials, package adhesive resin layers for circuit elements and the like, and adhesive resin layers between integrated circuit elements and circuit substrates, and in relation to thin displays, thin film transistor protecting films, liquid crystal color filter protecting films, black matrixes, and spacers. Particularly, the permanent film made of the composition for film formation for lithography is excellent in heat resistance and humidity resistance and furthermore, also has the excellent advantage that contamination by sublimable components is reduced. Particularly, for a display material, a material that achieves all of high sensitivity, high heat resistance, and hygroscopic reliability with reduced deterioration in image quality due to significant contamination can be obtained.

In the case of using, for resist permanent film purposes, the above composition for film formation for lithography, a curing agent as well as, if required, various additive agents such as an additional resin, a surfactant, a dye, a filler, a crosslinking agent, and a dissolution promoting agent can be added and dissolved in an organic solvent to prepare a composition for resist permanent films.

The above composition for film formation for lithography or composition for resist permanent films can be prepared by adding each of the above components and mixing them using a stirrer or the like. When the above composition for resist underlayer films or composition for resist permanent films contains a filler or a pigment, it can be prepared by dispersion or mixing using a dispersion apparatus such as a dissolver, a homogenizer, and a three-roll mill.

Example 1

Hereinafter, the present invention will be described further specifically with reference to Examples, but the present invention is not limited to these Examples.

<Synthesis Example 1> Synthesis of Acrylic Modified Xylene Formaldehyde Resin

To a container (internal capacity: 1000 mL) equipped with a stirrer, a condenser tube, and a burette, 200 g of toluene (a product manufactured by Tokyo Kasei Kogyo Co. Ltd.), 30 g of an ethylene glycol-modified xylene resin (a product "K0140E" manufactured by Fudow Company Limited), 10 g of acrylic acid (a product manufactured by Tokyo Kasei Kogyo Co., Ltd.), 0.5 g of p-toluenesulfonic acid (a product manufactured by Tokyo Kasei Kogyo Co., Ltd.), and 0.1 g of a polymerization inhibitor (hydroquinone, a product manufactured by Wako Pure Chemical Industries, Ltd.) were placed, and the contents were refluxed at 100°C while being stirred at normal pressure, and water was removed from the reaction system. The reaction time was set to be 6 hours. After the reaction terminates, 180 g of toluene (a product manufactured by Wako Pure Chemical Industries, Ltd.) was added to the reaction solution, which was left to stand still. Then, the reaction solution was washed and neutralized with a 20% aqueous sodium hydroxide solution, the catalyst (p-toluenesulfonic acid) and the polymerization inhibitor were removed, and the solvent (toluene) was distilled off under reduced pressure to obtain 24.7 g of an acrylic modified xylene formaldehyde resin "K-140EA" as a solid. K-140EA contains a resin represented by the following (K-140EA) as a main component.

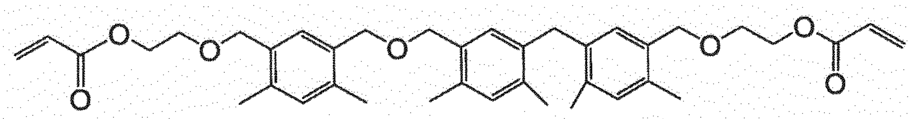

(K-140EA)

<Synthesis Example 2>

A four necked flask (internal capacity: 10 L) equipped with a Dimroth condenser tube, a thermometer, and a stirring blade and having a detachable bottom was prepared. To this four necked flask, 1.09 kg of 1,5-dimethylnaphthalene (7 mol, a product manufactured by Mitsubishi Gas Chemical Co., Inc.), 2.1 kg of a 40% by mass aqueous formalin solution (28 mol as formaldehyde, a product manufactured by Mitsubishi Gas Chemical Co., Inc.), and 0.97 mL of a 98% by mass sulfuric acid (a product manufactured by Kanto Chemical Co., Inc.) were fed in the current of nitrogen, and the mixture was reacted for 7 hours while being refluxed at 100°C at normal pressure. Subsequently, 1.8 kg of ethylbenzene (manufactured by Wako Pure Chemical Industries, Ltd., a special grade reagent) was added as a diluting solvent to the reaction solution, and the mixture was left to stand still, followed by removal of an aqueous phase as a lower phase. Neutralization and washing with water were further performed, and ethylbenzene and unreacted 1,5-dimethylnaphthalene were distilled off under reduced pressure to obtain 1.25 kg of a dimethylnaphthalene formaldehyde resin as a light brown solid. The number average molecular weight (Mn), weight average molecular weight (Mw), and dispersity (Mw/Mn) of the obtained dimethylnaphthalene formaldehyde resin were 562, 1168, and 2.08, respectively.

The above number average molecular weight (Mn), weight average molecular weight (Mw), and dispersity (Mw/Mn) were measured by gel permeation chromatography (GPC) analysis with the apparatus and under the conditions shown below. Hereinafter, the same also applies.

Apparatus: Shodex GPC-101 model (a product manufactured by SHOWA DENKO K.K.)
Column: KF-80M x 3
Eluent: THF 1 ml/min
Temperature: 40°C
Standard substance: polystyrene

Then, a four necked flask (internal capacity: 0.5 L) equipped with a Dimroth condenser tube, a thermometer, and a stirring blade was prepared. To this four necked flask, 100 g (0.51 mol) of the dimethylnaphthalene formaldehyde resin obtained as mentioned above, and 0.05 g of p-toluenesulfonic acid were added in a nitrogen stream, and the temperature was raised to 190°C at which the mixture was then heated for 2 hours, followed by stirring. Subsequently, 52.0 g (0.36 mol) of 1-naphthol was further added thereto, the temperature was further elevated to 220°C, and the mixture was reacted for 2 hours. After dilution with a solvent, neutralization and washing with water were performed, and the solvent was removed under reduced pressure to obtain 126.1 g of a phenol-modified dimethylnaphthalene formaldehyde resin (CR-1) as a black-brown solid. The Mn, Mw, and Mw/Mn of the obtained resin (CR-1) were 885, 2220, and 4.17, respectively.

[Evaluation of Solubility (Examples 1 to 5)]

To a 50 ml screw bottle, the aromatic hydrocarbon formaldehyde resin for each Example or the like and propylene

glycol monomethyl ether acetate (PGMEA) were added, and the resultant mixture was stirred at 23°C for 1 hour using a magnetic stirrer. Then, the amount of the aromatic hydrocarbon formaldehyde resin for each Example or the like dissolved in PGMEA was measured, and the solubility was evaluated according to the following criteria. From a practical viewpoint, evaluation A is preferable. When the evaluation is A, the sample has high storage stability in the solution state, and can be satisfyingly applied to an edge bead remover widely used for a fine processing process of semiconductors.

<Evaluation Criteria>

A: The amount of dissolution was 10% by mass or more.
B: The amount of dissolution was less than 10% by mass.

[Example 1]

The solubility of a xylene formaldehyde resin (a product "NIKANOL G 6N04" manufactured by Fudow Company Limited, containing a resin represented by the following (G 6N04) as a main component) in PGMEA was evaluated. The evaluation result was A.

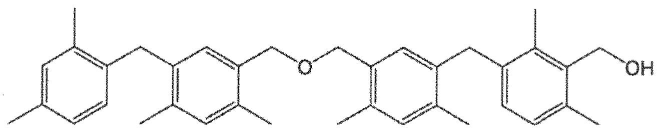

(G 6N04)

[Example 2]

The solubility of a phenol-modified xylene formaldehyde resin (a product "GP-100 6M22" manufactured by Fudow Company Limited, containing a resin represented by the following (GP-100 6M22) as a main component) in PGMEA was evaluated. The evaluation result was A.

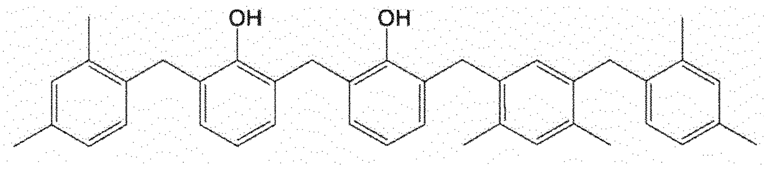

(GP-100 6M22)

[Example 3]

The solubility of an ethylene glycol-modified xylene formaldehyde resin (a product "K-140E" manufactured by Fudow Company Limited, containing a resin represented by the following (K-140E) as a main component) in PGMEA was evaluated. The evaluation result was A.

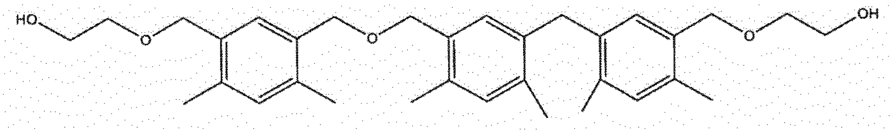

(K-140E)

[Example 4]

The solubility of the acrylic modified xylene formaldehyde resin obtained in Synthesis Example 1 in PGMEA was evaluated. The evaluation result was A.

[Example 5]

The solubility of an epoxy-modified xylene formaldehyde resin (a product "YL7770" manufactured by Mitsubishi Chemical Corporation, containing a resin represented by the following (YL7770) as a main component) in PGMEA was evaluated. The evaluation result was A.

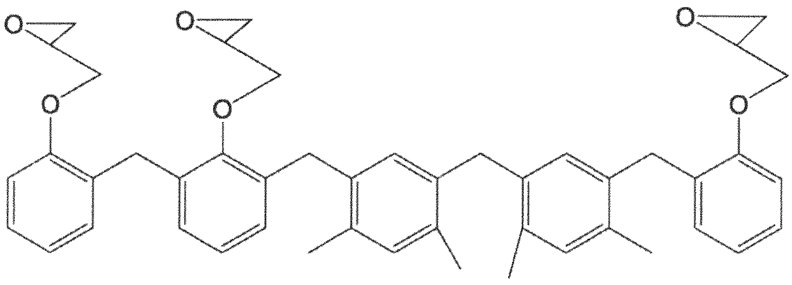

(YL7770)

[Method for Evaluating Curability through UV Irradiation (Examples 6 to 15 and Comparative Examples 1 to 2)]

A clean silicon wafer was spin coated with the composition for film formation for lithography for each of Examples 6 to 15 and Comparative Examples 1 to 2, prepared according to the composition shown in Table 1 (in the table, the "content" is shown in % by mass), and baked in an oven of 240°C for 60 seconds to form a baked film. The baked film was irradiated with UV having a wavelength of 360 nm using an UV irradiation apparatus (BJB267: high pressure mercury lamp, a product manufactured by GS Yuasa Corporation) to obtain an UV cured film. The film thickness of the UV cured film was measured using an ellipsometer (a product manufactured by Five Lab Co., Ltd., laser wavelength of 632.8 nm), and the UV cured film was then immersed in either solvent (propylene glycol monomethyl ether (PGME) or propylene glycol monomethyl ether acetate (PGMEA)) at room temperature for 60 seconds. Subsequently, the film was blown by air and further heated at 100°C for 60 seconds, thereby removing the solvent. Thereafter, the thickness of the UV cured film was measured again by the ellipsometer, and the film remaining rate after the solvent immersion was calculated according to the following formula:

Film remaining rate (%) = UV cured film thickness after solvent immersion/UV cured film thickness before solvent immersion x 100.

From the calculated film remaining rate, the UV curability was evaluated according to the following criteria. The evaluation results are shown in Table 1. From a practical viewpoint of the UV curability, for application to the fine processing process of semiconductors, evaluation S is most preferable, and next evaluation A, and then evaluation B are preferable, and evaluation C means that the composition is applicable to the UV curing process.

<Evaluation Criteria>

S: The film remaining rate was 90% or more.
A: The film remaining rate was 80% or more and less than 90%.
B: The film remaining rate was 50% or more and less than 80%.
C: The film remaining rate was 20% or more and less than 50%.
D: The film remaining rate was less than 20%.

[Table 1]

| | Composition for film formation for lithography | | | | | | Measurement conditions and results | | | |
|---|---|---|---|---|---|---|---|---|---|---|
| | Resin | | Solvent | | Photopolymerization initiator | | Film remaining rate | UV dose | Immersion solvent | Evaluation of UV curability |
| | Type | Content | Type | Content | Type | Content | (%) | (mJ/cm$^2$) | | |
| Example 6 | Product "YL7770" (epoxy-modified xylene formaldehyde resin) | 10 | MEK | 90 | - | - | 94.8 | 1500 | PGME | S |
| Example 7 | Product "YL7770" (epoxy-modified xylene formaldehyde resin) | 10 | MEK | 90 | - | - | 98.4 | 1500 | PGMEA | S |
| Example 8 | "K-140EA" of Synthesis Example 1 (acrylic modified xylene formaldehyde resin) | 10 | MEK | 90 | - | - | 86.9 | 600 | PGME | A |
| Example 9 | "K-140EA" of Synthesis Example 1 (acrylic modified xylene formaldehyde resin) | 10 | MEK | 90 | - | - | 87.4 | 600 | PGMEA | A |
| Example 10 | Product "K-140E" (ethylene glycol-modified xylene formaldehyde resin) | 10 | MEK | 90 | - | | 60.8 | 1500 | PGME | B |
| Example 11 | Product "K-140E" (ethylene glycol-modified xylene formaldehyde resin) | 10 | MEK | 90 | - | - | 60.8 | 1500 | PGMEA | B |
| Example 12 | Product "GP-100 6M22" (phenol-modified xylene formaldehyde resin) | 10 | MEK | 90 | - | - | 66.9 | 1500 | PGME | B |
| Example 13 | Product "GP-100 6M22" (phenol-modified xylene formaldehyde resin) | 10 | MEK | 90 | | - | 51.7 | 1500 | PGMEA | B |
| Example 14 | Product "G 6N04" (xylene formaldehyde resin) | 10 | MEK | 90 | - | - | 30.3 | 1500 | PGME | C |

(continued)

| | Composition for film formation for lithography | | | | | | Measurement conditions and results | | | |
|---|---|---|---|---|---|---|---|---|---|---|
| | Resin | | Solvent | | Photopolymerization initiator | | Film remaining rate | UV dose | Immersion solvent | Evaluation of UV curability |
| | Type | Content | Type | Content | Type | Content | (%) | ($mJ/cm^2$) | | |
| Example 15 | "K-140EA" of Synthesis Example 1 (acrylic modified xylene formaldehyde resin) | 10 | MEK | 85 | "IRGACURE 184" (product manufactured by BASF SE) | 5 | 96.7 | 600 | PGMEA | S |
| Comparative Example 1 | "CR-1" of Synthesis Example 2 | 10 | MEK | 90 | - | - | 0 | 1500 | PGME | D |
| Comparative Example 2 | "CR-1" of Synthesis Example 2 | 10 | MEK | 90 | - | - | 0 | 1500 | PGMEA | D |

As shown in Table 1, Examples 6 to 14 exhibited good UV curing properties, and particularly, Examples 6 and 7, which contain an epoxy-modified xylene formaldehyde resin, exhibited particularly excellent UV curing properties. In addition, as is obvious from the comparison between Examples 9 and 15, it was confirmed that UV curing properties can be improved when a photopolymerization initiator is contained. On the other hand, Comparative Examples 1 and 2 were not cured by UV.

[Preparation of Resist Film and Evaluation of Resist Performance (Examples 16 to 21 and Comparative Example 3)]

(Preparation of Composition for Resist Film Formation)

According to the compositions in Table 2, compositions for resist film formation were prepared. The acid generating agent (C), the acid diffusion controlling agent (E) and the solvent shown in Table 2 are described below.

Acid generating agent (C):

P-1: triphenylsulfonium trifluoromethanesulfonate (a product manufactured by Midori Kagaku Co., Ltd.)

Acid diffusion controlling agent (E):

Q-1: trioctylamine (a product manufactured by Tokyo Kasei Kogyo Co., Ltd.)

Solvent:

S-1: propylene glycol monomethyl ether (a product manufactured by Tokyo Kasei Kogyo Co., Ltd.)

(Preparation of Resist Film and Method for Evaluating Resist Performance)

A clean silicon wafer was spin coated with the homogeneous resist composition for each of Examples 16 to 21 and Comparative Example 3, and then prebaked (PB) before exposure in an oven of 110°C to form a resist film with a thickness of 60 nm. The obtained resist film was irradiated with electron beams of 1:1 line and space setting with an 80 nm interval using an electron beam lithography system (ELS-7500 manufactured by ELIONIX INC.). After irradiation, the resist film was heated at each predetermined temperature for 90 seconds, and immersed in a 2.38% by mass tetramethylammonium hydroxide (TMAH) alkaline developing solution for 60 seconds for development. Subsequently, the resist film was washed with ultrapure water for 30 seconds, and dried to form a positive type resist pattern. For the formed resist pattern, the line and space were observed by a scanning electron microscope (S-4800 manufactured by Hitachi High-Technologies Corporation). Those having good rectangularity without pattern collapse were evaluated as "good", and if this was not the case, evaluation of "poor" was given. In this manner, evaluation of resist performance by irradiation of the resist compositions with electron beams was carried out. As shown in the results of Table 2, good resist patterns were obtained in Examples 16 to 21, and a good resist pattern was not obtained in Comparative Example 3. From the above, the compositions for film formation for lithography of the present embodiment can impart a good shape to a resist pattern, as compared with the case of using CR-1. As long as the requirements of the present invention are met, compositions other than Examples also exhibit the same effects.

[Table 2]

| | Composition for film formation for lithography | | | | | Evaluation results |
|---|---|---|---|---|---|---|
| | Resin | | Acid generating agent (C) P-1 | Acid diffusion controlling agent (E) Q-1 | Solvent S-1 | Resist performance evaluation |
| | Type | Content | Content | Content | Content | |
| Example 16 | Product "YL7770" (epoxy-modified xylene formaldehyde resin) | 1.00 | 0.30 | 0.30 | 100 | Good |
| Example 17 | Product "YL7770" (epoxy-modified xylene formaldehyde resin) | 1.00 | 0.30 | 0.00 | 100 | Good |
| Example 18 | "K-140EA" of Synthesis Example 1 (acrylic modified xylene formaldehyde resin) | 1.00 | 0.30 | 0.30 | 100 | Good |

(continued)

| | Composition for film formation for lithography | | | | | Evaluation results |
|---|---|---|---|---|---|---|
| | Resin | | Acid generating agent (C) P-1 | Acid diffusion controlling agent (E) Q-1 | Solvent S-1 | Resist performance evaluation |
| | Type | Content | Content | Content | Content | |
| Example 19 | Product "K-140E" (ethylene glycol-modified xylene formaldehyde resin) | 1.00 | 0.30 | 0.30 | 100 | Good |
| Example 20 | Product "GP-100 6M22" (phenol-modified xylene formaldehyde resin) | 1.00 | 0.30 | 0.30 | 100 | Good |
| Example 21 | Product "G 6N04" (xylene formaldehyde resin) | 1.00 | 0.30 | 0.30 | 100 | Good |
| Comparative Example 3 | "CR-1" of Synthesis Example 2 | 1.00 | 0.30 | 0.30 | 100 | Poor |

[Preparation of Underlayer Film and Evaluation of Pattern Performance (Examples 22 to 28)]

(Preparation of Composition for Underlayer Film Formation)

According to the compositions in Table 3, compositions for underlayer film formation were prepared. The acid generating agent, the crosslinking agent, the base generating agent and the solvent shown in Table 3 are described below.

Acid generating agent: di-tertiary butyl diphenyliodonium nonafluoromethanesulfonate manufactured by Midori Kagaku Co., Ltd.
Crosslinking agent: NIKALAC MX270 manufactured by Sanwa Chemical Co., Ltd.
Base generating agent: WPBG-300 manufactured by FUJIFILM Wako Pure Chemical Corporation
Solvent: propylene glycol monomethyl ether acetate

A $SiO_2$ substrate with a film thickness of 300 nm was coated with the composition for underlayer film formation for lithography for each of Examples 22 to 28, and baked at 240°C for 60 seconds and further at 400°C for 120 seconds to form an underlayer film with a film thickness of 85 nm.

[Method for Evaluating Thermosetting Properties (Examples 22 to 28 and Comparative Examples 4)]

The film thickness of the obtained underlayer film was measured using an ellipsometer (a product manufactured by Five Lab Co., Ltd., laser wavelength of 632.8 nm), and the underlayer film was then immersed in either solvent (propylene glycol monomethyl ether (PGME) or propylene glycol monomethyl ether acetate (PGMEA)) at room temperature for 60 seconds. Subsequently, the film was blown by air and further heated at 100°C for 60 seconds, thereby removing the solvent. Thereafter, the thickness of the underlayer film was measured again, and the film remaining rate after the solvent immersion was calculated according to the following formula:

Film remaining rate (%) = underlayer film thickness after solvent immersion/underlayer film thickness before solvent immersion x 100.

From the calculated film remaining rate, the thermosetting properties were evaluated according to the following criteria. The evaluation results are shown in Table 3. From a practical viewpoint, for application to the fine processing

process of semiconductors, evaluation S is particularly preferable.

<Evaluation Criteria for Thermosetting Properties>

S: The film remaining rate was 90% or more.
A: The film remaining rate was 80% or more and less than 90%.
D: The film remaining rate was less than 20%.

[Table 3]

| | Composition for film formation for lithography | | | | | | Evaluation of thermosetting properties |
|---|---|---|---|---|---|---|---|
| | Resin Solvent | | | Acid generating agent | Crosslinking agent | Base generating agent | |
| | Type | Content | Content | Content | Content | Content | |
| Example 22 | Product "YL7770" (epoxy-modified xylene formaldehyde resin) | 1.20 | 97.80 | 0.50 | 0.50 | 0.00 | S |
| Example 23 | Product "YL7770" (epoxy-modified xylene formaldehyde resin) | 1.20 | 97.80 | 0.50 | 0.00 | 0.50 | S |
| Example 24 | Product "YL7770" (epoxy-modified xylene formaldehyde resin) | 1.20 | 97.80 | 0.00 | 0.00 | 0.00 | A |
| Example 25 | "K-140EA" of Synthesis Example 1(acrylic modified xylene formaldehyde resin) | 1.20 | 97.80 | 0.50 | 0.50 | 0.00 | A |
| Example 26 | Product "K-140E" (ethylene glycol-modified xylene formaldehyde resin) | 1.20 | 97.80 | 0.50 | 0.50 | 0.00 | A |
| Example 27 | Product "GP-100 6M22" (phenol-modified xylene formaldehyde resin) | 1.20 | 97.80 | 0.50 | 0.50 | 0.00 | S |
| Example 28 | Product "G 6N04" (xylene formaldehyde resin) | 1.20 | 97.80 | 0.50 | 0.50 | 0.00 | A |
| Comparative Example 4 | "CR-1" of Synthesis Example 2 | 1.20 | 97.80 | 0.50 | 0.50 | 0.00 | D |

As shown in Table 3, the compositions of Examples 22 to 28 exhibited good curing properties. In addition, as is obvious from the comparison between Examples 22 and 23, it was confirmed that, when the base generating agent is contained, good curing properties are exhibited even if the crosslinking agent is not contained. On the other hand, the composition of Comparative Example 4 was not cured into a film.

[Formation of Positive Type Resist Pattern and Evaluation of Resist Performance (Examples 29 to 34)]

The underlayer film obtained as described above was coated with a resist solution for ArF and baked at 130°C for 60 seconds to form a photoresist layer with a film thickness of 140 nm.

The resist solution for ArF was prepared by compounding 5 parts by mass of a compound represented by the following formula (24), 1 part by mass of triphenylsulfonium nonafluoromethanesulfonate, parts by mass of tributylamine, and 92 parts by mass of PGMEA.

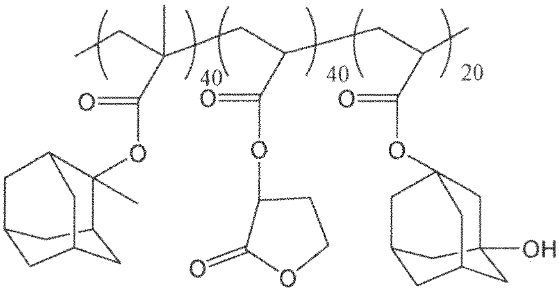

(24)

The numbers in the formula (24) indicate the ratio (mass ratio) of each constituent unit, and the form of arrangement of each unit may be random or may be block.

The compound represented by the formula (24) was prepared as follows.

4.15 g of 2-methyl-2-methacryloyloxyadamantane, 3.00 g of methacryloyloxy-γ-butyrolactone, 2.08 g of 3-hydroxy-1-adamantyl methacrylate, and 0.38 g of azobisisobutyronitrile were dissolved in 80 mL of tetrahydrofuran to prepare a reaction solution. This reaction solution was polymerized for 22 hours with the reaction temperature kept at 63°C in a nitrogen atmosphere. Then, the reaction solution was added dropwise into 400 mL of n-hexane. The product resin thus obtained was solidified and purified, and the resulting white powder was filtered and dried overnight at 40°C under reduced pressure to obtain the compound represented by the formula (24).

Subsequently, the photoresist layer was exposed using an electron beam lithography system (manufactured by ELIONIX INC.; ELS-7500, 50 keV), baked (PEB) at 115°C for 90 seconds, and developed for 60 seconds in a 2.38% by mass tetramethylammonium hydroxide (TMAH) aqueous solution to obtain a positive type resist pattern for each of Examples 29 to 34.

[Comparative Example 5]

The same operations as in Example 29 were performed except that no underlayer film was formed to obtain a positive type resist pattern for Comparative Example 5.

[Evaluation of Resist Performance]

Concerning the resist patterns for Examples 29 to 34 and Comparative Example 5, the shapes of the obtained 55 nm L/S (1:1) and 80 nm L/S (1:1) resist patterns were observed using an electron microscope (S-4800), a product manufactured by Hitachi, Ltd. The shapes of the resist patterns after development were evaluated as "good" when having good rectangularity without pattern collapse, and as "poor" if this was not the case. The smallest line width having good rectangularity without pattern collapse as a result of this observation was used as an index for resolution evaluation. Furthermore, the smallest electron beam energy quantity capable of lithographing good pattern shapes was used as an index for sensitivity evaluation.

[Table 4]

| | Composition for underlayer film formation | Resolution (nmL/S) | Sensitivity (μC/cm2) | Resist pattern shape after development |
|---|---|---|---|---|
| Example 29 | Composition of Example 22 | 56 | 20 | Good |

(continued)

| | Composition for underlayer film formation | Resolution (nmL/S) | Sensitivity (μC/cm2) | Resist pattern shape after development |
|---|---|---|---|---|
| Example 30 | Composition of Example 24 | 60 | 23 | Good |
| Example 31 | Composition of Example 25 | 60 | 22 | Good |
| Example 32 | Composition of Example 26 | 62 | 26 | Good |
| Example 33 | Composition of Example 27 | 64 | 25 | Good |
| Example 34 | Composition of Example 28 | 64 | 28 | Good |
| Comparative Example 5 | None | 90 | 42 | Poor |

As shown in Table 4, the compositions of Examples 29 to 34 were confirmed to be significantly superior in both resolution and sensitivity to Comparative Example 5. Also, the resist pattern shapes after development were confirmed to have good rectangularity without pattern collapse. Furthermore, from the difference in the resist pattern shapes after development, it was confirmed that the underlayer films obtained from the compositions for film formation for lithography of Examples 29 to 34 have good adhesiveness to a resist material.

The present application is based on Japanese Patent Application No. 2017-222641 filed in the Japan Patent Office on November 20, 2017, the contents of which are incorporated herein by reference.

## Claims

1. A composition for film formation for lithography, comprising at least one selected from the group consisting of an aromatic hydrocarbon formaldehyde resin and a modified aromatic hydrocarbon formaldehyde resin, wherein the aromatic hydrocarbon formaldehyde resin is a product of condensation reaction between an aromatic hydrocarbon having a substituted or unsubstituted benzene ring and formaldehyde, and the modified aromatic hydrocarbon formaldehyde resin is formed by modifying the aromatic hydrocarbon formaldehyde resin.

2. The composition for film formation for lithography according to claim 1, wherein the aromatic hydrocarbon formaldehyde resin is a xylene formaldehyde resin, which is a product of condensation reaction between xylene and formaldehyde, and the modified aromatic hydrocarbon formaldehyde resin is a modified xylene formaldehyde resin formed by modifying the xylene formaldehyde resin.

3. The composition for film formation for lithography according to claim 1 or 2, wherein the modified aromatic hydrocarbon formaldehyde resin is at least one selected from the group consisting of the following (X1), (X2), (X3) and (X4):

   (X1) a phenol-modified aromatic hydrocarbon formaldehyde resin formed by modifying the aromatic hydrocarbon formaldehyde resin with a phenol represented by the following formula (1) ;
   (X2) a polyol-modified aromatic hydrocarbon formaldehyde resin formed by modifying the aromatic hydrocarbon formaldehyde resin with a polyol;
   (X3) an epoxy-modified aromatic hydrocarbon formaldehyde resin; and
   (X4) an acrylic modified aromatic hydrocarbon formaldehyde resin,

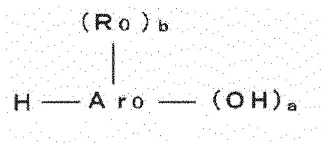
(1)

   wherein $Ar_0$ represents an aromatic ring; $R_0$ represents a hydrogen atom, an alkyl group, an aryl group or an alkoxy group; a represents an integer of 1 to 3; b represents an integer of 0 or more; and when there are a plurality of $R_0$, the plurality of $R_0$ may be the same or different.

4. The composition for film formation for lithography according to claim 3, wherein the phenol represented by the above

formula (1) is phenol, 2,6-xylenol or 3,5-xylenol.

5. The composition for film formation for lithography according to claim 3 or 4, wherein the polyol is a polyol represented by the following formula (1a):

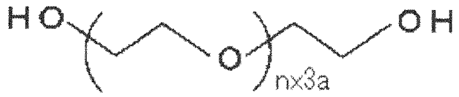

(1a)

wherein nx3a represents an integer of 0 to 5.

6. The composition for film formation for lithography according to any one of claims 3 to 5, wherein the epoxy-modified aromatic hydrocarbon formaldehyde resin is a resin obtained by reacting the phenol-modified aromatic hydrocarbon formaldehyde resin with epihalohydrin.

7. The composition for film formation for lithography according to any one of claims 3 to 6, wherein the acrylic modified aromatic hydrocarbon formaldehyde resin is a resin obtained by esterifying the polyol-modified aromatic hydrocarbon formaldehyde resin with acrylic acid or a derivative thereof.

8. The composition for film formation for lithography according to any one of claims 1 to 7, wherein the aromatic hydrocarbon formaldehyde resin is a deacetalized aromatic hydrocarbon formaldehyde resin that has been subjected to a deacetalization treatment, and the modified aromatic hydrocarbon formaldehyde resin is a resin formed by modifying the deacetalized aromatic hydrocarbon formaldehyde resin.

9. The composition for film formation for lithography according to any one of claims 1 to 8, wherein the modified aromatic hydrocarbon formaldehyde resin comprises a compound represented by the following formula (2) :

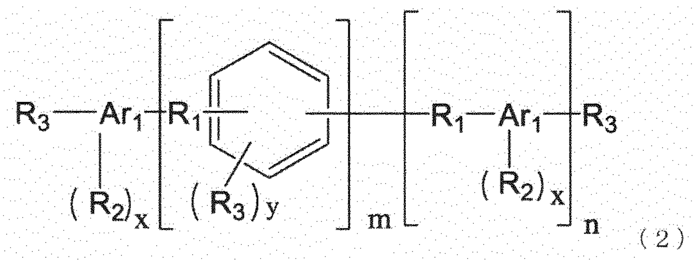

(2)

wherein $Ar_1$ represents an aromatic ring or an aliphatic ring; $R_1$ is a methylene group, a methyleneoxy group, an oxymethylene group or a divalent group formed by combining two or more groups thereof; $R_2$ represents a hydrogen atom, a hydroxy group, an alkyl group having 1 to 30 carbon atoms, an aryl group having 6 to 30 carbon atoms, an alkoxy group having 1 to 30 carbon atoms, an alkoxycarbonyl group having 1 to 30 carbon atoms, an alkenyl group having 2 to 30 carbon atoms, a group represented by the following formula (A) or a crosslinkable reactive group, wherein the alkyl group, the aryl group, the alkoxy group and the alkenyl group may be substituted with one substituent selected from the group consisting of a hydroxy group, an alkyl group having 1 to 12 carbon atoms and an alkoxy group, and wherein the alkyl group, the aryl group, the alkoxy group and the alkenyl group may comprise one bonding group selected from the group consisting of an ether bond, a ketone bond and an ester bond, where, when there are a plurality of $R_2$, the plurality of $R_2$ may be the same or different; $R_3$ is a hydrogen atom, a hydroxy group, an alkyl group having 1 to 3 carbon atoms, an aryl group, a hydroxymethylene group or a group represented by the following formula (B), the following formula (C1), the following formula (C2) or the following formula (C3), where, when there are a plurality of $R_3$, the plurality of $R_3$ may be the same or different; m represents an integer of 1 or more; n represents an integer of 1 or more; the arrangement of each unit is arbitrary; x represents an integer of 0 or more; and y represents an integer of 0 to 4, provided that either the formula (2) necessarily has any of the groups represented by the following formula (A), the following formula (B), the following formula (C1), the following formula (C2) and the following formula (C3), or $Ar_1$ represents an aromatic ring and at least one of $R_2$ bonded to the aromatic ring $Ar_1$ is a hydroxy group;

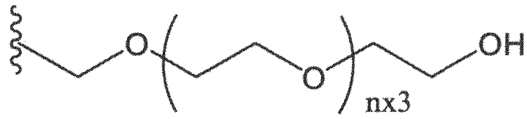

(A)

wherein nx3 represents an integer of 1 to 5;

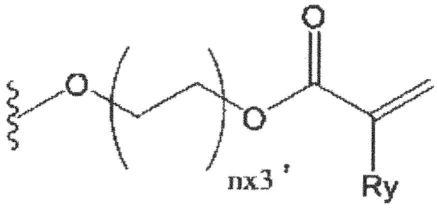

(B)

wherein nx3' represents an integer of 1 to 5 and Ry represents a hydrogen atom or a methyl group;

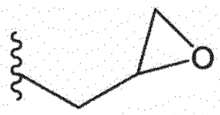

(C 1)

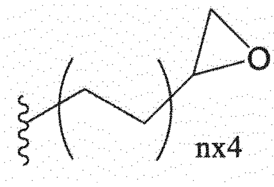

(C 2)

wherein nx4 represents an integer of 1 to 5; and

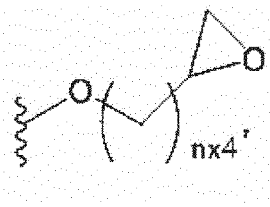

(C 3)

wherein nx4' represents an integer of 1 to 5.

**10.** The composition for film formation for lithography according to any one of claims 1 to 9, further comprising a radical polymerization initiator.

**11.** The composition for film formation for lithography according to claim 10, wherein the radical polymerization initiator is at least one selected from the group consisting of a ketone-based photopolymerization initiator, an organic peroxide-based polymerization initiator and an azo-based polymerization initiator.

**12.** The composition for film formation for lithography according to claim 10 or 11, wherein a content of the radical polymerization initiator is 0.05 to 50 parts by mass based on 100 parts by mass of the solid content of the composition for film formation for lithography.

**13.** The composition for film formation for lithography according to any one of claims 1 to 12, further comprising at least one selected from the group consisting of a photocurable monomer, a photocurable oligomer and a photocurable polymer.

**14.** The composition for film formation for lithography according to any one of claims 1 to 13, further comprising a solvent.

**15.** The composition for film formation for lithography according to any one of claims 1 to 14, further comprising an acid generating agent.

**16.** The composition for film formation for lithography according to any one of claims 1 to 15, further comprising an acid crosslinking agent.

**17.** The composition for film formation for lithography according to any one of claims 1 to 16, further comprising a crosslinking promoting agent.

**18.** The composition for film formation for lithography according to any one of claims 1 to 17, further comprising a base generating agent.

**19.** The composition for film formation for lithography according to any one of claims 1 to 18, wherein the composition is for an underlayer film.

**20.** The composition for film formation for lithography according to any one of claims 1 to 18, wherein the composition is for a resist.

**21.** The composition for film formation for lithography according to any one of claims 1 to 18, wherein the composition is for a resist permanent film.

**22.** A film for lithography, formed by using the composition for film formation for lithography according to any one of claims 1 to 21.

**23.** The film for lithography according to claim 22, wherein the film is an underlayer film.

**24.** A method for forming a resist pattern, comprising the steps of:

forming an underlayer film on a substrate using the composition for film formation for lithography according to any one of claims 1 to 21;
forming at least one photoresist layer on the underlayer film; and
irradiating a predetermined region of the photoresist layer with radiation for development, thereby forming a resist pattern.

**25.** A method for forming a circuit pattern, comprising the steps of:

forming an underlayer film on a substrate using the composition for film formation for lithography according to any one of claims 1 to 21;
forming an intermediate layer film on the underlayer film using a resist intermediate layer film forming material containing a silicon atom;
forming at least one photoresist layer on the intermediate layer film;
irradiating a predetermined region of the photoresist layer with radiation for development, thereby forming a resist pattern;
etching the intermediate layer film with the resist pattern as a mask, thereby forming an intermediate layer film pattern;
etching the underlayer film with the intermediate layer film pattern as an etching mask, thereby forming an underlayer film pattern; and
etching the substrate with the underlayer film pattern as an etching mask, thereby forming a pattern on the substrate.

**INTERNATIONAL SEARCH REPORT**

International application No. PCT/JP2018/042534

A. CLASSIFICATION OF SUBJECT MATTER
Int.Cl. G03F7/11(2006.01)i, C08G10/02(2006.01)i, C08G10/04(2006.01)i, G03F7/027(2006.01)i, G03F7/031(2006.01)i, G03F7/039(2006.01)i, G03F7/20(2006.01)i, G03F7/26(2006.01)i
According to International Patent Classification (IPC) or to both national classification and IPC

B. FIELDS SEARCHED
Minimum documentation searched (classification system followed by classification symbols)
Int.Cl. G03F7/11, G03F7/027, G03F7/031, G03F7/039, G03F7/26

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2005-068308 A (MITSUBISHI GAS CHEMICAL CO., INC.) 17 March 2005, paragraphs [0005], [0019]-[0020], [0035]-[0040], examples 1-2, 4, comparative examples 1-2, 4 (Family: none) | 1-5, 7, 10-15, 17, 21-22<br>6, 8-9, 16, 18-20, 23-25 |
| X<br>A | JP 48-004552 A (FUJI PHOTO FILM CO., LTD.) 20 January 1973, page 2, lower right column, line 8 to page 4, upper right column, line 17, examples 1-6 (Family: none) | 1-7, 9, 14, 20, 22<br>8, 10-13, 15-19, 21, 23-25 |

☒ Further documents are listed in the continuation of Box C.    ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 January 2019 (17.01.2019) | 29 January 2019 (29.01.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No.
PCT/JP2018/042534

C (Continuation). DOCUMENTS CONSIDERED TO BE RELEVANT

| Category* | Citation of document, with indication, where appropriate, of the relevant passages | Relevant to claim No. |
|---|---|---|
| X<br><br>A | JP 49-049703 A (FUJI PHOTO FILM CO., LTD.) 14 May 1974, page 4, lower right column, line 17 to page 6, upper right column, line 4, examples 1-6 (Family: none) | 1-7, 9, 14-15, 20, 22<br>8, 10-13, 16-19, 21, 23-25 |
| X<br>A | WO 2017/043561 A1 (MITSUBISHI GAS CHEMICAL CO., INC.) 16 March 2017, claims, paragraphs [0203], [0320]-[0321], [0323], [0364]-[0426], examples 5, 11, 17 & EP 3348542 A1 claims, paragraphs [0158], [0283]-[0284], [0286], [0330]-[0421], examples 5, 11, 17 & KR 10-2018-0050665 A & CN 108137478 A & TW 201722905 A | 1, 3-9, 14-25<br>2, 10-13 |
| X<br><br>A | JP 2003-344993 A (SAN NOPCO LIMITED) 03 December 2003, paragraphs [0034]-[0045], examples 1-6, comparative examples 1-5 (Family: none) | 1, 3-7, 9-10, 12-14, 17-18, 20-22<br>2, 8, 11, 15-16, 19, 23-25 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004177668 A
- JP 2004271838 A
- JP 2005250434 A
- WO 2009072465 A
- WO 2011034062 A
- JP 2002334869 A
- WO 2004066377 A
- JP 2007226170 A
- JP 2007226204 A
- JP 4224815 A
- WO 2015080240 A
- WO 2013024778 A
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- US 5405720 A
- US 5360692 A
- US 5529881 A
- US 5296330 A
- US 5436098 A
- US 5576143 A
- US 5294511 A
- US 5824451 A
- WO 2013024779 A
- JP 2017222641 A


### Non-patent literature cited in the description


- **C. E. HOYLE.** *Macromolecules,* 1999, vol. 32, 2793
- Synthesis of Inorganic Compounds III. New Experimental Chemistry Lecture. Maruzen Co., Ltd, 1977, vol. 8